# EUROPEAN PATENT APPLICATION

(11) **EP 4 557 921 A1**
(43) Date of publication of application: **21.05.2025**
(21) Application number: 24211896.6
(22) Date of filing: 08.11.2024
(51) Int. Cl.: H10K 59/122, H10K 59/80, H10K 59/88, H10K 59/35

(54) **DISPLAY DEVICE INCLUDING DISPLAY PANEL AND METHOD FOR MANUFACTURING THE DISPLAY PANEL**

(30) Priority: 20.11.2023 KR 20230160629
(71) Applicant: Samsung Display Co., Ltd., Gyeonggi-Do (KR)
(72) Inventor: SUNG, Woo Yong, Yongin-si (KR); SONG, Seungyong, Yongin-si (KR)
(74) Representative: Marks & Clerk LLP

(57) **Abstract**

A display device includes a pixel defining layer, a barrier wall that is disposed on the pixel defining layer and in which a barrier wall opening and a groove spaced apart from the barrier wall opening are defined, a light-emitting element including an anode, an emission pattern, and a cathode that is disposed in the barrier wall opening and that contacts the barrier wall; and a lower encapsulation pattern disposed on the light-emitting element and the barrier wall. The first groove surrounds the barrier wall opening in a plan view. An inner portion of the lower encapsulation pattern is disposed in the barrier wall opening and the groove, and an outer portion of the lower encapsulation pattern defines a spacing region between the barrier wall and the outer portion of the lower encapsulation pattern.

## Description

### BACKGROUND

### 1. Field

Embodiments of the disclosure described herein relate to a display device including a display panel and a manufacturing method for the display panel, and more particularly, relate to a display device including a display panel with improved process reliability and a method for manufacturing the display panel.

### 2. Description of the Related Art

A display device, such as a television, a monitor, a smart phone, a tablet computer, or the like, which provides an image to a user includes a display panel that displays an image. Various display panels, such as a liquid crystal display panel, an organic light-emitting display panel, an electro wetting display panel, an electrophoretic display panel, and the like, are being developed.

The organic light-emitting display panel may include anodes, cathodes, and emission patterns. The emission patterns may be divided from one another for respective emissive regions, and the cathodes may provide a common voltage for the respective emissive regions.

### SUMMARY

Embodiments of the disclosure provide a display device including a display panel with improved process reliability that includes light-emitting elements formed without the use of a metal mask. In addition, embodiments of the disclosure provide a method for manufacturing a display panel with improved process reliability.

In an embodiment of the disclosure, a display device includes a display panel, and the display panel includes a base layer, a pixel defining layer disposed on the base layer, a barrier wall that is disposed on the pixel defining layer and in which a first barrier wall opening and a first groove spaced apart from the first barrier wall opening are defined, a first light-emitting element including, a first anode, a first emission pattern, and a first cathode that is disposed in the first barrier wall opening and that contacts the barrier wall, and a first lower encapsulation pattern disposed on the first light-emitting element and the barrier wall. The first groove surrounds the first barrier wall opening in a plan view. An inner portion of the first lower encapsulation pattern is disposed in the first barrier wall opening and the first groove, and an outer portion of the first lower encapsulation pattern defines a first spacing region (or spacing portion) between the barrier wall and the outer portion of the first lower encapsulation pattern.

In an embodiment, the first groove may be defined by removing a portion of the barrier wall from an upper surface of the barrier wall in a thickness direction. The first groove may be defined by being recessed into or penetrating a portion of the barrier wall from an upper surface of the barrier wall in a thickness direction. The first groove may be defined by a recess in a portion of the barrier wall. The recess may extend from an upper surface of the barrier wall in a thickness direction.

In an embodiment, the barrier wall may include a first barrier wall layer disposed on the pixel defining layer and a second barrier wall layer disposed on the first barrier wall layer, and the first groove may include a first groove region defined by removing a portion of the first barrier wall layer and a second groove region penetrating the second barrier wall layer. The first groove region may be defined by penetrating a portion of a portion of the first barrier wall layer. The first groove region may be defined by a recess in a portion of the first barrier wall layer. The recess may extend from an upper surface of the first barrier wall layer in a thickness direction.

In an embodiment, the first barrier wall opening may include a first opening region penetrating the first barrier wall layer and a second opening region penetrating the second barrier wall layer. The second opening region may have a width smaller than a width of the first opening region. A first tip portion adjacent to the first barrier wall opening may be defined in the barrier wall.

In an embodiment, the second groove region may have a width smaller than a width of the first groove region. A second tip portion and a third tip portion that are adjacent to the first groove and that face each other may be defined in the barrier wall, and the second tip portion may be closer to the first barrier wall opening than the third tip portion is to the first barrier wall opening.

In an embodiment, the display panel may further include, first dummy patterns disposed on the barrier wall and disposed between the first barrier wall opening and the first groove in the plan view, and second dummy patterns disposed in the first groove. Each of the first dummy patterns and the second dummy patterns may include a first layer dummy pattern that is spaced apart from the first emission pattern and that includes a same material as that of the first emission pattern and a second layer dummy pattern that is spaced apart from the first cathode and that includes a same material as that of the first cathode.

In an embodiment, the inner portion of the first lower encapsulation pattern may include a first portion that is disposed in the first barrier wall opening and that covers the first cathode, a second portion that extends from the first portion and covers the first dummy patterns and that is disposed on the barrier wall, and a third portion that extends from the second portion and covers the second dummy patterns and that is disposed in the first groove.

In an embodiment, the barrier wall may further include an additional groove that surrounds the first barrier wall opening and the first groove in the plan view, and a fourth tip portion and a fifth tip portion that are adjacent to the additional groove and that face each other may be additionally defined in the barrier wall.

In an embodiment, the display panel may further include first additional dummy patterns disposed on the barrier wall and disposed between the first groove and the additional groove in the plan view and second additional dummy patterns disposed in the additional groove. Each of the first additional dummy patterns and the second additional dummy patterns may include a first layer additional dummy pattern that is spaced apart from the first emission pattern and that includes a same material as that of the first emission pattern and a second layer additional dummy pattern that is spaced apart from the first cathode and that includes a same material as that of the first cathode. One portion of the inner portion of the first lower encapsulation pattern may cover the first additional dummy patterns, and another portion of the inner portion of the first lower encapsulation pattern may be disposed in the additional groove and may cover the second additional dummy patterns.

In an embodiment, the barrier wall may further include a third barrier wall layer disposed on the second barrier wall layer and a fourth barrier wall layer disposed on the third barrier wall layer. The first barrier wall opening may include a third opening region penetrating the third barrier wall layer and a fourth opening region penetrating the fourth barrier wall layer. The third opening region may have a width greater than a width of the second opening region, and the fourth opening region may have a width than a width of the third opening region.

In an embodiment, the first groove may further include a third groove region penetrating the third barrier wall layer and a fourth groove region penetrating the fourth barrier wall layer. The third groove region may have a width greater than a width of the second groove region, and the fourth groove region may have a width smaller than a width of the third groove region.

In an embodiment, a portion of the inner portion of the first lower encapsulation pattern may fill the second groove region, and a space sealed by the first lower encapsulation pattern may be defined in the first groove region.

In an embodiment, the first groove may penetrate from an upper surface to a lower surface of the barrier wall.

In an embodiment, the display panel may further include an organic encapsulation film disposed on the barrier wall and the first lower encapsulation pattern.

In an embodiment, the first spacing region may be filled with the organic encapsulation film.

In an embodiment, the display device may further include an input sensor directly disposed on the display panel.

In an embodiment, the first groove may have a closed-line shape in the plan view.

In an embodiment, the first groove may have a width smaller than a width of the first barrier wall opening.

In an embodiment, the display panel may further include a second light-emitting element including a second anode, a second emission pattern, and a second cathode and a second lower encapsulation pattern spaced apart from the first lower encapsulation pattern and disposed on the second light-emitting element and the barrier wall. A second barrier wall opening spaced apart from the first barrier wall opening and a second groove that surrounds the second barrier wall opening in the plan view may be additionally defined in the barrier wall. The second cathode may be disposed in the second barrier wall opening and may contact the barrier wall. An inner portion of the second lower encapsulation pattern may be disposed in the second barrier wall opening and the second groove, and an outer portion of the second lower encapsulation pattern may define a second spacing region between the barrier wall and the outer portion of the second lower encapsulation pattern.

In an embodiment of the disclosure, a method for manufacturing a display panel includes forming a barrier wall in which a barrier wall opening and a groove spaced apart from the barrier wall opening are defined by etching a preliminary barrier wall, forming a light-emitting element in the barrier wall opening, forming a lower encapsulation pattern including an inner portion disposed in the barrier wall opening and the groove and an outer portion disposed at an outside from the inner portion, and forming a spacing region between the outer portion of the lower encapsulation pattern and the barrier wall.

In an embodiment, the forming the barrier wall may include a first etching operation performed by a dry etch process and a second etching operation performed by a wet etch process. The barrier wall may include a first barrier wall layer and a second barrier wall layer disposed on the first barrier wall layer, and the barrier wall opening may include a first opening region formed through the first barrier wall layer and a second opening region formed through the second barrier wall layer. The second opening region may have a width smaller than a width of the first opening region.

In an embodiment, the method may further include forming a first photoresist pattern having a first photo opening and a second photo opening on the preliminary barrier wall before the forming the barrier wall and removing the first photoresist pattern after the forming the barrier wall and before the forming the light-emitting element. In the forming the barrier wall, the barrier wall opening may correspond to the first photo opening, and the groove may correspond to the second photo opening. The second photo opening may have a width smaller than a width of the first photo opening, and the groove may have a height smaller than or equal to a height of the barrier wall opening.

In an embodiment, the method may further include forming a preliminary mask pattern on the preliminary barrier wall before the forming the first photoresist pattern, making the preliminary mask pattern subject to patterning after the forming the first photoresist pattern and before the forming the barrier wall to form a mask pattern in which a first pattern opening that overlaps the first photo opening and a second pattern opening that overlaps the second photo opening are defined, and removing the mask pattern after the removing the first photoresist pattern and before the forming the light-emitting element.

In an embodiment, the method may further include providing a preliminary display panel before the forming the preliminary mask pattern, the preliminary display panel including a base layer, a preliminary pixel defining layer disposed on the base layer, an anode disposed on the preliminary pixel defining layer, a sacrificial pattern disposed on the anode, and the preliminary barrier wall disposed on the preliminary pixel defining layer. In the forming the barrier wall, a pixel defining layer having a light-emitting opening corresponding to the first pattern opening may be formed from the preliminary pixel defining layer, and in the removing the mask pattern, a sacrificial opening corresponding to the light-emitting opening may be defined in the sacrificial pattern.

In an embodiment, the method may further include depositing a preliminary lower encapsulation pattern after the forming the light-emitting element and before the forming the lower encapsulation pattern and forming a second photoresist pattern on the preliminary lower encapsulation pattern. In the forming the light-emitting element, a first dummy pattern disposed on the barrier wall between the barrier wall opening and the groove, a second dummy pattern disposed in the groove, and a third preliminary dummy pattern disposed on the barrier wall outward of the groove may be formed together. The second photoresist pattern may overlap a portion of the third preliminary dummy pattern, the first dummy pattern, the second dummy pattern, and the light-emitting element. In the forming the spacing region, a wet etch process may be performed using the second photoresist pattern as a mask, and the third preliminary dummy pattern may be removed.

In an embodiment, the groove may be defined by removing a portion of the barrier wall from an upper surface of the barrier wall in a thickness direction. The groove may be defined by being recessed into or penetrating a portion of the barrier wall from an upper surface of the barrier wall in a thickness direction.

In an embodiment, the groove may penetrate from an upper surface to a lower surface of the barrier wall.
At least some of the above and other features of the invention are set out in the claims.

### BRIEF DESCRIPTION OF THE DRAWINGS

The above and other embodiments, advantages and features of the disclosure will become apparent by describing in detail embodiments thereof with reference to the accompanying drawings.
FIG. 1A is an assembled perspective view of an embodiment of a display device according to the disclosure.
FIG. 1B is an exploded perspective view of an embodiment of the display device illustrated in FIG. 1A according to the disclosure.
FIG. 2 is a cross-sectional view of an embodiment of a display module according to the disclosure.
FIG. 3 is a plan view of an embodiment of a display panel according to the disclosure.
FIG. 4 is an equivalent circuit diagram of an embodiment of a pixel according to the disclosure.
FIG. 5 is an enlarged plan view of an embodiment of a portion of a display region according to the disclosure.
FIG. 6 is a plan view of an embodiment of an input sensor according to the disclosure.
FIG. 7 is a cross-sectional view of an embodiment of the display panel according to the disclosure.
FIG. 8A is a cross-sectional view of an embodiment of the display module according to the disclosure.
FIG. 8B is a cross-sectional view of the display module, where FIG. 8B illustrates a blowup of region AA' of FIG. 8A.
FIG. 9A is a cross-sectional view of an embodiment of the display panel taken along line I-I' of FIG. 5 according to the disclosure.
FIG. 9B is an enlarged plan view illustrating an embodiment of some components of the display panel according to the disclosure.
FIG. 10A is a cross-sectional view of an embodiment of the display module according to the disclosure.
FIG. 10B is a cross-sectional view of the display module, where FIG. 10B illustrates a blowup of region BB' of FIG. 10A.
FIG. 11A is a cross-sectional view of an embodiment of the display module according to the disclosure.
FIG. 11B is a cross-sectional view of the display module, where FIG. 11B illustrates a blowup of region CC' of FIG. 11A.
Fig. 11C is an enlarged plan view illustrating some components of the display module according to the disclosure.
FIG. 12A is a cross-sectional view of an embodiment of the display module according to the disclosure.
FIG. 12B is a cross-sectional view of the display module, where FIG. 12B illustrates a blowup of region DD' of FIG. 12A.
FIG. 13A is a cross-sectional view of an embodiment of the display module according to the disclosure.
FIG. 13B is a cross-sectional view of the display module, where FIG. 13B illustrates a blowup of region EE' of FIG. 13A.
FIG. 14A is a cross-sectional view of an embodiment of the display module according to the disclosure.
FIG. 14B is a cross-sectional view of the display module, where FIG. 14B illustrates a blowup of region FF' of FIG. 14A.
FIGS. 15A to 15M are cross-sectional views illustrating an embodiment of some of the operations of a display panel manufacturing method according to the disclosure.
FIGS. 16A to 16E are cross-sectional views illustrating an embodiment of some of the operations of the display panel manufacturing method according to the disclosure.

### DETAILED DESCRIPTION

In this specification, when it is mentioned that a component (or a region, a layer, a part, etc.) is referred to as being "on", "connected to" or "coupled to" another component, this means that the component may be directly on, connected to, or coupled to the other component or a third component may be therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, operations, operations, components, parts, or combinations thereof, but do not preclude the presence or addition of one or more other features, numbers, operations, operations, components, parts, or combinations thereof.

Unless otherwise defined, all terms used herein, including technical or scientific terms, have the same meanings as those generally understood by those skilled in the art to which the disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the application.

Hereinafter, embodiments of the disclosure will be described with reference to the accompanying drawings.

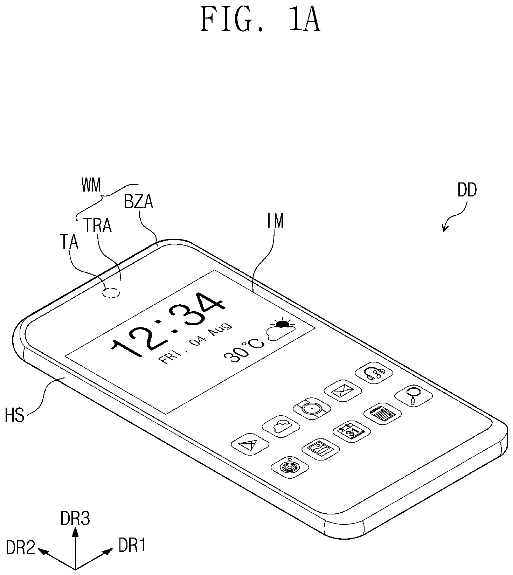

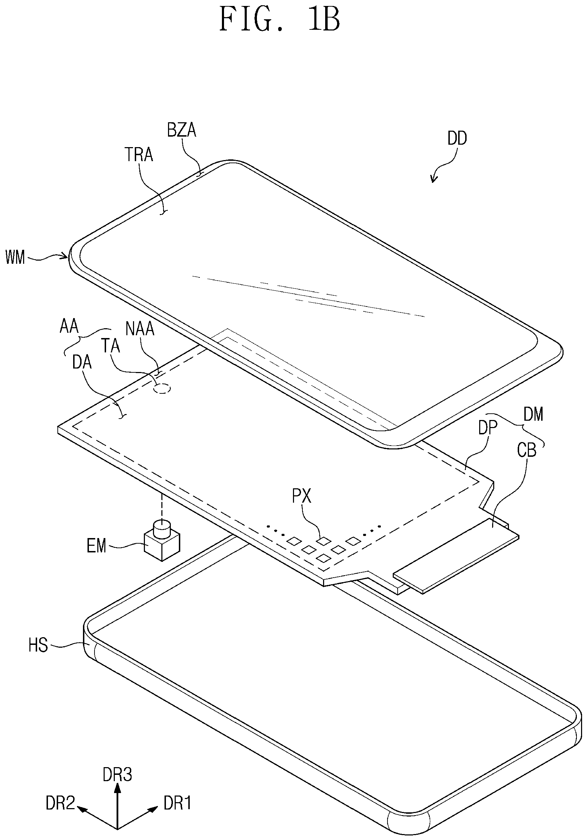

FIG. 1A is an assembled perspective view of an embodiment of a display device DD according to the disclosure. FIG. 1B is an exploded perspective view of an embodiment of the display device DD illustrated in FIG. 1A according to the disclosure. Hereinafter, the disclosure will be described with reference to FIGS. 1A and 1B.

The display device DD may be a device that displays an image IM. In an embodiment, the display device DD may include a tablet computer, a notebook computer, a computer, a smart phone, a television, or the like, for example. In this embodiment, the display device DD is illustrated as a smart phone.

A user receives information through the image IM displayed on an active region AA. The image IM may include at least one of a static image or a dynamic image. In FIG. 1A, a clock and a plurality of icons are illustrated in an embodiment of the image IM.

The display device DD may include a window WM, a display module DM, an electronic module EM, and a housing unit HS. The window WM is coupled with the housing unit HS to form the exterior of the display device DD.

The window WM may include an optically clear insulating material. In an embodiment, the window WM may include glass or plastic, for example. The window WM may have a multi-layer structure or a single-layer structure. In an embodiment, the window WM may have a stacked structure of a plurality of plastic films coupled through an adhesive, or may have a stacked structure of a glass substrate and a plastic film coupled through an adhesive, for example.

The window WM includes a transparent region TRA and a bezel region BZA. The transparent region TRA may be an optically clear region. The image IM generated by the display module DM may be visible from outside the display device DD through the transparent region TRA.

The transparent region TRA may have a shape corresponding to the active region AA that will be described below. The transparent region TRA may have a quadrangular shape parallel to a first direction DR1 and a second direction DR2. However, this is illustrative, and the transparent region TRA may have various shapes and is not limited to a particular embodiment.

The bezel region BZA is adjacent to the transparent region TRA. The bezel region BZA may be a region having a lower light transmittance than the transparent region TRA. When the window WM is implemented with a glass or plastic substrate, the bezel region BZA may be a color layer printed or deposited on one surface of the glass or plastic substrate. In an alternative embodiment, the bezel region BZA may be formed by coloring a corresponding region of the glass or plastic substrate.

The bezel region BZA defines the shape of the transparent region TRA. The bezel region BZA may be adjacent to the transparent region TRA and may surround the transparent region TRA. However, this is illustrative, and the bezel region BZA may be disposed adjacent to only one side of the transparent region TRA, or may be omitted.

A direction DR3 (hereinafter, also referred to as the third direction) perpendicular to the transparent region TRA may correspond to the thickness direction of the display device DD. The image IM is displayed in the third direction DR3. In this embodiment, front surfaces (or, upper surfaces) and rear surfaces (or, lower surfaces) of members are defined based on the direction in which the image IM is displayed. The front surfaces and the rear surfaces are opposite each other in the third direction DR3. The expression "components A and B overlap or are spaced apart from each other" used herein means that components A and B overlap or are spaced apart from each other when viewed from above a plane defined by the first direction DR1 and the second direction DR2.

The directions indicated by the first to third directions DR1, DR2, and DR3 may be relative concepts and may be changed to other directions.

The display module DM is disposed between the window WM and the housing unit HS. The display module DM may be accommodated in a space that the window WM and the housing unit HS are coupled with each other to provide. The display module DM may include a display panel DP and a circuit board CB.

The front surface of the display panel DP includes the active region AA and a peripheral region NAA. The active region AA may be a region in which a plurality of pixels PX is disposed. The pixels PX generate the image IM.

The active region AA includes a display region DA and a transmissive region TA. The display region DA may be a region in which a plurality of active pixels among the pixels PX are disposed. The image IM is displayed through light generated by the active pixels. Detailed description thereabout will be given below.

The transmissive region TA may be a region having a higher light transmittance than the display region DA. The transmissive region TA may be a region in which transmissive pixels among the pixels PX are disposed. A smaller number of active pixels may be disposed in the transmissive region TA than in the display region DA. In an embodiment, the density of active pixels disposed in the transmissive region TA may be lower than the density of active pixels disposed in the display region DA, for example. In an alternative embodiment, active pixels may not be disposed in the transmissive region TA.

The transmissive region TA is defined adjacent to the display region DA. In this embodiment, the entirety of the transmissive region TA is defined as being surrounded by the display region DA. However, this is illustrative, and the transmissive region TA may be defined at a position partially adjacent to the display region DA and may be provided in various shapes other than a circular shape. The transmissive region TA is not limited to a particular embodiment.

The peripheral region NAA is adjacent to the active region AA. The peripheral region NAA may be a region in which the pixels PX are not disposed. Drive circuits for driving the pixels PX may be disposed in the peripheral region NAA.

The circuit board CB is connected to the display panel DP. The circuit board CB is illustrated as being coupled with the display panel DP in the peripheral region NAA. The circuit board CB is electrically connected with the display panel DP. Various types of electronic elements for driving the pixels PX may be disposed (e.g., mounted) on the circuit board CB. This is illustrative, and the various types of electronic elements for driving the pixels PX may be disposed (e.g., mounted) on the display panel DP. In this case, the circuit board CB may be omitted. The display device DD in an embodiment of the disclosure may include various embodiments and is not limited to a particular embodiment.

The electronic module EM is disposed between the window WM and the housing unit HS. The electronic module EM may be accommodated in the space that the window WM and the housing unit HS are coupled with each other to provide. The electronic module EM is disposed to overlap the display panel DP when viewed from above the plane (i.e., in the plan view).

The electronic module EM, when viewed from above the plane, overlaps the active region AA of the display panel DP and overlaps the transparent region TRA of the window WM. The electronic module EM is disposed to overlap the transmissive region TA of the active region AA.

The electronic module EM may include an imaging module such as a camera, a light-receiving module such as an infrared detector, an acoustic module such as a speaker, and a module such as an ultrasonic detector. In this embodiment, the electronic module EM may take an image of a subject existing outside the display device DD through the transmissive region TA, or may receive an external input provided to the transparent region TRA, e.g., a touch, light, or the like. Since the electronic module EM is disposed to overlap the display panel DP, the bezel region BZA may be prevented from being increased, and a narrow-bezel display device or a borderless display device may be provided. This is illustrative, and the electronic module EM may be disposed to overlap the peripheral region NAA, or may be disposed so as not to overlap the display panel DP. The electronic module EM is not limited to a particular embodiment.

Furthermore, although the display device DD is illustrated as a flat rigid device in the disclosure, the display device DD may be a foldable device. In this case, the display device DD may be folded or unfolded about a folding axis overlapping at least a portion of the active region AA, and the display panel DP may be provided to be flexible. The display device DD in an embodiment of the disclosure may be provided in various embodiments as long as the display device DD is able to display an image and is not limited to a particular embodiment.

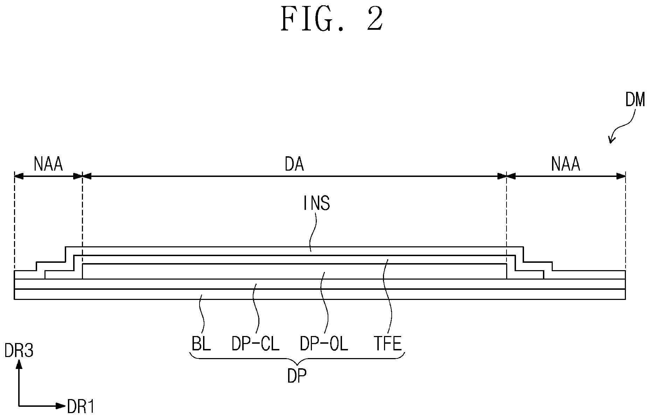

FIG. 2 is a cross-sectional view of an embodiment of the display module DM according to the disclosure.

Referring to FIG. 2, the display module DM may include the display panel DP and an input sensor INS. Although not separately illustrated, the display device DD (refer to FIG. 1A) in an embodiment of the disclosure may further include a protective member disposed on the lower surface of the display panel DP or an anti-reflective member and/or a window member disposed on the upper surface of the input sensor INS.

The display panel DP may be an emissive display panel. However, this is illustrative, and the disclosure is not particularly limited thereto. In an embodiment, the display panel DP may be an organic light-emitting display panel or an inorganic light-emitting display panel, for example. An emissive layer in the organic light-emitting display panel may include an organic luminescent material. An emissive layer in the inorganic light-emitting display panel may include quantum dots, quantum rods, or micro light-emitting diodes ("LEDs"). Hereinafter, it will be exemplified that the display panel DP is an organic light-emitting display panel.

The display panel DP includes a base layer BL, and may include a circuit element layer DP-CL, a display element layer DP-OL, and a thin film encapsulation layer TFE that are disposed on the base layer BL. The input sensor INS may be directly disposed on the thin film encapsulation layer TFE. The expression "component A is directly disposed on component B" used herein means that component A is directly disposed on the upper surface of component B without a separate layer interposed between component A and component B. That is, the expression "component A is directly disposed on component B" used herein means that a separate adhesive layer is not disposed between component A and component B.

The base layer BL may include at least one plastic film. The base layer BL may be a flexible substrate and may include a plastic substrate, a glass substrate, a metal substrate, or an organic/inorganic composite substrate. The display region DA and the peripheral region NAA described with reference to FIG. 1B may be identically defined in the base layer BL.

The circuit element layer DP-CL may include at least one insulating layer and a circuit element. The insulating layer includes at least one inorganic layer and at least one organic layer. The circuit element includes signal lines and a pixel drive circuit.

The display element layer DP-OL may include a barrier wall and a light-emitting element. The light-emitting element may include an anode, an intermediate layer, and a cathode.

The thin film encapsulation layer TFE may include a plurality of thin films. Some of the thin films may be disposed to improve optical efficiency, and the other thin films may be disposed to protect organic light-emitting diodes.

The input sensor INS obtains coordinate information of an external input. The input sensor INS may have a multi-layer structure. The input sensor INS may include a single conductive layer or multiple conductive layers. In addition, the input sensor INS may include a single insulating layer or multiple insulating layers. The input sensor INS may sense the external input in a capacitive type. However, this is illustrative, and the disclosure is not limited thereto. In an embodiment, in an embodiment, the input sensor INS may sense the external input using an electromagnetic induction method or a pressure sensing method, for example. In an embodiment of the disclosure, the input sensor INS may be omitted.

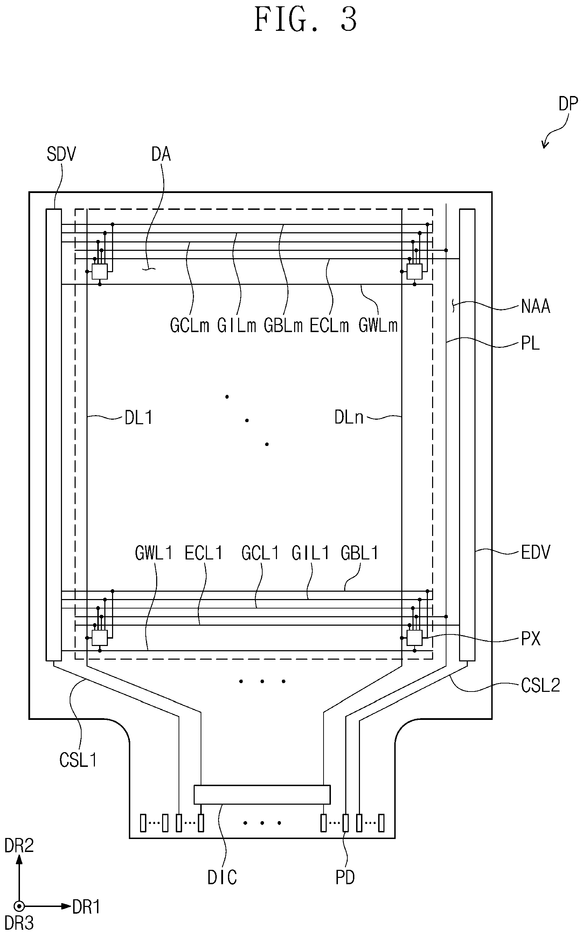

FIG. 3 is a plan view of an embodiment of the display panel DP according to the disclosure.

Referring to FIG. 3, the display region DA and the peripheral region NAA around the display region DA may be defined in the display panel DP. The display region DA and the peripheral region NAA may be distinguished from each other depending on whether the pixels PX are disposed. The pixels PX may be disposed in the display region DA. A scan driver SDV, a data driver, and an emission driver EDV may be disposed in the peripheral region NAA. The data driver may be a circuit configured in a driver integrated circuit ("IC") DIC.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2, a drive voltage line PL, and a plurality of pads PD. Here, "m" and "n" are natural numbers of 2 or more.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in the first direction DR1 and may be electrically connected to the scan driver SDV. The data lines DL1 to DLn may extend in the second direction DR2 and may be electrically connected to the driver IC DIC. The emission control lines ECL1 to ECLm may extend in the first direction DR1 and may be electrically connected to the emission driver EDV.

The drive voltage line PL may include a portion extending in the first direction DR1 and a portion extending in the second direction DR2. The portion extending in the first direction DR1 and the portion extending in the second direction DR2 may be disposed in different layers. The drive voltage line PL may provide a drive voltage to the pixels PX.

The first control line CSL1 may be connected to the scan driver SDV. The second control line CSL2 may be connected to the emission driver EDV.

The driver IC DIC, the drive voltage line PL, the first control line CSL1, and the second control line CSL2 may be electrically connected to the pads PD. The circuit board CB (refer to FIG. 1B) may be electrically connected to the pads PD through an anisotropic conductive adhesive layer. The pads PD may be pads for connecting the circuit board CB (refer to FIG. 1B) to the display panel DP. The pads PD may be connected to the corresponding pixels PX through the drive voltage line PL, the first control line CSL1, and the second control line CSL2.

In addition, the pads PD may further include input pads. The input pads may be pads for connecting the circuit board CB (refer to FIG. 1B) to the input sensor INS (refer to FIG. 2). However, without being limited thereto, the input pads may be disposed in the input sensor INS and may be connected with the pads PD and a separate circuit board. In an alternative embodiment, the input sensor INS may be omitted, and the pads PD may not further include the input pads.

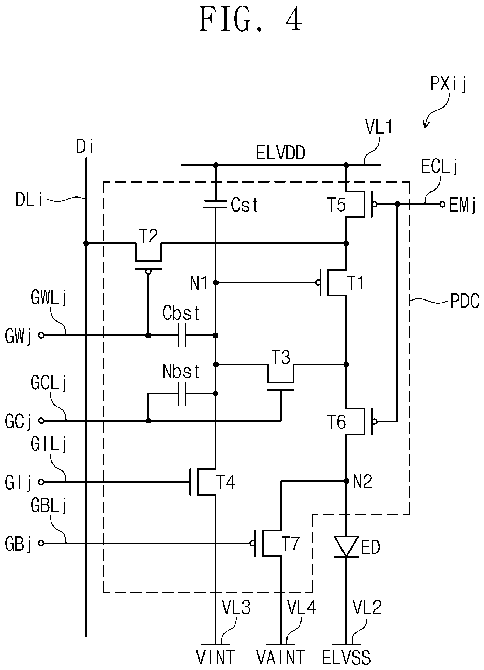

FIG. 4 is an equivalent circuit diagram of an embodiment of a pixel PX according to the disclosure.

In FIG. 4, an equivalent circuit diagram of one pixel PXij among the plurality of pixels PX (refer to FIG. 3) is illustrated as an embodiment. Since the plurality of pixels PX have the same circuit structure, description of the circuit structure for the pixel PXij may be applied to the remaining pixels PX, and detailed description of the remaining pixels PX will be omitted.

Referring to FIGS. 3 and 4, the pixel PXij is connected to the i-th data line DLi among the data lines DL1 to DLn, the j-th initialization scan line GILj among the initialization scan lines GIL1 to GILm, the j-th compensation scan line GCLj among the compensation scan lines GCL1 to GCLm, the j-th write scan line GWLj among the write scan lines GWL1 to GWLm, the j-th black scan line GBLj among the black scan lines GBL1 to GBLm, the j-th emission control line ECLj among the emission control lines ECL1 to ECLm, first and second drive voltage lines VL1 and VL2, and first and second initialization voltage lines VL3 and VL4. Here, "i" is an integer of 1 to n, and "j" is an integer of 1 to m.

The pixel PXij includes a light-emitting element ED and a pixel circuit PDC. The light-emitting element ED may be a light-emitting diode. In an embodiment of the disclosure, the light-emitting element ED may be an organic light-emitting diode including an organic light-emitting layer, but is not particularly limited thereto. The pixel circuit PDC may control the amount of current flowing through the light-emitting element ED in response to a data signal Di. The light-emitting element ED may emit light having a predetermined luminance in response to the amount of current provided from the pixel circuit PDC.

The pixel circuit PDC may include first to seventh transistors T1, T2, T3, T4, T5, T6, and T7 and first to third capacitors Cst, Cbst, and Nbst. The configuration of the pixel circuit PDC according to the disclosure is not limited to the embodiment illustrated in FIG. 4. The pixel circuit PDC illustrated in FIG. 4 is merely illustrative, and various changes and modifications may be made to the configuration of the pixel circuit PDC.

At least one of the first to seventh transistors T1, T2, T3, T4, T5, T6, and T7 may be a transistor having a low-temperature polycrystalline silicon ("LTPS") semiconductor layer. At least one of the first to seventh transistors T1, T2, T3, T4, T5, T6, and T7 may be a transistor having an oxide semiconductor layer. In an embodiment, the third and fourth transistors T3 and T4 may be oxide semiconductor transistors, and the first, second, fifth, sixth, and seventh transistors T1, T2, T5, T6, and T7 may be LTPS transistors, for example.

Specifically, the first transistor T 1 directly affecting the brightness of the light-emitting element ED may include a semiconductor layer including polycrystalline silicon having relatively high reliability, and thus the display device having a relatively high resolution may be implemented. An oxide semiconductor has relatively high carrier mobility and relatively low leakage current, and thus a voltage drop is not great even though operating time is relatively long. That is, the color of an image is not greatly changed depending on a voltage drop even during a low-frequency operation, and thus the low-frequency operation is possible. Since the oxide semiconductor has an advantage of relatively low leakage current as described above, at least one of the third transistor T3, which is connected with a gate electrode of the first transistor T1, or the fourth transistor T4 may be employed as an oxide semiconductor to reduce power consumption while preventing leakage current that is likely to flow to the gate electrode.

Some of the first to seventh transistors T1, T2, T3, T4, T5, T6, and T7 may be P-type transistors, and the others may be N-type transistors. In an embodiment, the first, second, fifth, sixth, and seventh transistors T1, T2, T5, T6, and T7 may be P-type transistors, and the third and fourth transistors T3 and T4 may be N-type transistors, for example.

The configuration of the pixel circuit PDC according to the disclosure is not limited to the embodiment illustrated in FIG. 4. The pixel circuit PDC illustrated in FIG. 4 is merely illustrative, and various changes and modifications may be made to the configuration of the pixel circuit PDC. In an embodiment, the first to seventh transistors T1, T2, T3, T4, T5, T6, and T7 may all be P-type transistors or N-type transistors, for example. In an alternative embodiment, the first, second, fifth, and sixth transistors T1, T2, T5, and T6 may be P-type transistors, and the third, fourth, and seventh transistors T3, T4, and T7 may be N-type transistors.

The j-th initialization scan line GILj, the j-th compensation scan line GCLj, the j-th write scan line GWLj, the j-th black scan line GBLj, and the j-th emission control line ECLj may transfer the j-th initialization scan signal GIj, the j-th compensation scan signal GCj, the j-th write scan signal GWj, the j-th black scan signal GBj, and the j-th emission control signal EMj, respectively, to the pixel PXij. The i-th data line DLi transfers the i-th data signal Di to the pixel PXij. The i-th data signal Di may have a voltage level corresponding to an image signal input to the display device DD (refer to FIG. 1A).

The first and second drive voltage lines VL1 and VL2 may transfer a first drive voltage ELVDD and a second drive voltage ELVSS, respectively, to the pixel PXij. In addition, the first and second initialization voltage lines VL3 and VL4 may transfer a first initialization voltage VINT and a second initialization voltage VAINT, respectively, to the pixel PXij.

The first transistor T1 is connected between the first drive voltage line VL1, which receives the first drive voltage ELVDD, and the light-emitting element ED. The first transistor T1 includes a first electrode connected with the first drive voltage line VL1 via the fifth transistor T5, a second electrode connected with a pixel electrode (or, referred to as an anode) of the light-emitting element ED via the sixth transistor T6, and a third electrode (e.g., a gate electrode) connected with one end of the first capacitor Cst (e.g., a first node N1). The first transistor T1 may receive the i-th data signal Di that the i-th data line DLi transfers depending on a switching operation of the second transistor T2 and may supply a drive current to the light-emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line GWLj. The second transistor T2 may be turned on depending on the j-th write scan signal GWj transferred through the j-th write scan line GWLj and may transfer, to the first electrode of the first transistor T1, the i-th data signal Di transferred from the i-th data line DLi. One end of the second capacitor Cbst may be connected to the third electrode of the second transistor T2, and an opposite end of the second capacitor Cbst may be connected to the first node N1.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line GCLj. The third transistor T3 may be turned on depending on the j-th compensation scan signal GCj transferred through the j-th compensation scan line GCLj and may diode-connect the first transistor T1 by connecting the third electrode of the first transistor T1 and the second electrode of the first transistor T1. One end of the third capacitor Nbst may be connected to the third electrode of the third transistor T3, and an opposite end of the third capacitor Nbst may be connected to the first node N1.

The fourth transistor T4 is connected between the first initialization voltage line VL3 through which the first initialization voltage VINT is applied and the first node N1. The fourth transistor T4 includes a first electrode connected with the first initialization voltage line VL3 through which the first initialization voltage VINT is transferred, a second electrode connected with the first node N1, and a third electrode (e.g., a gate electrode) connected with the j-th initialization scan line GILj. The fourth transistor T4 is turned on depending on the j-th initialization scan signal GIj transferred through the j-th initialization scan line GILj. The turned-on fourth transistor T4 initializes the potential of the third electrode of the first transistor T1 (that is, the potential of the first node N1) by transferring the first initialization voltage VINT to the first node N1.

The fifth transistor T5 includes a first electrode connected with the first drive voltage line VL1, a second electrode connected with the first electrode of the first transistor T1, and a third electrode (e.g., a gate electrode) connected to the j-th emission control line ECLj. The sixth transistor T6 includes a first electrode connected with the second electrode of the first transistor T1, a second electrode connected to the pixel electrode of the light-emitting element ED (or a second node N2), and a third electrode (e.g., a gate electrode) connected to the j-th emission control line ECLj.

The fifth and sixth transistors T5 and T6 are simultaneously turned on depending on the j-th emission control signal EMj transferred through the j-th emission control line ECLj. The first drive voltage ELVDD applied through the turned-on fifth transistor T5 may be compensated for through the diode-connected first transistor T1 and thereafter may be transferred to the light-emitting element ED through the sixth transistor T6.

The seventh transistor T7 includes a first electrode connected to the second initialization voltage line VL4 through which the second initialization voltage VAINT is transferred, a second electrode connected with the second electrode of the sixth transistor T6 (or the second node N2), and a third electrode (e.g., a gate electrode) connected with the j-th black scan line GBLj. The second initialization voltage VAINT may have a voltage level lower than or equal to the voltage level of the first initialization voltage VINT.

The one end of the first capacitor Cst is connected with the third electrode of the first transistor T1, and the opposite end of the first capacitor Cst is connected with the first drive voltage line VL1. A cathode of the light-emitting element ED may be connected with the second drive voltage line VL2 that transfers the second drive voltage ELVSS. The second drive voltage ELVSS may have a lower voltage level than a voltage level of the first drive voltage ELVDD.

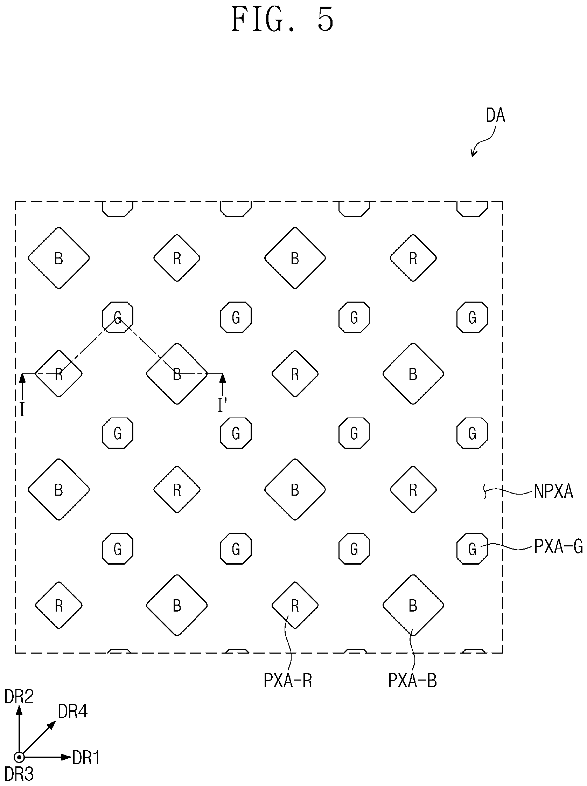

FIG. 5 is an enlarged plan view of an embodiment of a portion of the display region DA according to the disclosure. FIG. 5 is a plan view of the display module DM as viewed from above a display surface of the display module DM (refer to FIG. 1B) and illustrates an arrangement of emissive regions PXA-R, PXA-G, and PXA-B.

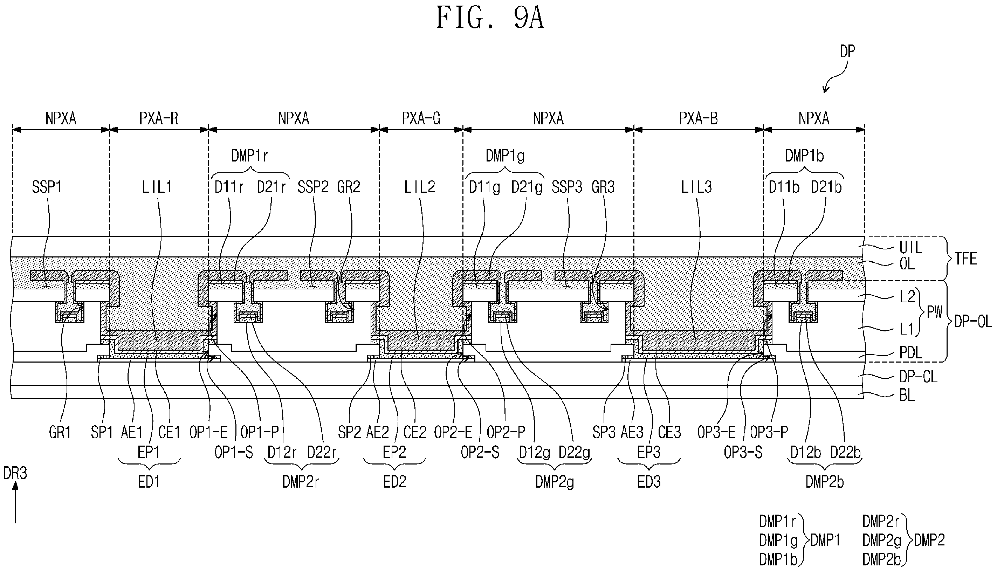

Referring to FIG. 5, the display region DA may include the first to third emissive regions PXA-R, PXA-G, and PXA-B and a peripheral region NPXA surrounding the first to third emissive regions PXA-R, PXA-G, and PXA-B. The first to third emissive regions PXA-R, PXA-G, and PXA-B may correspond to regions through which light provided from light-emitting elements ED1, ED2, and ED3 (refer to FIG. 9A) is emitted. The first to third emissive regions PXA-R, PXA-G, and PXA-B may be distinguished from one another depending on the colors of light emitted toward the outside of the display module DM (refer to FIG. 2).

The first to third emissive regions PXA-R, PXA-G, and PXA-B may provide first color light, second color light, and third color light that have different colors, respectively. In an embodiment, the first color light may be red light, the second color light may be green light, and the third color light may be blue light, for example. However, the first color light, the second color light, and the third color light are not necessarily limited thereto.

The first to third emissive regions PXA-R, PXA-G, and PXA-B may be defined as regions where the upper surfaces of anodes are exposed by light-emitting openings that will be described below. The peripheral region NPXA may set the boundaries between the first to third emissive regions PXA-R, PXA-G, and PXA-B and may prevent color mixing between the first to third emissive regions PXA-R, PXA-G, and PXA-B.

A plurality of first emissive regions PXA-R, a plurality of second emissive regions PXA-G, and a plurality of third emissive regions PXA-B may be provided. The plurality of first emissive regions PXA-R, the plurality of second emissive regions PXA-G, and the plurality of third emissive regions PXA-B may have a predetermined arrangement in the display region DA and may be repeatedly disposed. In an embodiment, the first and third emissive regions PXA-R and PXA-B may be alternately arranged in the first direction DR1 to form a "first group", for example. The second emissive regions PXA-G may be arranged in the first direction DR1 to form a "second group". A plurality of "first groups" and a plurality of "second groups" may be provided. The "first groups" and the "second groups" may be alternately arranged in the second direction DR2.

One second emissive region PXA-G may be spaced apart from one first emissive region PXA-R or one third emissive region PXA-B in a fourth direction DR4. The fourth direction DR4 may be defined as a direction between the first direction DR1 and the second direction DR2.

In FIG. 5, the arrangement of the first to third emissive regions PXA-R, PXA-G, and PXA-B is illustrated as an embodiment, and without being limited thereto, the first to third emissive regions PXA-R, PXA-G, and PXA-B may be disposed in various forms. In an embodiment, the first to third emissive regions PXA-R, PXA-G, and PXA-B may have a PENTILE^{™} arrangement form as illustrated in FIG. 5. In an alternative embodiment, the first to third emissive regions PXA-R, PXA-G, and PXA-B may have a stripe arrangement form or a Diamond Pixel^{™} arrangement form.

The first to third emissive regions PXA-R, PXA-G, and PXA-B may have various shapes when viewed from above the plane. In an embodiment, the first to third emissive regions PXA-R, PXA-G, and PXA-B may have a polygonal, circular, or oval shape, for example. FIG. 5 illustrates the first and third emissive regions PXA-R and PXA-B that have a quadrangular shape (or, a rhombic shape) when viewed from above the plane and the second emissive regions PXA-G that have an octagonal shape when viewed from above the plane.

When viewed from above the plane, the first to third emissive regions PXA-R, PXA-G, and PXA-B may have the same shape as each other, or at least some of the first to third emissive regions PXA-R, PXA-G, and PXA-B may have different shapes from each other. FIG. 5 illustrates the first and third emissive regions PXA-R and PXA-B that have the same shape as each other when viewed from above the plane and the second emissive regions PXA-G that have a shape different from those of the first and third emissive regions PXA-R and PXA-B.

At least some of the first to third emissive regions PXA-R, PXA-G, and PXA-B may have different areas from each other when viewed from above the plane. In an embodiment, the area of the first emissive region PXA-R emitting red light may be greater than the area of the second emissive region PXA-G emitting green light and may be smaller than the area of the third emissive region PXA-B emitting blue light. However, the relative size relationship between the first to third emissive regions PXA-R, PXA-G, and PXA-B depending on the colors of emitted light is not limited thereto and may vary depending on the design of the display module DM (refer to FIG. 2). Furthermore, without being limited thereto, the first to third emissive regions PXA-R, PXA-G, and PXA-B may have the same area when viewed from above the plane.

The shapes, areas, and arrangement of the first to third emissive regions PXA-R, PXA-G, and PXA-B of the display module DM (refer to FIG. 2) of the disclosure may be designed in various ways depending on the colors of emitted light or the size and configuration of the display module DM (refer to FIG.2) and are not limited to the embodiment illustrated in FIG. 5.

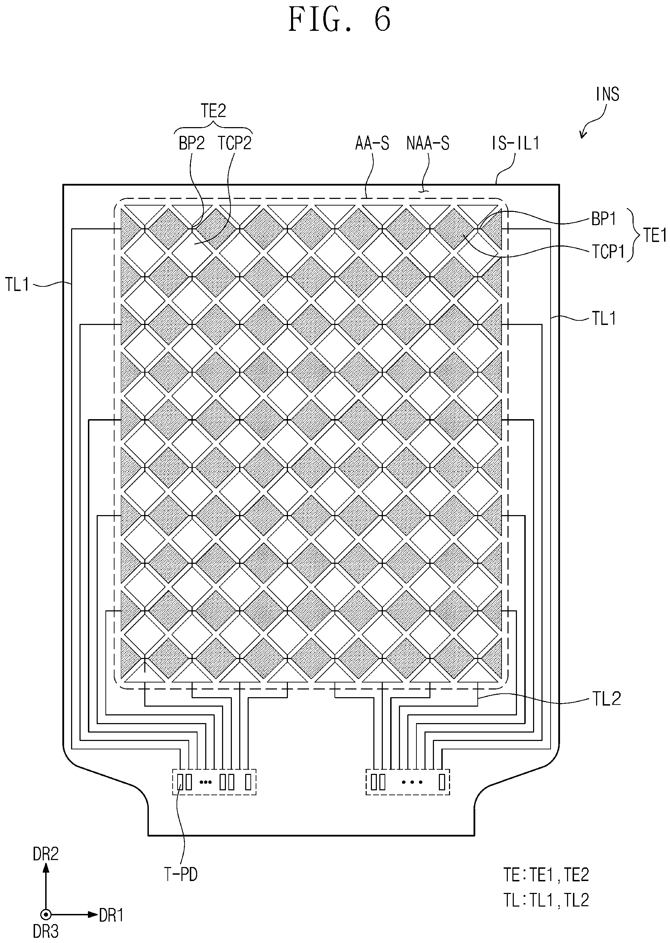

FIG. 6 is a plan view of an embodiment of the input sensor INS according to the disclosure.

Referring to FIG. 6, the input sensor INS may include a sensing region AA-S and a non-sensing region NAA-S adjacent to the sensing region AA-S. The sensing region AA-S may correspond to the display region DA (refer to FIG. 3) of the display module DM. The sensing region AA-S may be a region where sensing electrodes TE of the input sensor INS are disposed to sense an external input. The non-sensing region NAA-S may correspond to the peripheral region NAA (refer to FIG. 3) of the display module DM. The non-sensing region NAA-S may be a region where elements or lines for driving the sensing electrodes TE disposed in the sensing region AA-S are disposed.

The input sensor INS may include the sensing electrodes TE, sensing lines TL, and sensing pads T-PD disposed on a sensor base layer IS-IL1.

The sensing electrodes TE may include first sensing electrodes TE1 and second sensing electrodes TE2 that cross each other when viewed from above the plane and that are electrically isolated from each other. The input sensor INS may obtain information about an external input through a change in mutual capacitance between the first sensing electrodes TE1 and the second sensing electrodes TE2.

Each of the first sensing electrodes TE1 may extend in the first direction DR1, and the first sensing electrodes TE1 may be arranged in the second direction DR2. The first sensing electrodes TE1 may be provided in a plurality of rows arranged in the second direction DR2. Although ten first sensing electrodes TE1 arranged in the second direction DR2 are illustrated in FIG. 6, the number of first sensing electrodes TE1 included in the input sensor INS is not limited thereto.

Each of the second sensing electrodes TE2 may extend in the second direction DR2, and the second sensing electrodes TE2 may be arranged in the first direction DR1. The second sensing electrodes TE2 may be provided in a plurality of columns arranged in the first direction DR1. Although eight second sensing electrodes TE2 arranged in the first direction DR1 are illustrated in FIG. 6, the number of second sensing electrodes TE2 included in the input sensor INS is not limited thereto.

Each of the first sensing electrodes TE1 may include first sensing patterns TCP1 and first connecting patterns BP1. The first sensing patterns TCP1 may be arranged in the first direction DR1. The first connecting patterns BP1 may connect the first sensing patterns TCP1 adjacent to each other in the first direction DR1. The first connecting patterns BP1 may be disposed in the same layer as the first sensing patterns TCP1. The first connecting patterns BP1 may extend from the first sensing patterns TCP1 when viewed from above the plane and may have a one-body shape. The first sensing patterns TCP1 and the first connecting patterns BP1 may be patterns formed by making the same conductive layer subject to patterning through the same process. However, the disclosure is not limited thereto as long as the first connecting patterns BP1 electrically connect the first sensing patterns TCP1 adjacent to each other in the first direction DR1.

Each of the second sensing electrodes TE2 may include second sensing patterns TCP2 and second connecting patterns BP2. The second sensing patterns TCP2 may be arranged in the second direction DR2. The second connecting patterns BP2 may connect the second sensing patterns TCP2 adjacent to each other in the second direction DR2. The second connecting patterns BP2 may be disposed in a layer different from the second sensing patterns TCP2 and may be connected with the corresponding second sensing patterns TCP2 through contact holes. The second sensing patterns TCP2 spaced apart from each other in the second direction DR2 may be electrically connected through the second connecting patterns BP2. The second connecting patterns BP2 that are disposed in a layer different from the second sensing patterns TCP2 and that electrically connect the second sensing patterns TCP2 may be defined as bridge patterns.

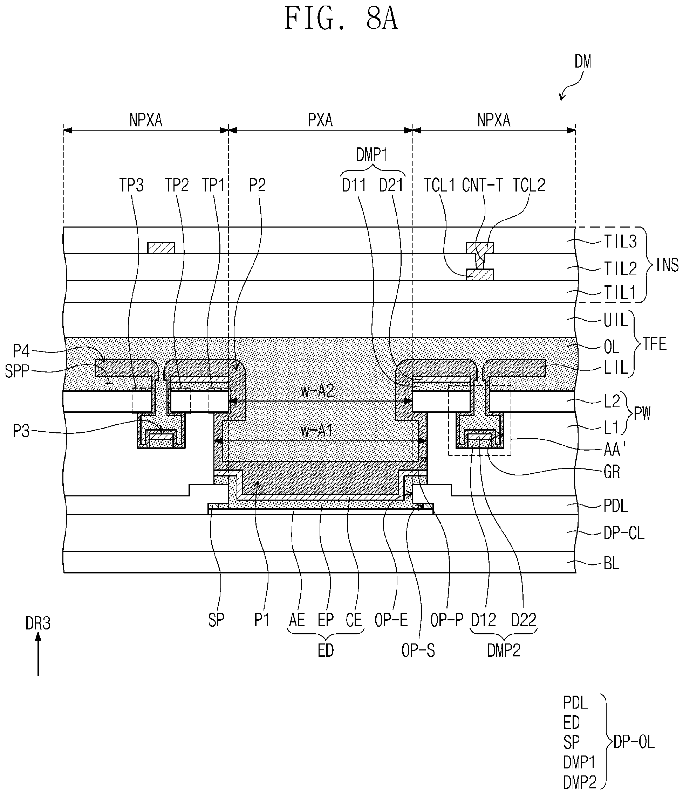

In an embodiment, the first sensing patterns TCP1, the first connecting patterns BP1, and the second sensing patterns TCP2 may be disposed in the same layer. The second connecting patterns BP2 may be disposed in a layer different from the second sensing patterns TCP2. In an embodiment, the first sensing patterns TCP1, the first connecting patterns BP1, and the second sensing patterns TCP2 may be included in a second sensor conductive layer TCL2 (refer to FIG. 8A), and the second connecting patterns BP2 may be included in a first sensor conductive layer TCL1 (refer to FIG. 8A), for example. However, without being limited thereto, the first sensing patterns TCP1, the first connecting patterns BP1, and the second sensing patterns TCP2 may be included in the first sensor conductive layer TCL1 (refer to FIG. 8A), and the second connecting patterns BP2 may be included in the second sensor conductive layer TCL2 (refer to FIG. 8A). In an alternative embodiment, the first sensing patterns TCP1, the second sensing patterns TCP2, and the second connecting patterns BP2 may be disposed in the same layer, and the first connecting patterns BP1 may be disposed in a layer different from the first sensing patterns TCP1.

The sensing lines TL may include first sensing lines TL1 and second sensing lines TL2. The first sensing lines TL1 may be connected to the first sensing electrodes TE1, respectively. Each of the first sensing lines TL1 may be connected to a first sensing electrode TE1 in a corresponding row among the first sensing electrodes TE1 provided in a plurality of rows. The second sensing lines TL2 may be connected to the second sensing electrodes TE2, respectively. Each of the second sensing lines TL2 may be connected to a second sensing electrode TE2 in a corresponding column among the second sensing electrodes TE2 provided in a plurality of columns.

The second sensing lines TL2 may be connected to lower ends of the second sensing electrodes TE2 adjacent to the sensing pads T-PD. The second sensing lines TL2 may extend from the lower ends of the corresponding second sensing electrodes TE2 on the non-sensing region NAA-S and may be connected to the sensing pads T-PD.

As illustrated in FIG. 6, the first sensing lines TL1 may be connected to left or right ends of the first sensing electrodes TE1, respectively. In an embodiment, each of first sensing lines TL1 connected to first sensing electrodes TE1 in odd-numbered rows among the first sensing lines TL1 may be connected to a left end of a corresponding first sensing electrode TE1 among the first sensing electrodes TE1 in the odd-numbered rows, for example. Each of first sensing lines TL1 connected to first sensing electrodes TE1 in even-numbered rows among the first sensing lines TL1 may be connected to a right end of a corresponding first sensing electrode TE1 among the first sensing electrodes TE1 in the even-numbered rows. The first sensing lines TL1 may extend in the second direction DR2 from the left or right ends of the corresponding first sensing electrodes TE1 on the non-sensing region NAA-S and may be connected to the sensing pads T-PD.

The sensing pads T-PD may be disposed in the non-sensing region NAA-S. The sensing pads T-PD may be disposed adjacent to the lower end of the sensor base layer IS-IL1. The sensing pads T-PD may be electrically connected to the sensing lines TL. The sensing pads T-PD may be spaced apart from each other and may be connected to the sensing lines TL, respectively. The sensing pads T-PD may be portions electrically connected to a circuit board that provides a drive signal. Signals may be applied to the sensing electrodes TE through the sensing pads T-PD and the sensing lines TL, or signals provided from the sensing electrodes TE may be received through the sensing pads T-PD and the sensing lines TL.

In an embodiment, drive signals for driving the first sensing electrodes TE1 and the second sensing electrodes TE2 may be applied to the first sensing electrodes TE1 and the second sensing electrodes TE2 through the second sensing lines TL2. Signals including information sensed by the first sensing electrodes TE1 and the second sensing electrodes TE2 may be output through the first sensing lines TL1. However, embodiments are not necessarily limited thereto.

The sensing pads T-PD may be unitary with the sensing lines TL correspondingly connected thereto. Unlike those illustrated in FIG. 6, the sensing pads T-PD may not be distinguished from the sensing lines TL, and ends of the sensing lines TL may correspond to sensing pad portions connected with a driver IC DIC (refer to FIG. 3) on a circuit board.

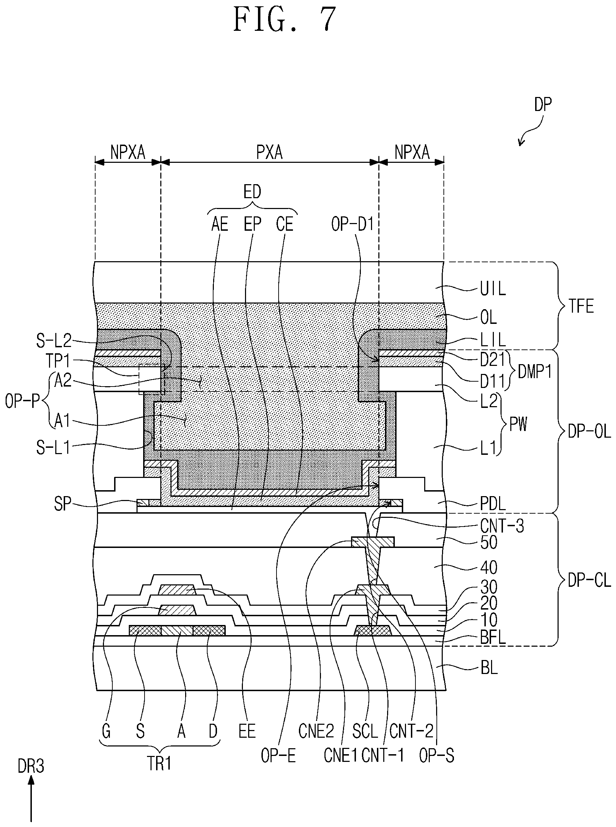

FIG. 7 is a cross-sectional view of an embodiment of the display panel DP according to the disclosure. FIG. 7 is an enlarged cross-sectional view of the display panel DP illustrating one emissive region PXA in the display region DA (refer to FIG. 3) and a peripheral region NPXA adjacent to the one emissive region PXA. The emissive region PXA of FIG. 7 may correspond to one of the first to third emissive regions PXA-R, PXA-G, and PXA-B of FIG. 5. In describing FIG. 7, the description will be made with reference to FIG. 2, and description of the same reference numerals will be omitted.

Referring to FIG. 7, the display panel DP may include the base layer BL, the circuit element layer DP-CL, the display element layer DP-OL, and the thin film encapsulation layer TFE.

The display panel DP may include a plurality of insulating layers, a semiconductor pattern, a conductive pattern, and a signal line. An insulating layer, a semiconductor layer, and a conductive layer are formed by coating, deposition, or the like. Thereafter, the insulating layer, the semiconductor layer, and the conductive layer may be selectively subjected to patterning by photolithography and etching. The semiconductor pattern, the conductive pattern, and the signal line included in the circuit element layer DP-CL and the display element layer DP-OL may be formed by the above-described method.

The circuit element layer DP-CL may be disposed on the base layer BL. The circuit element layer DP-CL may include a buffer layer BFL, a transistor TR1, a signal transmission region SCL, first to fifth insulating layers 10, 20, 30, 40, and 50, an upper electrode EE, and a plurality of connecting electrodes CNE1 and CNE2.

The buffer layer BFL may be disposed on the base layer BL. The buffer layer BFL may improve a coupling force between the base layer BL and a semiconductor pattern. The buffer layer BFL may include silicon oxide layers and silicon nitride layers. The silicon oxide layers and the silicon nitride layers may be alternately stacked one above another.

The semiconductor pattern may be disposed on the buffer layer BFL. The semiconductor pattern may include poly-silicon. However, without being limited thereto, the semiconductor pattern may include amorphous silicon or metal oxide. In FIG. 5, a portion of the semiconductor pattern is illustrated in an embodiment, and the semiconductor pattern may be additionally disposed in the plurality of emissive regions PXA-R, PXA-G, PXA-B (refer to FIG. 5). The semiconductor pattern may be arranged across the plurality of emissive regions PXA-R, PXA-G, PXA-B according to a predetermined rule. The semiconductor pattern may have different electrical properties depending on whether doping is performed or not. The semiconductor pattern may include a first region having a relatively high doping concentration and a second region having a relatively low doping concentration. The first region may be doped with an N-type dopant or a P-type dopant. A P-type transistor may include a first region doped with a P-type dopant.

The first region has a higher conductivity than the second region and substantially serves as an electrode or a signal line. The second region may substantially correspond to an active (or, channel) region of the transistor. In other words, one portion of the semiconductor pattern may be the active region of the transistor, another portion may be a source or drain of the transistor, and another portion may be a conductive region.

The source S, the active region A, and the drain D of the transistor TR1 may be formed from the semiconductor pattern. A portion of the signal transmission region SCL formed from the semiconductor pattern is illustrated in FIG. 7. Although not separately illustrated, the signal transmission region SCL may be connected to the drain D of the transistor TR1 when viewed from above the plane.

The first to fifth insulating layers 10, 20, 30, 40, and 50 may be disposed on the buffer layer BFL. The first to fifth insulating layers 10, 20, 30, 40, and 50 may each be an inorganic layer or an organic layer.

The first insulating layer 10 may be disposed on the buffer layer BFL. The first insulating layer 10 may cover the source S, the active region A, and the drain D of the transistor TR1 and the signal transmission region SCL that are disposed on the buffer layer BFL. A gate G of the transistor TR1 may be disposed on the first insulating layer 10. The second insulating layer 20 may be disposed on the first insulating layer 10 and may cover the gate G. The upper electrode EE may be disposed on the second insulating layer 20. The third insulating layer 30 may be disposed on the second insulating layer 20 and may cover the upper electrode EE.

The first connecting electrode CNE1 may be disposed on the third insulating layer 30. The first connecting electrode CNE1 may be connected to the signal transmission region SCL through a contact hole CNT-1 penetrating the first to third insulating layers 10, 20, and 30. The fourth insulating layer 40 may be disposed on the third insulating layer 30 and may cover the first connecting electrode CNE1. The fourth insulating layer 40 may be an organic layer.

The second connecting electrode CNE2 may be disposed on the fourth insulating layer 40. The second connecting electrode CNE2 may be connected to the first connecting electrode CNE1 through a contact hole CNT-2 penetrating the fourth insulating layer 40. The fifth insulating layer 50 may be disposed on the fourth insulating layer 40 and may cover the second connecting electrode CNE2. The fifth insulating layer 50 may be an organic layer.

The display element layer DP-OL may be disposed on the circuit element layer DP-CL. The display element layer DP-OL may include a light-emitting element ED, a sacrificial pattern SP, a pixel defining layer PDL, a barrier wall PW, and first dummy patterns DMP1.

The light-emitting element ED includes an anode AE (or, a first electrode), an emission pattern EP, and a cathode CE (or, a second electrode). Each of the first to third light-emitting elements ED1, ED2, and ED3 that will be described below may include substantially the same configuration as the light-emitting element ED of FIG. 4. Description of the anode AE, the emission pattern EP, and the cathode CE may be identically applied to an anode, an emission pattern, and a cathode of each of the first to third light-emitting elements ED 1 to ED3 that will be described below.

The anode AE may be disposed on the fifth insulating layer 50 of the circuit element layer DP-CL. The anode AE may be a transmissive electrode, a transflective electrode, or a reflective electrode. The anode AE may be connected to the second connecting electrode CNE2 by a connection contact hole CNT-3 defined to penetrate the fifth insulating layer 50. Accordingly, the anode AE may be electrically connected to the signal transmission region SCL through the first and second connecting electrodes CNE1 and CNE2 and may be electrically connected to a corresponding circuit element. The anode AE may include a single-layer structure or a multi-layer structure. The anode AE may include a plurality of layers including indium tin oxide ("ITO") and Ag. In an embodiment, the anode AE may include a layer (or, a lower ITO layer) including ITO, a layer (or a Ag layer) that is disposed on the lower ITO layer and that includes Ag, and a layer (or, an upper ITO layer) that is disposed on the Ag layer and that includes ITO, for example.

The sacrificial pattern SP may be disposed between the anode AE and the pixel defining layer PDL. The sacrificial pattern SP may correspond to a portion of a layer provided to prevent damage to the anode AE in a process of defining a barrier wall opening OP-P that will be described below. A sacrificial opening OP-S that exposes a portion of the upper surface of the anode AE may be defined in the sacrificial pattern SP. The sacrificial opening OP-S may overlap a light-emitting opening OP-E that will be described below. The sacrificial pattern SP may include amorphous transparent conductive oxide. In an embodiment, the sacrificial pattern SP may be zinc oxide ZnOₓ doped with aluminum (Al), for example.

The pixel defining layer PDL may be disposed on the fifth insulating layer 50 of the circuit element layer DP-CL. The light-emitting opening OP-E may be defined in the pixel defining layer PDL. The light-emitting opening OP-E may correspond to the anode AE, and the pixel defining layer PDL may expose at least a portion of the anode AE through the light-emitting opening OP-E.

The light-emitting opening OP-E may correspond to the sacrificial opening OPS of the sacrificial pattern SP. According to this embodiment, the upper surface of the anode AE may be spaced apart from the pixel defining layer PDL on the section with the sacrificial pattern SP therebetween. Accordingly, damage to the anode AE in a process of defining the light-emitting opening OP-E may be prevented.

When viewed from above the plane, the area of the light-emitting opening OP-E may be smaller than the area of the sacrificial opening OP-S. That is, the inner surface of the pixel defining layer PDL that defines the light-emitting opening OP-E may be closer to the center of the anode AE than the inner surface of the sacrificial pattern SP that defines the sacrificial opening OP-S is to the center of the anode AE. However, without being limited thereto, the inner surface of the sacrificial pattern SP that defines the sacrificial opening OP-S may be substantially aligned with the inner surface of the pixel defining layer PDL that defines the corresponding light-emitting opening OP-E. In this case, the emissive region PXA may be a region of the anode AE exposed from the corresponding sacrificial opening OP-S.

The pixel defining layer PDL may include an inorganic insulating material. The pixel defining layer PDL may include at least one of silicon oxide SiOₓ, silicon nitride SiNₓ, and silicon oxy nitride SiOₓN_{y}. In an embodiment, the pixel defining layer PDL may include silicon nitride SiNₓ, for example. The pixel defining layer PDL may be disposed between the anode AE and the barrier wall PW and may block electrical connection between the anode AE and the barrier wall PW. However, without being limited thereto, the pixel defining layer PDL may include an organic insulating material. Furthermore, the pixel defining layer PDL may be implemented with a single layer, or may be implemented with a plurality of layers. When the pixel defining layer PDL is implemented with a plurality of layers, the plurality of layers may include different materials from each other.

The barrier wall PW is disposed on the pixel defining layer PDL. The barrier wall opening OP-P is defined in the barrier wall PW. The barrier wall opening OP-P may correspond to the light-emitting opening OP-E and may expose at least a portion of the anode AE.

The barrier wall PW may have an undercut shape in cross-section. The barrier wall PW may include multiple layers sequentially stacked one above another, and at least one layer among the multiple layers may be recessed relative to the other layers. At least one layer among the multiple layers included in the barrier wall PW may protrude relative to the other layers. Accordingly, the barrier wall PW may include a first tip portion TP1.

The barrier wall PW may include a first barrier wall layer L1 and a second barrier wall layer L2. The first barrier wall layer L1 may be disposed on the pixel defining layer PDL, and the second barrier wall layer L2 may be disposed on the first barrier wall layer L1. Based on the emissive region PXA, the first barrier wall layer L1 may be recessed relative to the second barrier wall layer L2. That is, the first barrier wall layer L1 may be undercut with respect to the second barrier wall layer L2.

Only the state in which the first barrier wall layer L1 and the second barrier wall layer L2 are disposed is illustrated in the drawing. However, without being limited thereto, a third barrier wall layer may be additionally disposed on the second barrier wall layer L2 or may be additionally disposed under the first barrier wall layer L1, and the barrier wall PW is not limited to a particular embodiment.

The first barrier wall layer L1 may have conductivity. The first barrier wall layer L1 may include a conductive material. In an embodiment, the conductive material may include metal, metal nitride, transparent conductive oxide ("TCO"), or any combinations thereof, for example. In an embodiment, the metal may include gold (Au), silver (Ag), aluminum (Al), magnesium (Mg), lithium (Li), molybdenum (Mo), titanium (Ti), copper (Cu), or an alloy, for example. The metal nitride may include titanium nitride (TiN). The transparent conductive oxide may include indium tin oxide ("ITO"), indium zinc oxide ("IZO"), zinc oxide, indium oxide, indium gallium oxide, indium gallium zinc oxide ("IGZO"), or aluminum zinc oxide.

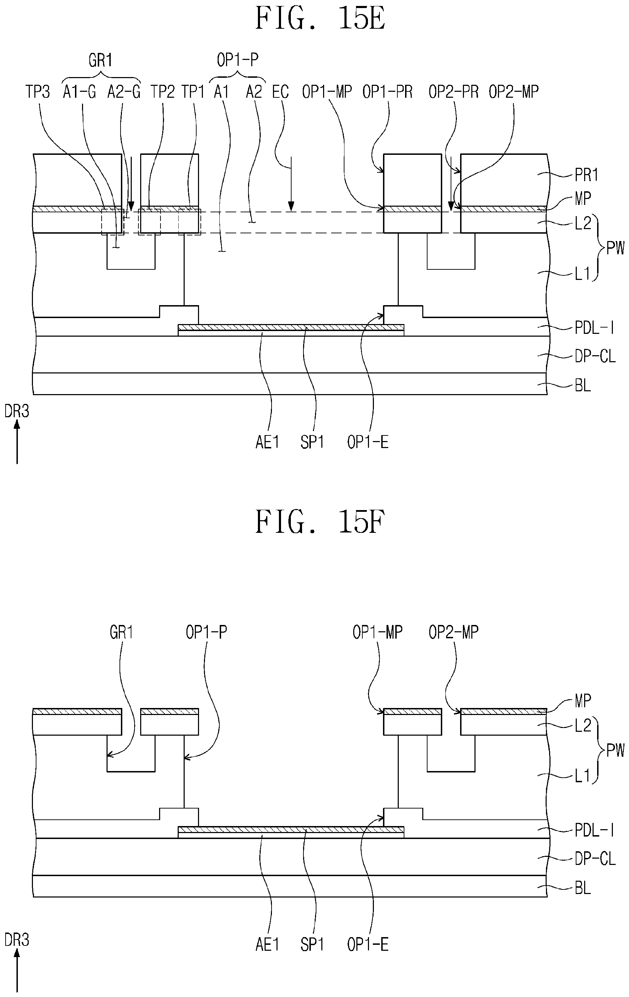

The second barrier wall layer L2 is disposed on the first barrier wall layer L1. The second barrier wall layer L2 may include a material having an etch selectivity with respect to the first barrier wall layer L1. In an embodiment, the reactivity of the second barrier wall layer L2 with a chemical EC (refer to FIG. 15E) that will be described below may be lower than the reactivity of the first barrier wall layer L1 with the chemical EC, for example. The first barrier wall layer L1 may be relatively recessed with respect to the emissive region PXA when compared to the second barrier wall layer L2. The second barrier wall layer L2 may define the first tip portion TP1 formed in the barrier wall PW.

The first tip portion TP1 of the barrier wall PW may be defined as a portion of the second barrier wall layer L2 that protrudes from the first barrier wall layer L1 toward the emissive region PXA. In this embodiment, the upper surface of the second barrier wall layer L2 may form the uppermost surface of the barrier wall PW and may define the upper surface of the first tip portion TP1 formed in the barrier wall PW.

In an embodiment, the second barrier wall layer L2 may include a conductive material. In an embodiment, the conductive material may include metal, metal nitride, transparent conductive oxide ("TCO"), or any combinations thereof, for example. In an embodiment, the metal may include gold (Au), silver (Ag), aluminum (Al), magnesium (Mg), lithium (Li), molybdenum (Mo), titanium (Ti), copper (Cu), or an alloy, for example. The metal nitride may include titanium nitride (TiN). The transparent conductive oxide may include indium tin oxide ("ITO"), indium zinc oxide ("IZO"), zinc oxide, indium oxide, indium gallium oxide, indium gallium zinc oxide ("IGZO"), or aluminum zinc oxide.

In an alternative embodiment of the disclosure, the second barrier wall layer L2 may include an insulating material. In an embodiment, the second barrier wall layer L2 may include an inorganic insulating material and may include a silicon-based compound, for example. In an embodiment, the second barrier wall layer L2 may include at least one of silicon oxide SiOₓ, silicon nitride SiNₓ, and silicon oxy nitride SiOₓN_{y}, for example.

The barrier wall opening OP-P defined in the barrier wall PW may include a first opening region A1 and a second opening region A2. The first barrier wall layer L1 may include a first inner surface S-L1 that defines the first opening region A1 of the barrier wall opening OP-P, and the second barrier wall layer L2 may include a second inner surface S-L2 that defines the second opening region A2 of the barrier wall opening OP-P.

The first inner surface S-L1 of the first barrier wall layer L1 may be recessed inward relative to the second inner surface S-L2 of the second barrier wall layer L2. When viewed from above the plane, the second inner surface S-L2 of the second barrier wall layer L2 that defines the second opening region A2 may protrude relative to the first inner surface S-L1 of the first barrier wall layer L1 that defines the first opening region A1 and may be closer to the center of the anode AE than the first inner surface S-L1 is to the center of the anode AE. The width w-A1 (refer to FIG. 8A) of the first opening region A1 may be different from the width w-A2 (refer to FIG. 8A) of the second opening region A2. The width w-A2 (refer to FIG. 8A) of the second opening region A2 may be narrower than the width w-A1 (refer to FIG. 8A) of the first opening region A1.

Although FIG. 7 illustrates an embodiment that the second inner surface S-L2 of the second barrier wall layer L2 extends perpendicular to the upper surface of the pixel defining layer PDL, the disclosure is not limited thereto. In an embodiment, the second inner surface S-L2 may have a tapered shape or an inverted tapered shape with respect to the upper surface of the pixel defining layer PDL, for example.

The emission pattern EP may be disposed on the anode AE. The emission pattern EP may include an emissive layer including a luminescent material. The emission pattern EP may further include a hole injection layer ("HIL") and a hole transport layer ("HTL") that are disposed between the anode AE and the emissive layer and may further include an electron transport layer ("ETL") and an electron injection layer ("EIL") that are disposed on the emissive layer. The emission pattern EP may be also referred to as an "organic layer (or organic light-emitting layer)" or an "intermediate layer".

The emission pattern EP may be subjected to patterning by the first tip portion TP1 defined in the barrier wall PW. The emission pattern EP may be disposed in the sacrificial opening OP-S, the light-emitting opening OP-E, and the barrier wall opening OP-P. The emission pattern EP may cover a portion of the upper surface of the pixel defining layer PDL exposed from the barrier wall opening OP-P.

The cathode CE may be disposed on the emission pattern EP. The cathode CE may be subjected to patterning by the first tip portion TP1 defined in the barrier wall PW. The cathode CE may contact the first inner surface S-L1 of the first barrier wall layer L1.

The barrier wall PW may receive a bias voltage (or, a common voltage). Accordingly, the cathode CE may be electrically connected to the barrier wall PW and may receive the bias voltage (or, the common voltage) from the barrier wall PW.

In an embodiment of the disclosure, the display panel DP may further include a capping pattern. The capping pattern may be disposed in the barrier wall opening OP-P and may be disposed on the cathode CE. The capping pattern may cover at least a portion of the cathode CE. The capping pattern may be subjected to patterning by the first tip portion TP1 formed in the barrier wall PW.

The first dummy patterns DMP1 may be disposed on the barrier wall PW. The first dummy patterns DMP1 may include a first-first layer dummy pattern D11 and a second-first layer dummy pattern D21. The first-first layer dummy pattern D11 and the second-first layer dummy pattern D21 may be sequentially stacked on the upper surface of the second barrier wall layer L2 of the barrier wall PW in the third direction DR3.

The first-first layer dummy pattern D11 may include an organic material. In an embodiment, the first-first layer dummy pattern D11 may include the same material as that of the emission pattern EP, for example. The first-first layer dummy pattern D11 may be simultaneously formed with the emission pattern EP through one process and may be separated from the emission pattern EP by the undercut shape of the barrier wall PW.

The second-first layer dummy pattern D21 may include a conductive material. In an embodiment, the second-first layer dummy pattern D21 may include the same material as that of the cathode CE, for example. The second-first layer dummy pattern D21 may be simultaneously formed with the cathode CE through one process and may be separated from the cathode CE by the undercut shape of the barrier wall PW.

In an embodiment of the disclosure, the first dummy patterns DMP1 may further include a third-first layer dummy pattern disposed on the second-first layer dummy pattern D21. As described above, the display panel DP may further include the capping pattern, and the third-first layer dummy pattern may include the same material as that of the capping pattern. The third-first layer dummy pattern may be simultaneously formed with the capping pattern through one process and may be separated from the capping pattern by the undercut shape of the barrier wall PW.

A first dummy opening OP-D1 may be defined in the first dummy patterns DMP1. The first dummy opening OP-D1 may overlap the light-emitting opening OP-E. The first dummy opening OP-D1 may include a region defined by the inner surface of the first-first layer dummy pattern D11 and a region defined by the inner surface of the second-first layer dummy pattern D21. Each of the first-first layer dummy pattern D11 and the second-first layer dummy pattern D21, when viewed from above the plane, may have a closed-line shape surrounding the emissive region PXA.

Although FIG. 7 illustrates an embodiment that the inner surface of the first-first layer dummy pattern D11 and the inner surface of the second-first layer dummy pattern D21 are aligned with the second inner surface S-L2 of the second barrier wall layer L2, the disclosure is not limited thereto, and the first-first layer dummy pattern D11 and the second-first layer dummy pattern D21 may cover the second inner surface S-L2 of the second barrier wall layer L2.

The thin film encapsulation layer TFE may be disposed on the display element layer DP-OL. The thin film encapsulation layer TFE may include a lower encapsulation pattern LIL, an organic encapsulation film OL, and an upper inorganic encapsulation film UIL.

The lower encapsulation pattern LIL may be disposed to overlap the light-emitting opening OP-E. The lower encapsulation pattern LIL may cover the light-emitting element ED, and a portion of the lower encapsulation pattern LIL may be disposed in the barrier wall opening OP-P. In an embodiment, the lower encapsulation pattern LIL may contact the first inner surface S-L1 of the first barrier wall layer L1 and the second inner surface S-L2 of the second barrier wall layer L2.

The organic encapsulation film OL may cover the lower encapsulation pattern LIL and may provide a flat upper surface. The upper inorganic encapsulation film UIL may be disposed on the organic encapsulation film OL.

The lower encapsulation pattern LIL and the upper inorganic encapsulation film UIL may protect the display element layer DP-OL from moisture/oxygen, and the organic encapsulation film OL may protect the display element layer DP-OL from foreign matter such as dust particles. The upper inorganic encapsulation film UIL may include silicon nitride, silicon oxy nitride, silicon oxide, titanium oxide, or aluminum oxide, but is not particularly limited thereto. The organic encapsulation film OL may include an acrylic compound, an epoxy compound, or the like. The organic encapsulation film OL may include an organic material capable of photopolymerization, but is not particularly limited.

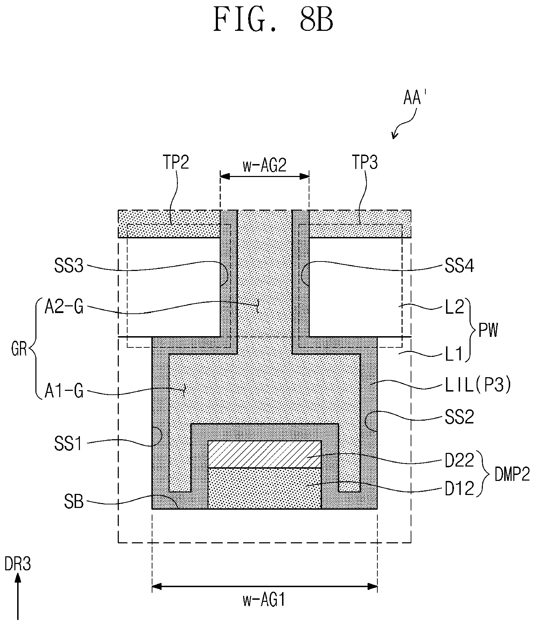

FIG. 8A is a cross-sectional view of an embodiment of the display module DM according to the disclosure. FIG. 8B is a cross-sectional view of the display module DM, where FIG. 8B illustrates a blowup of region AA' of FIG. 8A. FIG. 8A is an enlarged cross-sectional view of the display module DM illustrating one emissive region PXA in the display region DA (refer to FIG. 5) and a peripheral region NPXA adjacent to the one emissive region PXA. The emissive region PXA of FIG. 8A may correspond to one of the first to third emissive regions PXA-R, PXA-G, and PXA-B of FIG. 5. In describing FIGS. 8A and 8B, the description will be made with reference to FIGS. 2 and 7, and description of the same reference numerals will be omitted.

Referring to FIGS. 8A and 8B, the barrier wall opening OP-P and a groove GR spaced apart from the barrier wall opening OP-P are defined in the barrier wall PW according to this embodiment. The groove GR may be defined by removing at least a portion of the barrier wall PW in the thickness direction. The groove GR may be defined by a recess in the barrier wall in the thickness direction. The groove GR may be disposed outside the barrier wall opening OP-P. The groove GR may surround the barrier wall opening OP-P when viewed from above the plane. The groove GR may have a closed-line shape surrounding the barrier wall opening OP-P when viewed from above the plane.

The groove GR may include a first groove region A1-G defined by the first barrier wall layer L1 and a second groove region A2-G defined by the second barrier wall layer L2.

In this embodiment, the first groove region A1-G may be defined by removing a portion of the first barrier wall layer L1 in the thickness direction. The first groove region A1-G may be defined by a recess in the first barrier wall layer L1, or by penetrating into the first barrier wall layer L1, in the thickness direction. The first barrier wall layer L1 may include first and second peripheral inner surfaces SS1 and SS2 and a peripheral bottom surface SB that define the first groove region A1-G. The first peripheral inner surface SS1 and the second peripheral inner surface SS2 may face each other, and the first peripheral inner surface SS1 may be disposed closer to the barrier wall opening OP-P than the second peripheral inner surface SS2 is to the barrier wall opening OP-P. The bottom surface of the groove GR may be defined by the peripheral bottom surface SB of the first barrier wall layer L1.

The second groove region A2-G may be defined to penetrate the second barrier wall layer L2 in the thickness direction. The second barrier wall layer L2 may include third and fourth peripheral inner surfaces SS3 and SS4 that define the second groove region A2-G. The third peripheral inner surface SS3 and the fourth peripheral inner surface SS4 may face each other, and the third peripheral inner surface SS3 may be disposed closer to the barrier wall opening OP-P than the fourth peripheral inner surface SS4 is to the barrier wall opening OP-P.

The first peripheral inner surface SS1 of the first barrier wall layer L1 may be recessed in the direction toward the emissive region PXA or the barrier wall opening OP-P relative to the third peripheral inner surface SS3 of the second barrier wall layer L2. That is, the third peripheral inner surface SS3 of the second barrier wall layer L2 may protrude in the direction away from the emissive region PXA or the barrier wall opening OP-P relative to the first peripheral inner surface SS1 of the first barrier wall layer L1.

The second peripheral inner surface SS2 of the first barrier wall layer L1 may be recessed in the direction away from the emissive region PXA or the barrier wall opening OP-P relative to the fourth peripheral inner surface SS4 of the second barrier wall layer L2. That is, the fourth peripheral inner surface SS4 of the second barrier wall layer L2 may protrude in the direction toward the emissive region PXA or the barrier wall opening OP-P relative to the second peripheral inner surface SS2 of the first barrier wall layer L1.

The width w-AG2 of the second groove region A2-G may be narrower than the width w-AG1 of the first groove region A1-G.

In this embodiment, the barrier wall PW may include the first tip portion TP1, a second tip portion TP2, and a third tip portion TP3. The first tip portion TP1 may be defined at a portion adjacent to the barrier wall opening OP-P. Since the first tip portion TP1 has been described above with reference to FIG. 7, detailed description thereabout will be omitted.

The second and third tip portions TP2 and TP3 may be defined at portions adjacent to the groove GR. The second tip portion TP2 may be a portion defined by the third peripheral inner surface SS3 that protrudes relative to the first peripheral inner surface SS1. The second tip portion TP2 may be a portion of the second barrier wall layer L2 that protrudes in the direction away from the emissive region PXA (or, the barrier wall opening OP-P) that corresponds to the direction from the first barrier wall layer L1 toward the inside of the groove GR. The third tip portion TP3 may be a portion defined by the fourth peripheral inner surface SS4 that protrudes relative to the second peripheral inner surface SS2. The third tip portion TP3 may be a portion of the second barrier wall layer L2 that protrudes in the direction toward the emissive region PXA (or the barrier wall opening OP-P) that corresponds the direction from the first barrier wall layer L1 toward the inside of the groove GR.

Although FIG. 8A illustrates an embodiment that the first and second peripheral inner surfaces SS1 and SS2 of the first barrier wall layer L1 and the third and fourth peripheral inner surfaces SS3 and SS4 of the second barrier wall layer L2 extend perpendicular to the upper surface of the pixel defining layer PDL, the disclosure is not limited thereto. In an embodiment, the first to fourth peripheral inner surfaces SS1, SS2, SS3, and SS4 may have a tapered shape or an inverted tapered shape with respect to the upper surface of the pixel defining layer PDL, for example.

In this embodiment, the display panel DP may further include second dummy patterns DMP2. The second dummy patterns DMP2 may be disposed in the groove GR. The second dummy patterns DMP2 may be disposed on the peripheral bottom surface SB of the first barrier wall layer L1. The second dummy patterns DMP2 may include a first-second layer dummy pattern D12 and a second-second layer dummy pattern D22. The first-second layer dummy pattern D12 and the second-second layer dummy pattern D22 may be sequentially stacked on the peripheral bottom surface SB of the first barrier wall layer L1 in the third direction DR3.

The first-second layer dummy pattern D12 may include an organic material. In an embodiment, the first-second layer dummy pattern D12 may include the same material as that of the emission pattern EP, for example. The first-second layer dummy pattern D12 may be simultaneously formed with the emission pattern EP through one process and may be separated from the emission pattern EP by the undercut shapes at the second and third tip portions TP2 and TP3 in the barrier wall PW.

The second-second layer dummy pattern D22 may include a conductive material. In an embodiment, the second-second layer dummy pattern D22 may include the same material as that of the cathode CE, for example. The second-second layer dummy pattern D22 may be simultaneously formed with the cathode CE through one process and may be separated from the cathode CE by the undercut shapes at the second and third tip portions TP2 and TP3 in the barrier wall PW.

In an embodiment of the disclosure, the second dummy patterns DMP2 may further include a third-second layer dummy pattern disposed on the second-second layer dummy pattern D22. The third-second layer dummy pattern may include the same material as that of the capping pattern. The third-second layer dummy pattern may be simultaneously formed with the capping pattern through one process and may be separated from the capping pattern by the undercut shapes at the second and third tip portions TP2 and TP3 in the barrier wall PW.

When viewed from above the plane, each of the first-second layer dummy pattern D12 and the second-second layer dummy pattern D22 may be spaced apart from the barrier wall opening OP-P and may have a closed-line shape surrounding the emissive region PXA.

In this embodiment, the lower encapsulation pattern LIL may include an inner portion and an outer portion P4, and the inner portion may include a first portion P1, a second portion P2, and a third portion P3.

The first portion P1 may be a portion of the lower encapsulation pattern LIL disposed in the barrier wall opening OP-P. The first portion P1 may cover the light-emitting element ED, more specifically, the cathode CE. In addition, the first portion P1 may cover the first inner surface S-L1 (refer to FIG. 7) that defines the first opening region A1 (refer to FIG. 7) of the barrier wall opening OP-P and the second inner surface S-L2 (refer to FIG. 7) that defines the second opening region A2 (refer to FIG. 7) of the barrier wall opening OP-P. The first portion P1 may also cover the lower surface of the second barrier wall layer L2 that is exposed from the first barrier wall layer L1 in the second barrier wall layer L2 that defines the first tip portion TP1.

The second portion P2 may be a portion that extends from the first portion P1 and covers the first dummy patterns DMP1. The second portion P2 may be disposed on the barrier wall PW.

The third portion P3 may be a portion that extends from the second portion P2 and that is disposed in the groove GR. The third portion P3 may cover the second dummy patterns DMP2 in the groove GR. In addition, the third portion P3 may cover the first and second peripheral inner surfaces SS1 and SS2 and the peripheral bottom surface SB of the first barrier wall layer L1 that define the first groove region A1-G of the groove GR and the third and fourth peripheral inner surfaces SS3 and SS4 of the second barrier wall layer L2 that define the second groove region A2-G of the groove GR. The third portion P3 may cover the lower surface of the second barrier wall layer L2 that is exposed from the first barrier wall layer L1 in the second barrier wall layer L2 that defines the second tip portion TP2 and may cover the lower surface of the second barrier wall layer L2 that is exposed from the first barrier wall layer L1 in the second barrier wall layer L2 that defines the third tip portion TP3.

The outer portion P4 may be a portion partially spaced apart from the barrier wall PW to define a spacing region SPP. The outer portion P4 may extend from the third portion P3 and may be disposed over the barrier wall PW. At least part of the outer portion P4 may be spaced apart from the barrier wall PW, more specifically, the upper surface of the second barrier wall layer L2 at a predetermined interval. The spacing region SPP may be defined between the outer portion P4 and the barrier wall PW. The spacing region SPP may be defined or formed by removing a portion of a preliminary dummy pattern between the barrier wall PW and the outer portion P4 in a patterning process of the preliminary dummy pattern that will be described below.

Although the first portion P1, the second portion P2, the third portion P3, and the outer portion P4 of the lower encapsulation pattern LIL are distinguished from one another for convenience of description, the first portion P1, the second portion P2, the third portion P3, and the outer portion P4 may have a one-body shape without being divided from one another with an interface therebetween.

After the spacing region SPP is formed between the outer portion P4 of the lower encapsulation pattern LIL and the barrier wall PW, the outer portion P4 may be damaged by the spacing region SPP in a subsequent process. In an embodiment, the subsequent process may be a patterning process (e.g., an etching process), and due to the damage to the outer portion P4, the lower encapsulation pattern LIL adjacent to the spacing region SPP may be spaced apart from the barrier wall PW, for example. In this case, moisture may be introduced through the spaced portion of the lower encapsulation pattern LIL. When the barrier wall PW does not include the groove GR surrounding the barrier wall opening OP-P unlike in this embodiment, the spacing region SPP may be formed adjacent to the barrier wall opening OP-P. Accordingly, when the lower encapsulation pattern LIL is spaced, a moisture permeation path along which moisture is introduced into the light-emitting element ED may be easily formed.

In contrast, since the barrier wall PW includes the groove GR surrounding the barrier wall opening OP-P according to this embodiment, the spacing region SPP may be formed adjacent to the groove GR. Accordingly, even though the lower encapsulation pattern LIL is spaced, a moisture permeation path along which moisture is introduced into the light-emitting element ED need not be immediately formed. More specifically, while one tip portion is provided for one light-emitting element ED when the barrier wall PW does not include the groove GR, three tip portions TP1, TP2, and TP3 may be provided for one light-emitting element ED when the barrier wall PW includes the groove GR as in this embodiment. Accordingly, a moisture permeation path may be lengthened. In addition, even though the lower encapsulation pattern LIL is spaced at a tip portion (e.g., the third tip portion TP3) adjacent to the spacing region SPP, infiltration of moisture may be more stably blocked through the remaining tip portions (e.g., the first and second tip portions TP1 and TP2). Accordingly, by preventing moisture from infiltrating into the light-emitting element ED, the light-emitting element ED with improved process reliability and reduced defects may be provided.

In an embodiment, the spacing region SPP may be completely filled with the organic encapsulation film OL. However, without being limited thereto, depending on the height of the spacing region SPP and the material of the organic encapsulation film OL, the spacing region SPP may be provided as an empty space without being filled with the organic encapsulation film OL.

In an embodiment, the display module DM may include the input sensor INS disposed on the display panel DP. The input sensor INS may be directly disposed on the thin film encapsulation layer TFE. The input sensor INS may include a first sensing insulation layer TIL1, the first sensor conductive layer TCL1, a second sensing insulation layer TIL2, the second sensor conductive layer TCL2, and a third sensing insulation layer TIL3.

The first sensing insulation layer TIL1 may be directly disposed on the upper inorganic encapsulation film UIL. The first sensing insulation layer TIL1 may be an inorganic layer including at least one of silicon nitride, silicon oxy nitride, or silicon oxide. In an alternative embodiment, the first sensing insulation layer TIL1 may be an organic layer including an epoxy resin, an acrylic resin, or an imide-based resin. The first sensing insulation layer TIL1 may have a single-layer structure, or may have a multi-layer structure stacked in the third direction DR3.

The first sensor conductive layer TCL1 may be disposed on the first sensing insulation layer TIL1. The second sensing insulation layer TIL2 may be disposed on the first sensor conductive layer TCL1 and may cover the first sensor conductive layer TCL1. The second sensor conductive layer TCL2 may be disposed on the second sensing insulation layer TIL2. The third sensing insulation layer TIL3 may be disposed on the second sensor conductive layer TCL2 and may cover the second sensor conductive layer TCL2. The second sensor conductive layer TCL2 may be connected with the first sensor conductive layer TCL1 through a contact hole CNT-T penetrating the second sensing insulation layer TIL2.

Each of the first and second sensor conductive layers TCL1 and TCL2 may have a single-layer structure, or may have a multi-layer structure stacked in the third direction DR3.

A conductive layer having a single-layer structure may include a metal layer or a transparent conductive layer. The metal layer may include molybdenum, silver, titanium, copper, aluminum, or any alloys thereof. The transparent conductive layer may include transparent conductive oxide such as indium tin oxide ("ITO"), indium zinc oxide ("IZO"), zinc oxide (ZnO), indium zinc tin oxide ("IZTO"), or the like. In addition, the transparent conductive layer may include a conductive polymer such as poly(3,4-ethylenedioxythiophene) ("PEDOT"), a metal nano-wire, or graphene.

A conductive layer having a multi-layer structure may include metal layers. The meal layers may have, e.g., a three-layer structure of titanium/aluminum/titanium. The conductive layer having the multi-layer structure may include at least one metal layer and at least one transparent conductive layer.

Each of the first and second sensor conductive layers TCL1 and TCL2 may include transparent conductive oxide and may have a metal mesh shape including an opaque conductive material. As long as the visibility of an image displayed by light generated by the display element layer DP-OL is not deteriorated, each of the first and second sensor conductive layers TCL1 and TCL2 may have various materials and various shapes and is not limited to a particular embodiment.

Referring to FIGS. 6 and 8A, the components included in the first sensing electrodes TE1 and the second sensing electrodes TE2 may be included in one of the first sensor conductive layer TCL1 and the second sensor conductive layer TCL2.

According to this embodiment, the second sensing patterns TCP2 and the second connecting patterns BP2 of the second sensing electrodes TE2 and the first sensing patterns TCP1 of the first sensing electrodes TE1 may be disposed in the same layer. The first connecting patterns BP1 of the first sensing electrodes TE1 may be disposed in a layer different from the layer in which the second sensing patterns TCP2 and the second connecting patterns BP2 of the second sensing electrodes TE2 and the first sensing patterns TCP1 of the first sensing electrodes TE1 are disposed. In this embodiment, the second sensing electrodes TE2 and the first sensing patterns TCP1 may be included in the second sensor conductive layer TCL2, and the first connecting patterns BP1 may be included in the first sensor conductive layer TCL1.

At least one of the second sensing insulation layer TIL2 and the third sensing insulation layer TIL3 may include an inorganic film. The inorganic film may include at least one of aluminum oxide, titanium oxide, silicon oxide, silicon nitride, silicon oxy nitride, zirconium oxide, and hafnium oxide.

In an alternative embodiment, at least one of the second sensing insulation layer TIL2 and the third sensing insulation layer TIL3 may include an organic film. The organic film may include at least one of an acrylic resin, a methacrylic resin, a polyisoprene resin, a vinyl resin, an epoxy resin, a urethane-based resin, a cellulosic resin, a siloxane-based resin, a polyimide resin, a polyamide resin, and a perylene-based resin.

Although FIG. 8A illustrates an embodiment that the input sensor INS includes the first to third sensing insulation layers TIL1, TIL2, and TIL3, the number of sensing insulation layers constituting the input sensor INS is not limited to a particular embodiment.

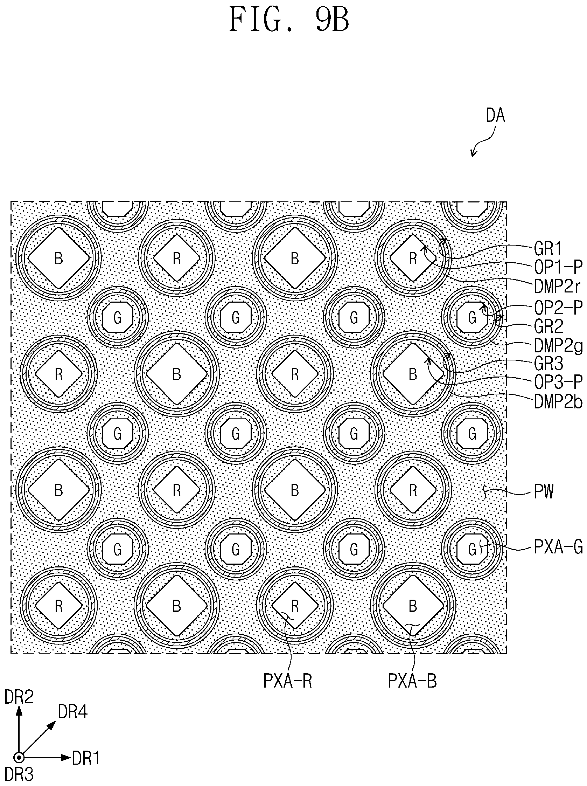

FIG. 9A is a cross-sectional view of an embodiment of the display panel DP taken along line I-I' of FIG. 5 according to the disclosure. FIG. 9B is an enlarged plan view illustrating an embodiment of some components of the display panel DP (e.g. refer to FIG. 9A) according to the disclosure. FIG. 9A is an enlarged view illustrating one first emissive region PXA-R, one second emissive region PXA-G, and one third emissive region PXA-B, and the description of the emissive region PXA of FIGs. 7 to 8B may be identically applied to each of the first to third emissive regions PXA-R, PXA-G, and PXA-B.

Referring to FIGS. 9A and 9B, the display panel DP according to this embodiment may include the base layer BL, the circuit element layer DP-CL, the display element layer DP-OL, and the thin film encapsulation layer TFE. The display element layer DP-OL may include the light-emitting elements ED1, ED2, and ED3, sacrificial patterns SP1, SP2, and SP3, the pixel defining layer PDL, the barrier wall PW, first dummy patterns DMP1r, DMP1g, and DMP1b, and second dummy patterns DMP2r, DMP2g, and DMP2b.

The light-emitting elements ED1, ED2, and ED3 may include the first light-emitting element ED1, the second light-emitting element ED2, and the third light-emitting element ED3. The first light-emitting element ED1 may include a first anode AE1, a first emission pattern EP1, and a first cathode CE1. The second light-emitting element ED2 may include a second anode AE2, a second emission pattern EP2, and a second cathode CE2. The third light-emitting element ED3 may include a third anode AE3, a third emission pattern EP3, and a third cathode CE3. The first to third anodes AE1, AE2, and AE3 may be provided in a plurality of patterns. In an embodiment, the first emission pattern EP1 may provide red light, the second emission pattern EP2 may provide green light, and the third emission pattern EP3 may provide blue light.

First to third light-emitting openings OP1-E, OP2-E, and OP3-E may be defined in the pixel defining layer PDL. The first light-emitting opening OP1-E may expose at least a portion of the first anode AE1. The first emissive region PXA-R may be defined as a region of the upper surface of the first anode AE1 that is exposed by the first light-emitting opening OP1-E. The second light-emitting opening OP2-E may expose at least a portion of the second anode AE2. The second emissive region PXA-G may be defined as a region of the upper surface of the second anode AE2 that is exposed by the second light-emitting opening OP2-E. The third light-emitting opening OP3-E may expose at least a portion of the third anode AE3. The third emissive region PXA-B may be defined as a region of the upper surface of the third anode AE3 that is exposed by the third light-emitting opening OP3-E.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be disposed on the upper surfaces of the first to third anodes AE1, AE2, and AE3, respectively. First to third sacrificial openings OP1-S, OP2-S, and OP3-S corresponding to the first to third light-emitting openings OP1-E, OP2-E, and OP3-E may be defined in the first to third sacrificial patterns SP1, SP2, and SP3, respectively.

In this embodiment, first to third barrier wall openings OP1-P, OP2-P, and OP3-P corresponding to the first to third light-emitting openings OP1-E, OP2-E, and OP3-E, respectively, may be defined in the barrier wall PW.

Each of the first to third barrier wall openings OP1-P, OP2-P, and OP3-P may include the first opening region A1 and the second opening region A2 described above with reference to FIG. 7. The first barrier wall layer L1 may include the first inner surfaces S-L1 (refer to FIG. 7) that define portions of the first opening regions A1 (refer to FIG. 7) of the first to third barrier wall openings OP1-P, OP2-P, and OP3-P. The second barrier wall layer L2 may include the second inner surfaces S-L2 (refer to FIG. 7) that define the second opening regions A2 (refer to FIG. 7) of the first to third barrier wall openings OP1-P, OP2-P, and OP3-P.

The first emission pattern EP1 and the first cathode CE1 may be disposed in the first barrier wall opening OP1-P, the second emission pattern EP2 and the second cathode CE2 may be disposed in the second barrier wall opening OP2-P, and the third emission pattern EP3 and the third cathode CE3 may be disposed in the third barrier wall opening OP3-P. The first to third cathodes CE1, CE2, and CE3 may contact the first inner surfaces S-L1 (refer to FIG. 7) of the first barrier wall layer L1.

The first to third cathodes CE1, CE2, and CE3 may be physically separated by the second barrier wall layer L2 that forms the first tip portions TP1 (refer to FIG. 8A) and may be formed in the light-emitting openings OP1-E, OP2-E, and OP3-E, respectively. The first to third cathodes CE1, CE2, and CE3 may be electrically connected with one another by contacting the first barrier wall layer L1 and may receive a common voltage. The first barrier wall layer L1 in contact with the first to third cathodes CE1, CE2, and CE3 may have a higher electrical conductivity than the second barrier wall layer L2 and thus may decrease contact resistance with the first to third cathodes CE1, CE2, and CE3. Accordingly, a common cathode voltage (e.g. the common voltage) may be uniformly provided for the emissive regions PXA-R, PXA-G, and PXA-B.

According to the disclosure, the plurality of emission patterns EP1, EP2, and EP3 may be subjected to patterning and deposited in pixel units by the first tip portions TP1 (refer to FIG. 7) defined in the barrier wall PW. That is, the plurality of emission patterns EP1, EP2, and EP3 may be commonly formed by an open mask, but may be easily divided in pixel units by the barrier wall PW.

In contrast, in a case in which the plurality of emission patterns EP1, EP2, and EP3 are subjected to patterning by a fine metal mask ("FMM"), a spacer for support that protrudes from a conductive barrier wall has to be provided to support the fine metal mask. Furthermore, the fine metal mask may be spaced, by the height of the barrier wall and the spacer, apart from a base surface on which the patterning is performed, and therefore there may be a limitation in the implementation of relatively high resolution. In addition, because the fine metal mask is brought into contact with the spacer, foreign matter may remain on the spacer after the patterning process of the plurality of emission patterns EP1, EP2, and EP3, or the spacer may be damaged by a dent in the fine metal mask. Accordingly, a defective display panel may be formed.

Since the barrier wall PW is included, the physical separation between the first to third light-emitting elements ED1, ED2, and ED3 may be easily achieved. Accordingly, current leakage or a driving error between the adjacent first to third emissive regions PXA-R, PXA-G, and PXA-B may be prevented, and the first to third light-emitting elements ED1, ED2, and ED3 may be independently driven.

In particular, by making the plurality of emission patterns EP1, EP2, and EP3 subject to patterning without a mask in contact with an internal component in the display region DA (refer to FIG. 3), a defect rate may be reduced, and thus the display panel DP with improved process reliability may be provided. Since the patterning is possible even without the separate spacer for support that protrudes from the barrier wall PW, the areas of the emissive regions PXA-R, PXA-G, and PXA-B may be scaled down, and thus the display panel DP capable of easily implementing relatively high resolution may be provided.

Furthermore, in the manufacture of the large-area display panel DP, the manufacture of a large-area mask may be omitted. Accordingly, process costs may be reduced, and the display panel DP may be not affected by defects that are likely to occur in the large-area mask. Thus, the display panel DP with improved process reliability may be provided.

In this embodiment, grooves GR are defined in the barrier wall PW. The grooves GR may include a first groove GR1, a second groove GR2, and a third groove GR3. The first groove GR1 may be adjacent to the first barrier wall opening OP1-P, the second groove GR2 may be adjacent to the second barrier wall opening OP2-P, and the third groove GR3 may be adjacent to the third barrier wall opening OP3-P.

Each of the first to third grooves GR1, GR2, and GR3 may include the first groove region A1-G (refer to FIG. 8B) and the second groove region A2-G (refer to FIG. 8B) described above with reference to FIG. 8B. The first barrier wall layer L1 may include the first peripheral inner surfaces SS1 (refer to FIG. 8B), the second peripheral inner surfaces SS2 (refer to FIG. 8B), and the peripheral bottom surfaces SB (refer to FIG. 8B) that define the first groove regions A1-G (refer to FIG. 8B) of the first to third grooves GR1, GR2, and GR3. The second barrier wall layer L2 may include the third peripheral inner surfaces SS3 (refer to FIG. 8B) and the fourth peripheral inner surfaces SS4 (refer to FIG. 8B) that define the second groove regions A2-G (refer to FIG. 8B) of the first to third grooves GR1, GR2, and GR3.

When viewed from above the plane, the first groove GR1 may surround the first barrier wall opening OP1-P, the second groove GR2 may surround the second barrier wall opening OP2-P, and the third groove GR3 may surround the third barrier wall opening OP3-P. Although FIG. 9B illustrates an embodiment that the first to third grooves GR1, GR2, and GR3 have a circular shape when viewed from above the plane, the shapes of the first to third grooves GR1, GR2, and GR3 are not limited thereto. In an embodiment, the first to third grooves GR1, GR2, and GR3 may have a polygonal shape, for example. The first to third grooves GR1, GR2, and GR3 may extend along the peripheries of the corresponding barrier wall openings and may have shapes similar to those of the corresponding barrier wall openings.

The first dummy patterns DMP1r, DMP1g, and DMP1b may include first-first dummy patterns DMP1r, first-second dummy patterns DMP1g, and first-third dummy patterns DMP1b. The first-first dummy patterns DMP1r, the first-second dummy patterns DMP1g, and the first-third dummy patterns DMP1b may include first-first layer dummy patterns D11r, D11g, and D11b and second-first layer dummy patterns D21r, D21g, and D21b.

The first-first dummy patterns DMP1r may include the first-first layer dummy pattern D11r and the second-first layer dummy pattern D21r that surround the first emissive region PXA-R when viewed from above the plane. The first-first layer dummy pattern D11r may include the same material as that of the first emission pattern EP1 and may be formed through the same process as that of the first emission pattern EP1. The second-first layer dummy pattern D21r may include the same material as that of the first cathode CE1 and may be formed through the same process as that of the first cathode CE1.

The first-second dummy patterns DMP1g may include the first-first layer dummy pattern D11g and the second-first layer dummy pattern D21g that surround the second emissive region PXA-G when viewed from above the plane. The first-first layer dummy pattern D11g may include the same material as that of the second emission pattern EP2 and may be formed through the same process as that of the second emission pattern EP2. The second-first layer dummy pattern D21g may include the same material as that of the second cathode CE2 and may be formed through the same process as that of the second cathode CE2.

The first-third dummy patterns DMP1b may include the first-first layer dummy pattern D11b and the second-first layer dummy pattern D21b that surround the third emissive region PXA-B when viewed from above the plane. The first-first layer dummy pattern D11b may include the same material as that of the third emission pattern EP3 and may be formed through the same process as that of the third emission pattern EP3. The second-first layer dummy pattern D21b may include the same material as that of the third cathode CE3 and may be formed through the same process as that of the third cathode CE3.

In this embodiment, the display panel DP may further include the second dummy patterns DMP2r, DMP2g, and DMP2b. The second dummy patterns DMP2r, DMP2g, and DMP2b may include second-first dummy patterns DMP2r, second-second dummy patterns DMP2g, and second-third dummy patterns DMP2b. The second-first dummy patterns DMP2r may be disposed in the first groove GR1, the second-second dummy patterns DMP2g may be disposed in the second groove GR2, and the second-third dummy patterns DMP2b may be disposed in the third groove GR3. The second-first dummy patterns DMP2r, the second-second dummy patterns DMP2g, and the second-third dummy patterns DMP2b may include first-second layer dummy patterns D12r, D12g, and D12b and second-second layer dummy patterns D22r, D22g, and D22b.

The second-first dummy patterns DMP2r may surround the corresponding first barrier wall opening OP1-P when viewed from above the plane. The second-first dummy patterns DMP2r may have a shape corresponding to the shape of the first groove GR1 when viewed from above the plane. The second-first dummy patterns DMP2r may include the first-second layer dummy pattern D12r and the second-second layer dummy pattern D22r. The first-second layer dummy pattern D12r may include the same material as that of the first emission pattern EP1 and may be formed through the same process as that of the first emission pattern EP1. The second-second layer dummy pattern D22r may include the same material as that of the first cathode CE1 and may be formed through the same process as that of the first cathode CE1.

The second-second dummy patterns DMP2g may surround the corresponding second barrier wall opening OP2-P when viewed from above the plane. The second-second dummy patterns DMP2g may have a shape corresponding to the shape of the second groove GR2 when viewed from above the plane. The second-second dummy patterns DMP2g may include the first-second layer dummy pattern D12g and the second-second layer dummy pattern D22g. The first-second layer dummy pattern D 12g may include the same material as that of the second emission pattern EP2 and may be formed through the same process as that of the second emission pattern EP2. The second-second layer dummy pattern D22g may include the same material as that of the second cathode CE2 and may be formed through the same process as that of the second cathode CE2.

The second-third dummy patterns DMP2b may surround the corresponding third barrier wall opening OP3-P when viewed from above the plane. The second-third dummy patterns DMP2b may have a shape corresponding to the shape of the third groove GR3 when viewed from above the plane. The second-third dummy patterns DMP2b may include the first-second layer dummy pattern D12b and the second-second layer dummy pattern D22b that surround the third emissive region PXA-B when viewed from above the plane. The first-second layer dummy pattern D12r may include the same material as that of the third emission pattern EP3 and may be formed through the same process as that of the third emission pattern EP3. The second-second layer dummy pattern D22b may include the same material as that of the third cathode CE3 and may be formed through the same process as that of the third cathode CE3.

The thin film encapsulation layer TFE may include lower encapsulation patterns LIL1, LIL2, and LIL3, the organic encapsulation film OL, and the upper inorganic encapsulation film UIL. In this embodiment, the lower encapsulation patterns LIL1, LIL2, and LIL3 may include the first lower encapsulation pattern LII,1, the second lower encapsulation pattern LIL2, and the third lower encapsulation pattern LIL3. The first to third lower encapsulation patterns LIL1, LIL2, and LIL3 may correspond to the first to third light-emitting openings OP1-E, OP2-E, and OP3-E, respectively. Each of the first to third lower encapsulation patterns LIL1, LIL2, and LIL3 may include the inner portion including the first to third portions P1, P2, and P3 and the outer portion P4 described above with reference to FIG. 8A. Hereinafter, detailed description thereabout will be omitted.

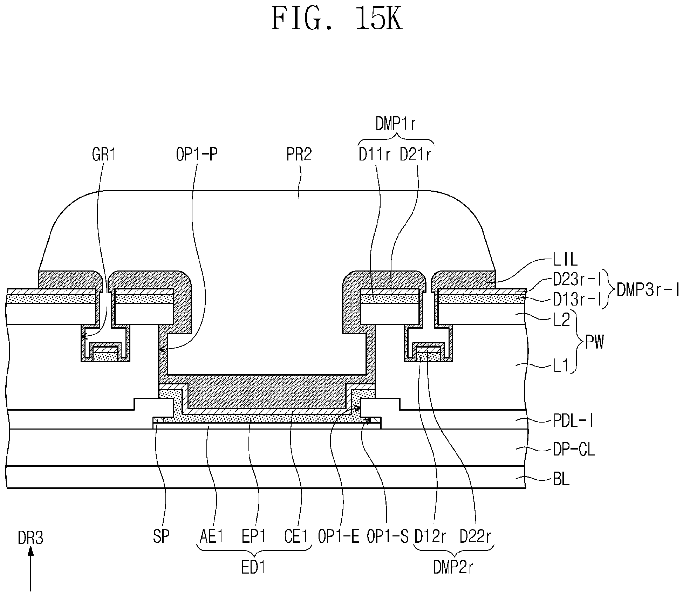

The first lower encapsulation pattern LIL1 may cover the first light-emitting element ED1 and the first-first dummy patterns DMP1r and may be partially disposed in the first barrier wall opening OP1-P. In addition, the first lower encapsulation pattern LIL1 may cover the second-first dummy patterns DMP2r and may be partially disposed in the first groove GR1. A portion of the first lower encapsulation pattern LIL1 may be spaced apart from the barrier wall PW, more specifically, the upper surface of the second barrier wall layer L2 at a predetermined interval. A first spacing region SSP1 may be defined between the first lower encapsulation pattern LIL1 and the barrier wall PW. The first spacing region SSP1 may be defined or formed by removing a portion of first-first preliminary dummy patterns (e.g. which may refer to the preliminary dummy patterns corresponding to the third-first preliminary dummy patterns DMP3r-I DMP3r-I in FIG. 15K) between the barrier wall PW and the first lower encapsulation pattern LIL1 in a patterning process of the first-first preliminary dummy patterns that will be described below.

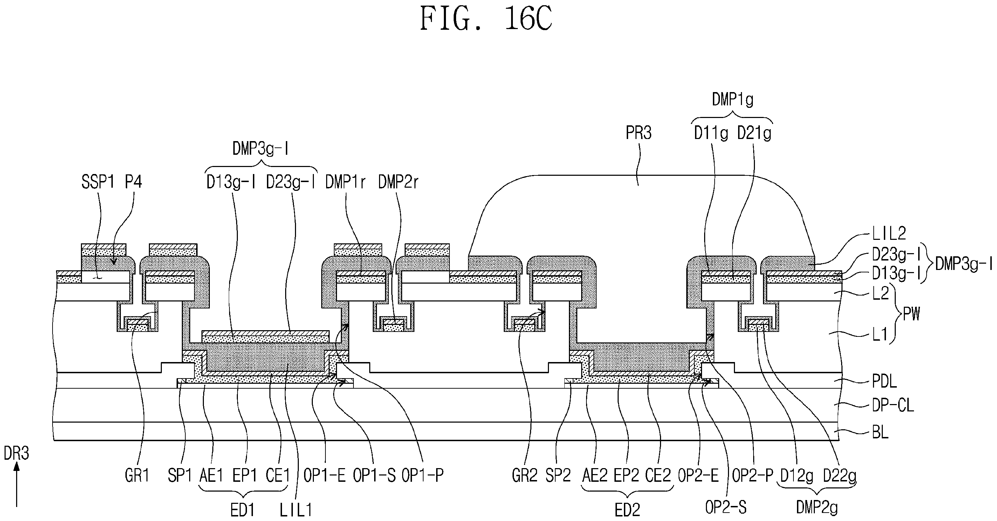

The second lower encapsulation pattern LIL2 may cover the second light-emitting element ED2 and the first-second dummy patterns DMP1g and may be partially disposed in the second barrier wall opening OP2-P. In addition, the second lower encapsulation pattern LIL2 may cover the second-second dummy patterns DMP2g and may be partially disposed in the second groove GR2. A portion of the second lower encapsulation pattern LIL2 may be spaced apart from the barrier wall PW, more specifically, the upper surface of the second barrier wall layer L2 at a predetermined interval. A second spacing region SSP2 may be defined between the second lower encapsulation pattern LIL2 and the barrier wall PW. The second spacing region SSP2 may be defined or formed by removing a portion of first-second preliminary dummy patterns (e.g. which may refer to the preliminary dummy patterns corresponding to the third-second preliminary dummy patterns DMP3g-I in FIG. 16C) between the barrier wall PW and the second lower encapsulation pattern LIL2 in a patterning process of the first-second preliminary dummy patterns that will be described below.

The third lower encapsulation pattern LIL3 may cover the third light-emitting element ED3 and the first-third dummy patterns DMP1b and may be partially disposed in the third barrier wall opening OP3-P. In addition, the third lower encapsulation pattern LIL3 may cover the second-third dummy patterns DMP2b and may be partially disposed in the third groove GR3. A portion of the third lower encapsulation pattern LIL3 may be spaced apart from the barrier wall PW, more specifically, the upper surface of the second barrier wall layer L2 at a predetermined interval. A third spacing region SSP3 may be defined between the third lower encapsulation pattern LIL3 and the barrier wall PW. The third spacing region SSP3 may be defined or formed by removing a portion of first-third preliminary dummy patterns between the barrier wall PW and the third lower encapsulation pattern LIL3 in a patterning process of the first-third preliminary dummy patterns for forming the first-third dummy patterns DMP1b. That is to say, during a subsequent processing operation, the spacing regions SSP1, SSP2, and SSP3 may be formed between the barrier wall PW and the tip portions of the lower encapsulation patterns LIL.

The first to third lower encapsulation patterns LII,1, LIL2, and LIL3 may be provided in the form of patterns spaced apart from one another. The organic encapsulation film OL may commonly cover the first to third lower encapsulation patterns LIL1, LIL2, and LIL3.

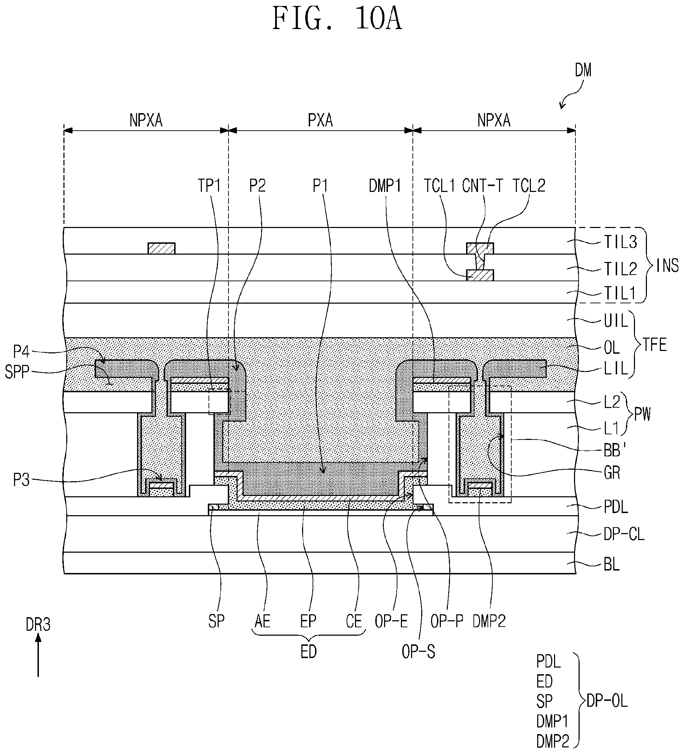

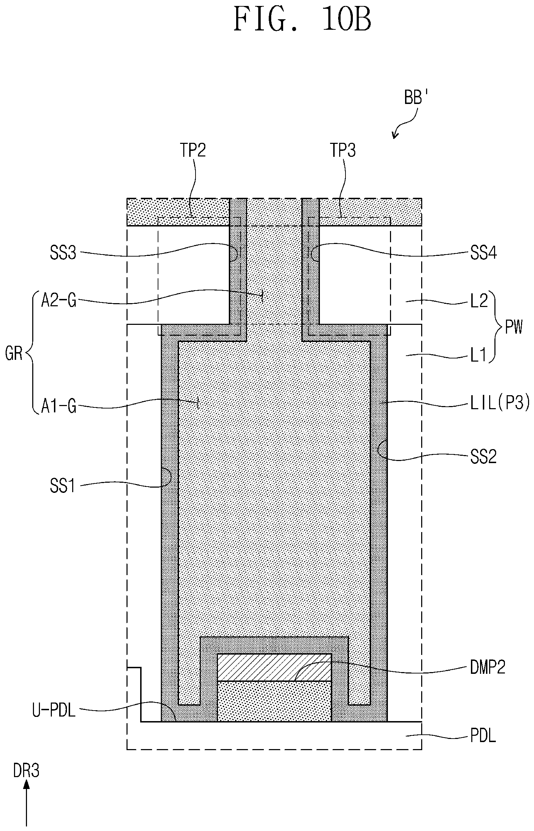

FIG. 10A is a cross-sectional view of an embodiment of the display module DM according to the disclosure. FIG. 10B is a cross-sectional view of the display module DM, where FIG. 10B illustrates a blowup of region BB' of FIG. 10A.

Referring to FIGS. 10A and 10B, the barrier wall opening OP-P and the groove GR may be defined in the barrier wall PW according to this embodiment. The groove GR in this embodiment may be defined to penetrate the barrier wall PW in the thickness direction. Accordingly, the groove GR in this embodiment may be also referred to as a peripheral opening.

The groove GR may include the first groove region A1-G defined by the first barrier wall layer L1 and the second groove region A2-G defined by the second barrier wall layer L2.

In this embodiment, the first groove region A1-G may be defined to penetrate the first barrier wall layer L1 in the thickness direction. The first barrier wall layer L1 may include the first and second peripheral inner surfaces SS1 and SS2 that define the first groove region A1-G.

The second groove region A2-G may be defined to penetrate the second barrier wall layer L2 in the thickness direction. The second barrier wall layer L2 may include the third and fourth peripheral inner surfaces SS3 and SS4 that define the second groove region A2-G.

The bottom surface of the groove GR may be defined by a portion of an upper surface U-PDL of the pixel defining layer PDL that is exposed from the barrier wall PW by the groove GR.

In this embodiment, the second dummy patterns DMP2 may be disposed in the groove GR. The second dummy patterns DMP2 may be disposed on the bottom surface of the groove GR. That is, the second dummy patterns DMP2 may be disposed on the upper surface U-PDL of the pixel defining layer PDL that is exposed from the barrier wall PW by the groove GR.

In this embodiment, the lower encapsulation pattern LIL may include the inner portion and the outer portion P4, and the inner portion may include the first portion P1, the second portion P2, and the third portion P3. The third portion P3 may cover the first and second peripheral inner surfaces SS1 and SS2 of the first barrier wall layer L1 that define the first groove region A1-G of the groove GR and the third and fourth peripheral inner surfaces SS3 and SS4 of the second barrier wall layer L2 that define the second groove region A2-G of the groove GR. In addition, the third portion P3 may cover the second dummy patterns DMP2 and the upper surface U-PDL of the pixel defining layer PDL that is exposed from the barrier wall PW by the groove GR.

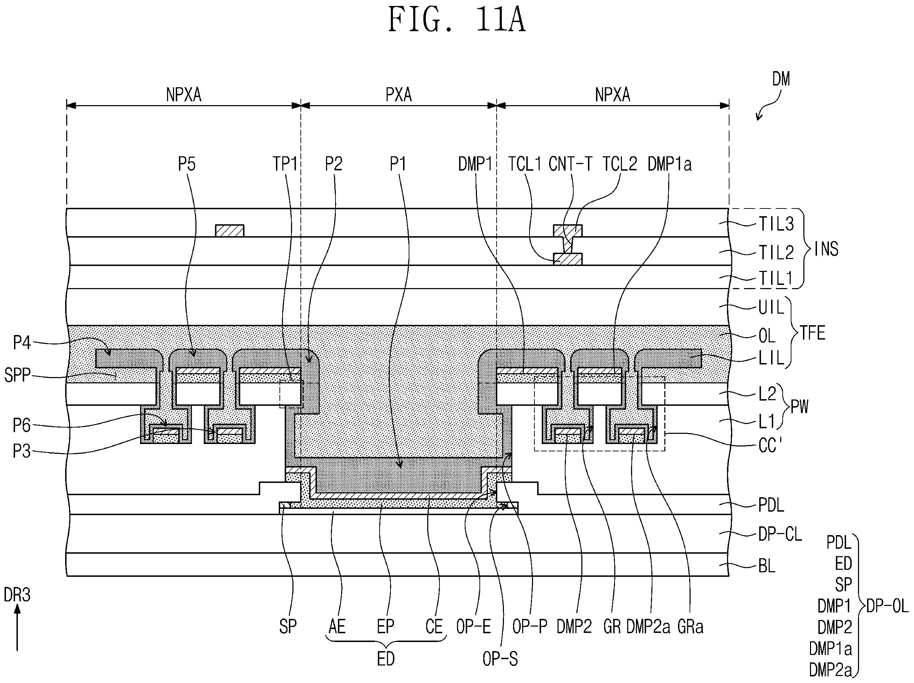

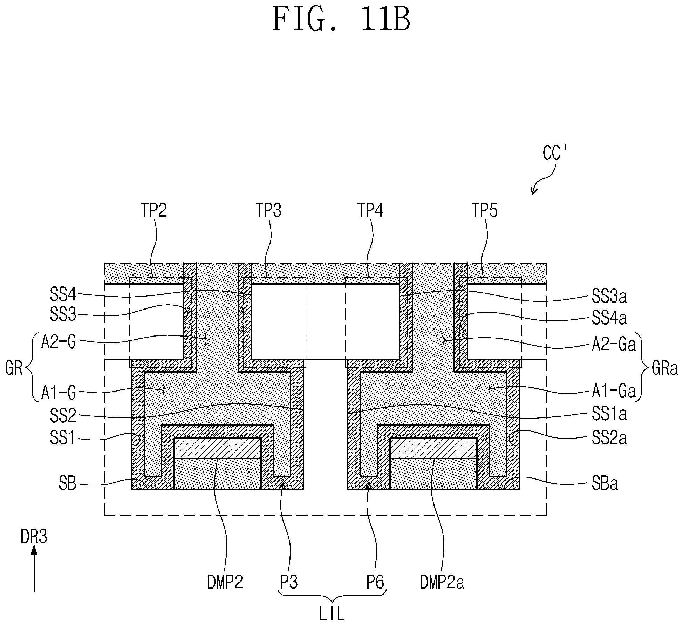

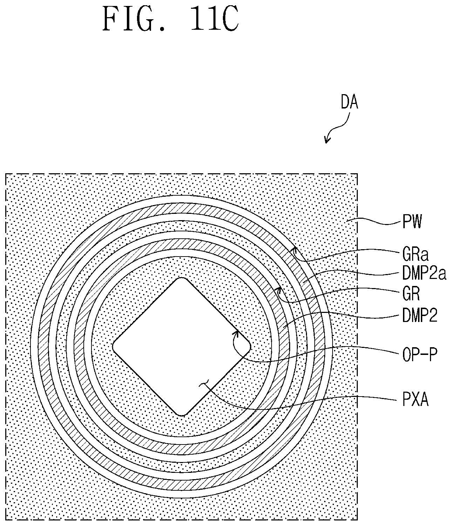

FIG. 11A is a cross-sectional view of an embodiment of the display module DM according to the disclosure. FIG. 11B is a cross-sectional view of the display module DM, where FIG. 11B illustrates a blowup of region CC' of FIG. 11A. FIG. 11C is an enlarged plan view illustrating an embodiment of some components of the display module DM (e.g. refer to FIG. 11A) according to the disclosure.

Referring to FIGS. 11A to 11C, the barrier wall opening OP-P, the groove GR, and an additional groove GRa may be defined in the barrier wall PW according to this embodiment. The groove GR in this embodiment may be defined or formed by removing a portion of the barrier wall PW in the thickness direction. The groove GR in this embodiment may be defined by a recess in, or penetrating into, the barrier wall PW in the thickness direction. The description made with reference to FIGS. 8A and 8B may be identically applied to the groove GR in this embodiment, and detailed description will hereinafter be omitted.

The additional groove GRa may be disposed outward of the groove GR. The additional groove GRa may be spaced further apart from the barrier wall opening OP-P relative to the groove GR. The additional groove GRa may include a first additional groove region A1-Ga defined by the first barrier wall layer L1 and a second additional groove region A2-Ga defined by the second barrier wall layer L2.

In this embodiment, the first additional groove region A1-Ga may be defined or formed by removing a portion of the first barrier wall layer L1 in the thickness direction. The first additional groove region A1-Ga may be defined by a recess in, or penetrating a portion of, the first barrier wall layer L1 in the thickness direction. The first barrier wall layer L1 may include first and second additional inner surfaces SS1a and SS2a and an additional bottom surface SBa that define the first additional groove region A1-Ga. The first additional inner surface SS1a and the second additional inner surface SS2a may face each other, and the first additional inner surface SS1a may be disposed closer to the barrier wall opening OP-P than the second additional inner surface SS2a is to the barrier wall opening OP-P. The bottom surface of the additional groove GRa may be defined by the additional bottom surface SBa of the first barrier wall layer L1.

The second additional groove region A2-Ga may be defined to penetrate the second barrier wall layer L2 in the thickness direction. The second barrier wall layer L2 may include third and fourth additional inner surfaces SS3a and SS4a that define the second additional groove region A2-Ga. The third additional inner surface SS3a and the fourth additional inner surface SS4a may face each other, and the third additional inner surface SS3a may be disposed closer to the barrier wall opening OP-P than the fourth additional inner surface SS4a is to the barrier wall opening OP-P.

The first additional inner surface SS1a of the first barrier wall layer L1 may be recessed in the direction toward the emissive region PXA or the barrier wall opening OP-P relative to the third additional inner surface SS3a of the second barrier wall layer L2. That is, the third additional inner surface SS3a of the second barrier wall layer L2 may protrude in the direction away from the emissive region PXA or the barrier wall opening OP-P relative to the first additional inner surface SS1a of the first barrier wall layer L1.

The second additional inner surface SS2a of the first barrier wall layer L1 may be recessed in the direction away from the emissive region PXA or the barrier wall opening OP-P relative to the fourth additional inner surface SS4a of the second barrier wall layer L2. That is, the fourth additional inner surface SS4a of the second barrier wall layer L2 may protrude in the direction toward the emissive region PXA or the barrier wall opening OP-P relative to the second additional inner surface SS2a of the first barrier wall layer L1.

The width of the second additional groove region A2-Ga may be narrower than the width of the first groove region A1-Ga.

In this embodiment, the barrier wall PW may include first to fifth tip portions TP1, TP2, TP3, TP4, and TP5. The fourth and fifth tip portions TP4 and TP5 may be defined at portions adjacent to the additional groove GRa. The fourth tip portion TP4 may be a portion defined by the third additional inner surface SS3a that protrudes relative to the first additional inner surface SS1a. The fifth tip portion TP5 may be a portion defined by the fourth additional inner surface SS4a that protrudes relative to the second additional inner surface SS2a.

In this embodiment, the display panel DP may further include first additional dummy patterns DMP1a and second additional dummy patterns DMP2a. The first additional dummy patterns DMP1a may be disposed on the barrier wall PW between the groove GR and the additional groove GRa. The second additional dummy patterns DMP2a may be disposed in the additional groove GRa. The second additional dummy patterns DMP2a may be disposed on the additional bottom surface SBa of the first barrier wall layer L1.

The first additional dummy patterns DMP1a may include a first-first layer additional dummy pattern and a second-first layer additional dummy pattern, and the second additional dummy patterns DMP2a may include a first-second layer additional dummy pattern and a second-second layer additional dummy pattern. The first-first layer additional dummy pattern and the first-second layer additional dummy pattern may be simultaneously formed with the emission pattern EP through one process and may be separated from the emission pattern EP by the undercut shapes at the fourth and fifth tip portions TP4 and TP5 in the barrier wall PW. The second-first layer additional dummy pattern and the second-second layer additional dummy pattern may be simultaneously formed with the cathode CE through one process and may be separated from the cathode CE by the undercut shapes at the fourth and fifth tip portions TP4 and TP5 in the barrier wall PW.

In this embodiment, the lower encapsulation pattern LIL may include the inner portion and the outer portion P4, and the inner portion may include the first portion P1, the second portion P2, the third portion P3, a first additional portion P5, and a second additional portion P6.

The first additional portion P5 may be a portion that covers the first additional dummy patterns DMP1a. The first additional portion P5 may extend from the third portion P3 and may be disposed on the barrier wall PW.

The second additional portion P6 may be a portion that extends from the first additional portion P5 and that is disposed in the additional groove GRa. The second additional portion P6 may cover the second additional dummy patterns DMP2a in the additional groove GRa. In addition, the second additional portion P6 may cover the first and second additional inner surfaces SS1a and SS2a and the additional bottom surface SBa of the first barrier wall layer L1 that define the first additional groove region A1-Ga of the additional groove GRa and the third and fourth additional inner surfaces SS3a and SS4a of the second barrier wall layer L2 that define the second additional groove region A2-Ga of the additional groove GRa. The second additional portion P6 may cover the lower surface of the second barrier wall layer L2 that is exposed from the first barrier wall layer L1 in the second barrier wall layer L2 that defines the fourth tip portion TP4 and may cover the lower surface of the second barrier wall layer L2 that is exposed from the first barrier wall layer L1 in the second barrier wall layer L2 that defines the fifth tip portion TP5.

The outer portion P4 may extend from the second additional portion P6 and may be disposed on the barrier wall PW. A portion of the outer portion P4 may be spaced apart from the barrier wall PW to define the spacing region SPP.

In this embodiment, the five tip portions TP1, TP2, TP3, TP4, and TP5 may be defined between the spacing region SPP and the light-emitting element ED, and thus a moisture permeation path along which moisture is introduced into the light-emitting element ED may be lengthened. Accordingly, infiltration of moisture into the light-emitting element ED may be more stably blocked, and the light-emitting element ED with improved process reliability and reduced defects may be provided.

Although the first to third portions P1, P2, and P3, the first and second additional portions P5 and P6, and the outer portion P4 of the lower encapsulation pattern LIL are distinguished from one another for convenience of description, the first to third portions P1, P2, and P3, the first and second additional portions P5 and P6, and the outer portion P4 may have a one-body shape without being divided from one another with an interface therebetween.

As illustrated in FIG. 11C, when viewed from above the plane, the groove GR may surround the barrier wall opening OP-P, and the additional groove GRa may surround the groove GR. The groove GR and the additional groove GRa may have a closed-line shape surrounding the emissive region PXA when viewed from above the plane. Although FIG. 11C illustrates an embodiment that the groove GR and the additional groove GRa have a circular shape when viewed from above the plane, the shapes of the groove GR and the additional groove GRa are not limited thereto. In an embodiment, the groove GR and the additional groove GRa may have a polygonal shape, for example. The groove GR and the additional groove GRa may extend along the periphery of the corresponding barrier wall opening OP-P and may have a shape similar to that of the corresponding barrier wall opening OP-P.

When viewed from above the plane, the second dummy patterns DMP2 may surround the barrier wall opening OP-P, and the second additional dummy patterns DMP2a may surround the groove GR and the second dummy patterns DMP2. The second dummy patterns DMP2 may have a shape corresponding to the shape of the groove GR when viewed from above the plane, and the second additional dummy patterns DMP2a may have a shape corresponding to the shape of the additional groove GRa when viewed from above the plane. The second dummy patterns DMP2 and the second additional dummy patterns DMP2a may have a closed-line shape surrounding the emissive region PXA when viewed from above the plane.

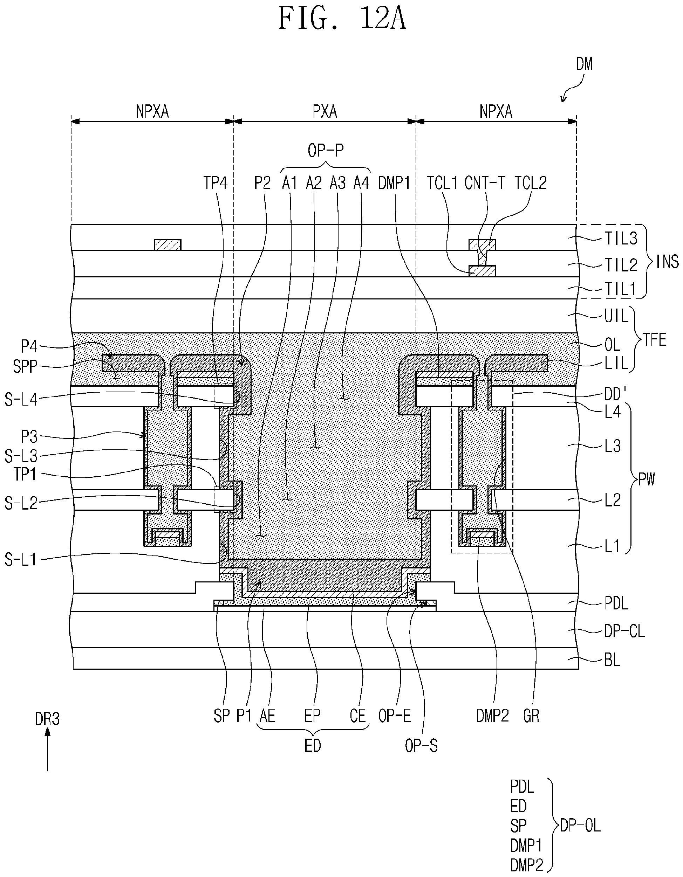

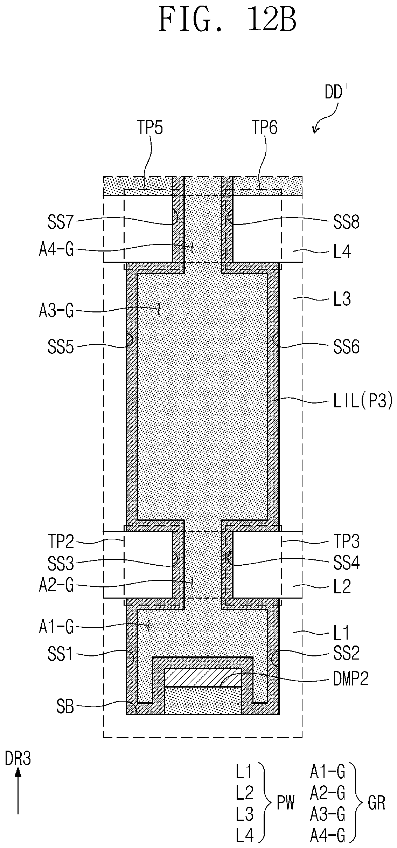

FIG. 12A is a cross-sectional view of an embodiment of the display module DM according to the disclosure. FIG. 12B is a cross-sectional view of the display module DM, where FIG. 12B illustrates a blowup of region DD' of FIG. 12A.

Referring to FIGS. 12A and 12B, the barrier wall PW according to this embodiment may include the first barrier wall layer L1, the second barrier wall layer L2, a third barrier wall layer L3, and a fourth barrier wall layer L4. The third barrier wall layer L3 may be disposed on the second barrier wall layer L2, and the fourth barrier wall layer L4 may be disposed on the third barrier wall layer L3.

The third barrier wall layer L3 may have conductivity. The third barrier wall layer L3 may include a conductive material. In an embodiment, the conductive material may include metal, metal nitride, transparent conductive oxide ("TCO"), or any combinations thereof, for example. In an embodiment, the metal may include gold (Au), silver (Ag), aluminum (Al), magnesium (Mg), lithium (Li), molybdenum (Mo), titanium (Ti), copper (Cu), or an alloy, for example. The metal nitride may include titanium nitride (TiN). The transparent conductive oxide may include indium tin oxide ("ITO"), indium zinc oxide ("IZO"), zinc oxide, indium oxide, indium gallium oxide, indium gallium zinc oxide ("IGZO"), or aluminum zinc oxide.

The fourth barrier wall layer L4 may include a material having an etch selectivity with respect to the third barrier wall layer L3. In an embodiment, the reactivity of the fourth barrier wall layer L4 with the chemical EC (refer to FIG. 15E) that will be described below may be lower the reactivity of the third barrier wall layer L3 with the chemical EC, for example. The third barrier wall layer L3 may be relatively recessed with respect to the emissive region PXA relative to the second barrier wall layer L2 or the fourth barrier wall layer L4. The fourth barrier wall layer L4 may define a fourth tip portion TP4 formed in the barrier wall PW.

The fourth tip portion TP4 of the barrier wall PW may be defined as a portion of the fourth barrier wall layer L4 that protrudes from the third barrier wall layer L3 toward the emissive region PXA. In this embodiment, the upper surface of the fourth barrier wall layer L4 may form the uppermost surface of the barrier wall PW and may define the upper surface of the fourth tip portion TP4 formed in the barrier wall PW.

In an embodiment, the fourth barrier wall layer L4 may include a conductive material. In an embodiment, the conductive material may include metal, metal nitride, transparent conductive oxide ("TCO"), or any combinations thereof, for example. In an embodiment, the metal may include gold (Au), silver (Ag), aluminum (Al), magnesium (Mg), lithium (Li), molybdenum (Mo), titanium (Ti), copper (Cu), or an alloy, for example. The metal nitride may include titanium nitride (TiN). The transparent conductive oxide may include indium tin oxide ("ITO"), indium zinc oxide ("IZO"), zinc oxide, indium oxide, indium gallium oxide, indium gallium zinc oxide ("IGZO"), or aluminum zinc oxide.

In an alternative embodiment of the disclosure, the fourth barrier wall layer L4 may include an insulating material. In an embodiment, the fourth barrier wall layer L4 may include an inorganic insulating material and may include a silicon-based compound, for example. In an embodiment, the fourth barrier wall layer L4 may include at least one of silicon oxide SiOₓ, silicon nitride SiNₓ, and silicon oxy nitride SiOₓN_{y}, for example.

The barrier wall opening OP-P defined in the barrier wall PW may include the first opening region A1, the second opening region A2, a third opening region A3, and a fourth opening region A4. The third barrier wall layer L3 may include a third inner surface S-L3 that defines the third opening region A3 of the barrier wall opening OP-P, and the fourth barrier wall layer L4 may include a fourth inner surface S-L4 that defines the fourth opening region A4 of the barrier wall opening OP-P.

When viewed from above the plane, the second inner surface S-L2 of the second barrier wall layer L2 may protrude relative to the first inner surface S-L1 of the first barrier wall layer L1 and the third inner surface S-L3 of the third barrier wall layer L3 and may be closer to the center of the anode AE than the first inner surface S-L1 of the first barrier wall layer L1 and the third inner surface S-L3 of the third barrier wall layer L3 are to the center of the anode AE. The third inner surface S-L3 of the third barrier wall layer L3 may be recessed inward relative to the second inner surface S-L2 of the second barrier wall layer L2 and the fourth inner surface S-L4 of the fourth barrier wall layer L4. When viewed from above the plane, the fourth inner surface S-L4 of the fourth barrier wall layer L4 that defines the fourth opening region A4 may protrude relative to the third inner surface S-L3 of the third barrier wall layer L3 that defines the third opening region A3 and may be closer to the center of the anode AE than the third inner surface S-L3 of the third barrier wall layer L3 is to the center of the anode AE. The width of the second opening region A2 may be narrower than the widths of the first opening region A1 and the third opening region A3. The width of the fourth opening region A4 may be narrower than the width of the third opening region A3.

The barrier wall opening OP-P and the groove GR may be defined in the barrier wall PW according to this embodiment. The groove GR in this embodiment may be defined to penetrate a portion of the barrier wall PW in the thickness direction.

The groove GR may include the first groove region A1-G defined by the first barrier wall layer L1, the second groove region A2-G defined by the second barrier wall layer L2, a third groove region A3-G defined by the third barrier wall layer L3, and a fourth groove region A4-G defined by the fourth barrier wall layer L4.

The third groove region A3-G may be defined to penetrate the third barrier wall layer L3 in the thickness direction. The third barrier wall layer L3 may include fifth and sixth peripheral inner surfaces SS5 and SS6 that define the third groove region A3-G. The fifth peripheral inner surface SS5 and the sixth peripheral inner surface SS6 may face each other, and the fifth peripheral inner surface SS5 may be disposed closer to the barrier wall opening OP-P than the sixth peripheral inner surface SS6 is to the barrier wall opening OP-P.

The fourth groove region A4-G may be defined to penetrate the fourth barrier wall layer L4 in the thickness direction. The fourth barrier wall layer L4 may include seventh and eighth peripheral inner surfaces SS7 and SS8 that define the fourth groove region A4-G. The seventh peripheral inner surface SS7 and the eighth peripheral inner surface SS8 may face each other, and the seventh peripheral inner surface SS7 may be disposed closer to the barrier wall opening OP-P than the eighth peripheral inner surface SS8 is to the barrier wall opening OP-P.

The fifth peripheral inner surface SS5 of the third barrier wall layer L3 may be recessed in the direction toward the emissive region PXA or the barrier wall opening OP-P relative to the third peripheral inner surface SS3 of the second barrier wall layer L2 and the seventh peripheral inner surface SS7 of the fourth barrier wall layer L4. That is, the third peripheral inner surface SS3 of the second barrier wall layer L2 and the seventh peripheral inner surface SS7 of the fourth barrier wall layer L4 may protrude in the direction away from the emissive region PXA or the barrier wall opening OP-P relative to the fifth peripheral inner surface SS5 of the third barrier wall layer L3.

The sixth peripheral inner surface SS6 of the third barrier wall layer L3 may be recessed in the direction away from the emissive region PXA or the barrier wall opening OP-P relative to the fourth peripheral inner surface SS4 of the second barrier wall layer L2 and the eighth peripheral inner surface SS8 of the fourth barrier wall layer L4. That is, the fourth peripheral inner surface SS4 of the second barrier wall layer L2 and the eighth peripheral inner surface SS8 of the fourth barrier wall layer L4 may protrude in the direction toward from the emissive region PXA or the barrier wall opening OP-P relative to the sixth peripheral inner surface SS6 of the third barrier wall layer L3.

In this embodiment, the barrier wall PW may include first to sixth tip portions TP1, TP2, TP3, TP4, TP5, and TP6. The first and fourth tip portions TP1 and TP4 may be defined at portions adjacent to the barrier wall opening OP-P.

The second, third, fifth, and sixth tip portions TP2, TP3, TP5, and TP6 may be defined at portions adjacent to the groove GR. The fifth tip portion TP5 may be a portion defined by the seventh peripheral inner surface SS7 that protrudes relative to the fifth peripheral inner surface SS5. The sixth tip portion TP6 may be a portion defined by the eighth peripheral inner surface SS8 that protrudes relative to the sixth peripheral inner surface SS6.

In this embodiment, the six tip portions TP1, TP2, TP3, TP4, TP5, and TP6 may be defined between the spacing region SPP and the light-emitting element ED, and thus a moisture permeation path along which moisture is introduced into the light-emitting element ED may be lengthened. Accordingly, infiltration of moisture into the light-emitting element ED may be more stably blocked, and the light-emitting element ED with improved process reliability and reduced defects may be provided.

In this embodiment, the lower encapsulation pattern LIL may include the inner portion and the outer portion P4, and the inner portion may include the first portion P1, the second portion P2, and the third portion P3. The first portion P1 according to this embodiment may cover the first inner surface S-L1 defining the first opening region A1, the second inner surface S-L2 defining the second opening region A2, the third inner surface S-L3 defining the third opening region A3, and the fourth inner surface S-L4 defining the fourth opening region A4. The third portion P3 according to this embodiment may cover first and second peripheral inner surfaces SS1 and SS2 and the peripheral bottom surface SB of the first barrier wall layer L1 that define the first groove region A1-G of the groove GR, the third and fourth peripheral inner surfaces SS3 and SS4 of the second barrier wall layer L2 that define the second groove region A2-G, the fifth and sixth peripheral inner surfaces SS5 and SS6 of the third barrier wall layer L3 that define the third groove region A3-G, and the seventh and eighth peripheral inner surfaces SS7 and SS8 of the fourth barrier wall layer L4 that define the fourth groove region A4-G.

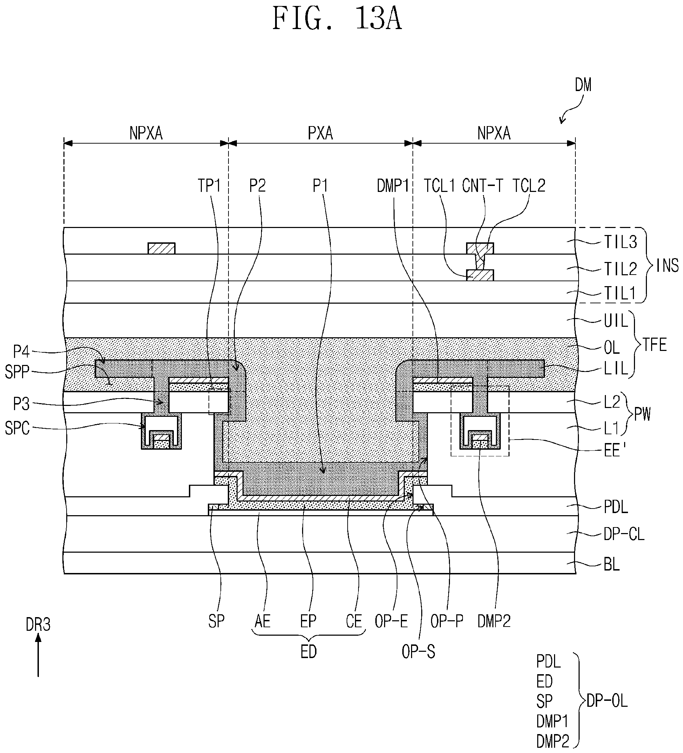

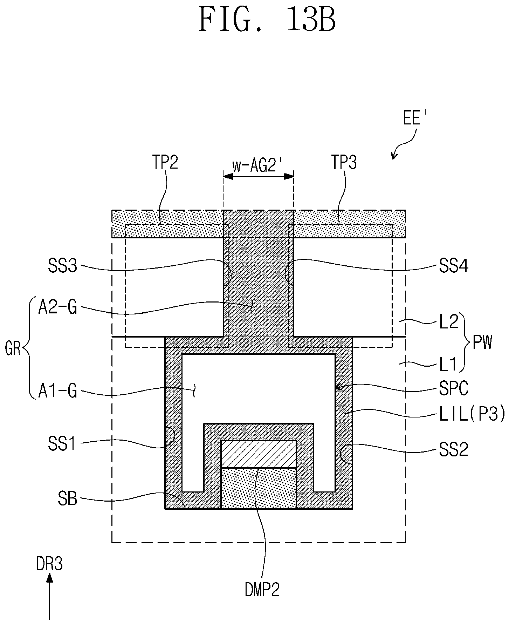

FIG. 13A is a cross-sectional view of an embodiment of the display module DM according to the disclosure. FIG. 13B is a cross-sectional view of the display module DM, where FIG. 13B illustrates a blowup of region EE' of FIG. 13A.

Referring to FIGS. 13A and 13B, the barrier wall opening OP-P and the groove GR may be defined in the barrier wall PW according to this embodiment. The groove GR in this embodiment may be defined or formed by removing a portion of the barrier wall PW in the thickness direction. The groove GR in this embodiment may be defined by a recess in, or penetration into, a portion of the barrier wall PW in the thickness direction. The description made with reference to FIGS. 8A and 8B may be identically applied to the groove GR in this embodiment, and detailed description will hereinafter be omitted.

In this embodiment, the lower encapsulation pattern LIL may include the inner portion and the outer portion P4, and the inner portion may include the first portion P1, the second portion P2, and the third portion P3.

The third portion P3 according to this embodiment may all overlap the second groove region A2-G of the groove GR. The third portion P3 according to this embodiment may extend from the second portion P2 and may be disposed in the groove GR. The third portion P3 may cover the second dummy patterns DMP2 in the groove GR. In addition, the third portion P3 may cover the first and second peripheral inner surfaces SS1 and SS2 of the first barrier wall layer L1 that define the first groove region A1-G. In this embodiment, the third portion P3 may fill the second groove region A2-G of the groove GR. In a deposition process for forming the lower encapsulation patter LIL, a deposition material may be accumulated in the second groove region A2-G, and a portion of the lower encapsulation pattern LIL may seal the second groove region A2-G. Accordingly, a space SPC may be defined in the first groove region A1-G.

The outer portion P4 according to this embodiment may extend from the second portion P2 and may be disposed on the barrier wall PW. The outer portion P4 may be spaced apart from the barrier wall PW, more specifically, the upper surface of the second barrier wall layer L2 at a predetermined interval. The spacing region SPP may be defined between the outer portion P4 and the barrier wall PW.

The width w-AG2' of the second groove region A2-G may be less than several micrometers, e.g., less than 1 micrometer, but is not particularly limited thereto. In an embodiment, as long as the second groove region A2-G is capable of being filled with a portion of the lower encapsulation pattern LIL, the width w-AG2' of the second groove region A2-G is not particularly limited, for example.

Air may be accommodated in the space SPC. The dielectric constant of air may be 1.00059. In an alternative embodiment, the space SPC may be in a vacuum state. The dielectric constant of vacuum may be 1. The space SPC may be also referred to as a cavity. According to this embodiment, the space SPC sealed by the lower encapsulation pattern LIL may be provided, and a portion in which the lower encapsulation film OL is not disposed may be provided through the space SPC. Accordingly, the permittivity between the input sensor INS and the display element layer DP-OL, that is, the permittivity of the thin film encapsulation layer TFE may be decreased. Noise caused by coupling between the input sensor INS and the display element layer DP-OL (e.g., between the input sensor INS and the cathode CE) may be reduced. Thus, a signal to noise ratio ("SNR") may be reduced, and the display device DD (refer to FIGs. 1A and 1B) having the input sensor INS with improved sensitivity may be provided.

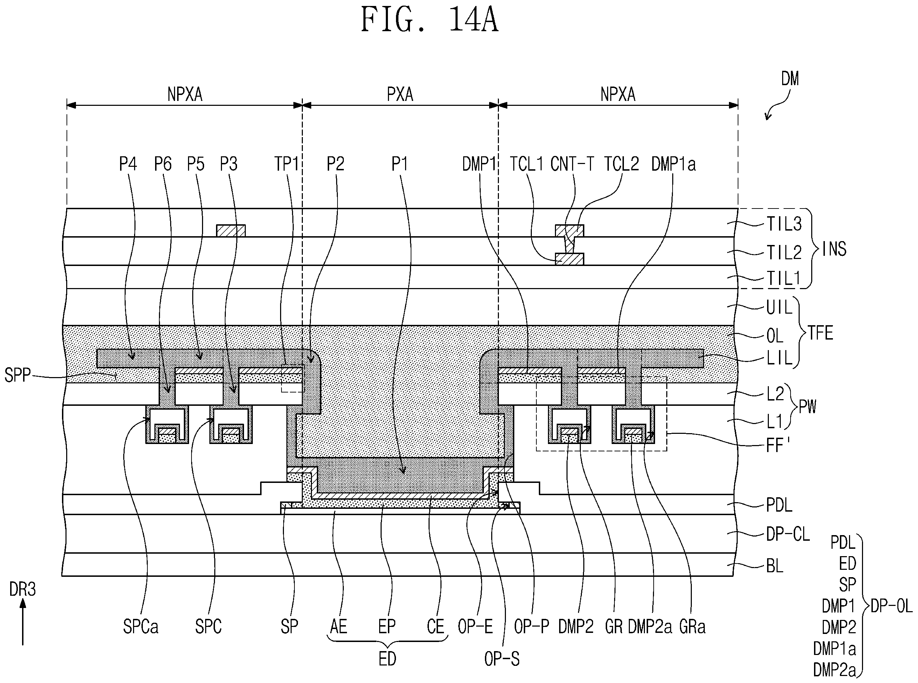

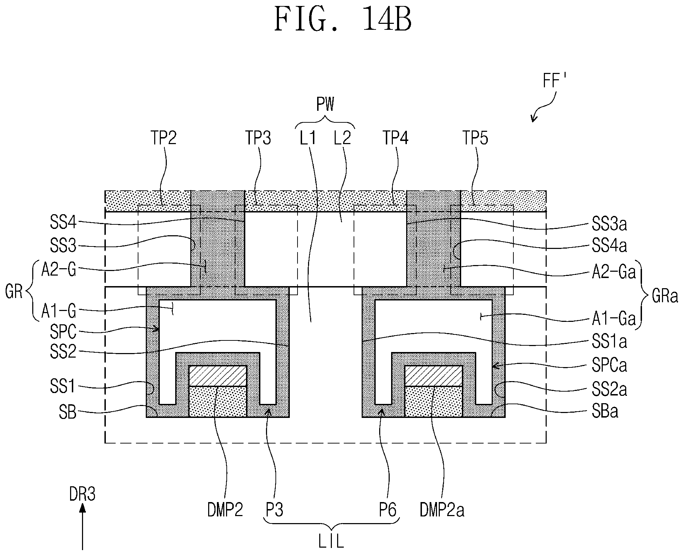

FIG. 14A is a cross-sectional view of an embodiment of the display module DM according to the disclosure. FIG. 14B is a cross-sectional view of the display module DM, where FIG. 14B illustrates a blowup of region FF' of FIG. 14A.

Referring to FIGS. 14A and 14B, the barrier wall opening OP-P, the groove GR, and the additional groove GRa may be defined in the barrier wall PW according to this embodiment. The groove GR and the additional groove GRa in this embodiment may be defined or formed by removing portions of the barrier wall PW in the thickness direction. The description made with reference to FIGS. 8A and 8B may be identically applied to the groove GR in this embodiment, and the description made with reference to FIGS. 11A to 11C may be identically applied to the additional groove GRa in this embodiment. Detailed description will hereinafter be omitted.

In this embodiment, the lower encapsulation pattern LIL may include the inner portion and the outer portion P4, and the inner portion may include the first portion P1, the second portion P2, the third portion P3, the first additional portion P5, and the second additional portion P6. The third portion P3 according to this embodiment may fill the second groove region A2-G of the groove GR. Accordingly, a space SPC may be defined in the first groove region A1-G. The description made with reference to FIGS. 13A and 13B may be identically applied to the third portion P3, and detailed description will hereinafter be omitted.

The first additional portion P5 according to this embodiment may cover the first additional dummy patterns DMP1a. The first additional portion P5 may extend from the second portion P2 and may be disposed on the barrier wall PW. The first additional portion P5 may all overlap the second additional groove region A2-Ga of the additional groove GRa.

The second additional portion P6 according to this embodiment may extend from the first additional portion P5 and may be disposed in the additional groove GRa. The second additional portion P6 may cover the second additional dummy patterns DMP2a in the additional groove GRa. In addition, the second additional portion P6 may cover the first and second additional inner surfaces SS1a and SS2a of the first barrier wall layer L1 that define the first additional groove region A1-Ga. In this embodiment, the second additional portion P6 may fill the second additional groove region A2-Ga of the additional groove GRa. In a deposition process for forming the lower encapsulation patter LIL, a deposition material may be accumulated in the second additional groove region A2-Ga, and a portion of the lower encapsulation pattern LIL may seal the second additional groove region A2-Ga. Accordingly, an additional space SPCa may be defined in the first additional groove region A1-Ga.

The outer portion P4 according to this embodiment may extend from the first additional portion P5 and may be disposed on the barrier wall PW. The outer portion P4 may be spaced apart from the barrier wall PW, more specifically, the upper surface of the second barrier wall layer L2 at a predetermined interval. The spacing region SPP may be defined between the outer portion P4 and the barrier wall PW.

The width of the second additional groove region A2-Ga may be less than several micrometers, e.g., less than 1 micrometer, but is not particularly limited thereto. In an embodiment, as long as the second additional groove region A2-Ga is capable of being filled with a portion of the lower encapsulation pattern LIL, the width of the second additional groove region A2-Ga is not particularly limited, for example.

Air may be accommodated in the additional space SPCa. In an alternative embodiment, the additional space SPCa may be in a vacuum state. The additional space SPCa may be also referred to as an additional cavity. In other words, the plurality of spaces SPC and SPCa including air or in a vacuum state may be provided around the one barrier wall opening OP-P. According to this embodiment, the plurality of spaces SPC and SPCa sealed by the lower encapsulation pattern LIL may be provided, and portions in which the organic encapsulation film OL is not disposed may be provided through the plurality of spaces SPC and SPCa. Accordingly, the permittivity between the input sensor INS and the display element layer DP-OL may be decreased, and noise caused by coupling between the input sensor INS and the display element layer DP-OL may be reduced. Thus, an SNR may be reduced, and the display device DD (refer to FIGs. 1A and 1B) having the input sensor INS with improved sensitivity may be provided.

Hereinafter, a display panel manufacturing method (i.e. a manufacturing method for a display panel or a method for manufacturing a display panel) in an embodiment will be described with reference to the accompanying drawings. In describing the display panel manufacturing method in the embodiment, repetitive descriptions identical to the descriptions of the display panel in the above-described embodiments will be omitted.

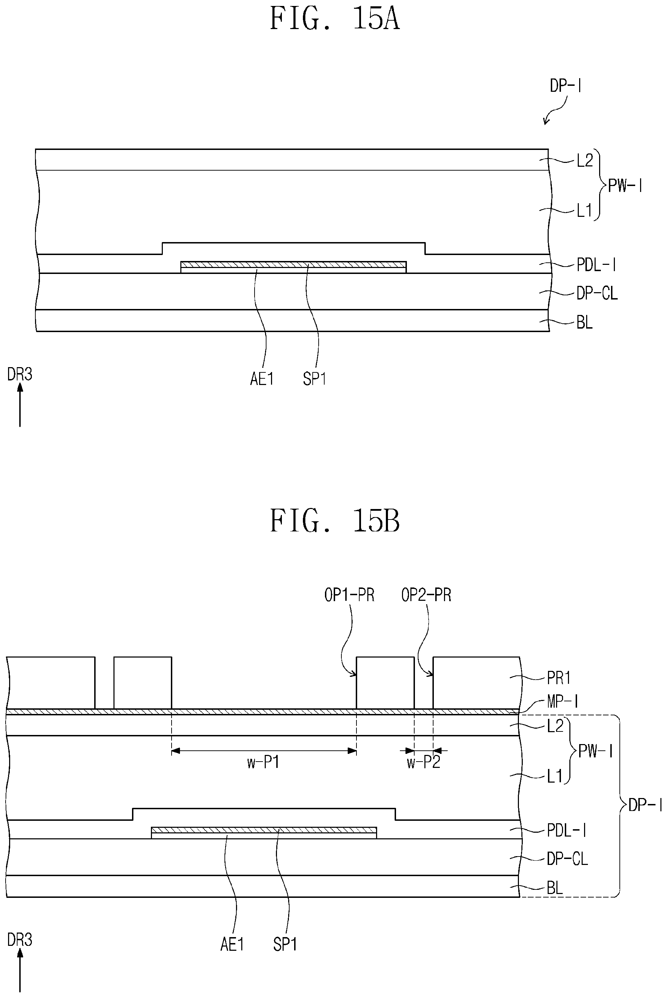

FIGS. 15A to 15M are cross-sectional views illustrating an embodiment of some of the operations of the display panel manufacturing method according to the disclosure.

The display panel manufacturing method according to the disclosure may include an operation of etching a preliminary barrier wall to form a barrier wall in which a barrier wall opening and a groove spaced apart from the barrier wall opening are defined, an operation of forming a light-emitting element in the barrier wall opening, an operation of forming a lower encapsulation pattern including an inner portion disposed in the barrier wall opening and the groove and an outer portion disposed at the outside from the inner portion; and an operation of defining a spacing region between the outer portion of the lower encapsulation pattern and the barrier wall.

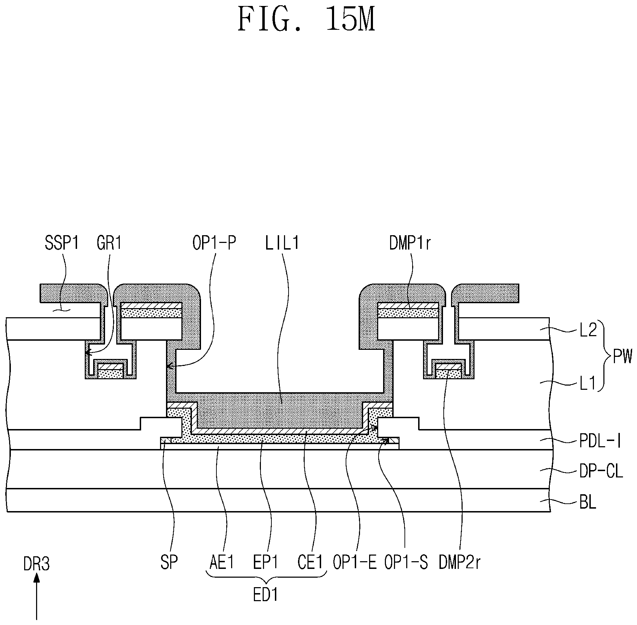

Hereinafter, a method of forming one light-emitting element ED1 (refer to FIG. 15M) and one lower encapsulation pattern LII,1 (refer to FIG. 15M) covering the light-emitting element ED1 will be described with reference to FIGS. 15A to 15M.

In FIGS. 15A to 15M, a method of forming the first light-emitting element ED1 (refer to FIG. 15M) among the first to third light-emitting elements ED1, ED2, and ED3 of FIG. 9A and the first lower encapsulation pattern LIL1 (refer to FIG. 15M) among the first to third lower encapsulation patterns LIL1, LIL2, and LIL3 of FIG. 9A is illustrated as an embodiment. The method to be described below with reference to FIGS. 15A to 15M may be similarly applied to an operation of forming the second light-emitting element ED2 (refer to FIG. 9A) and the second lower encapsulation pattern LIL2 (refer to FIG. 9A) and an operation of forming the third light-emitting element ED3 (refer to FIG. 9A) and the third lower encapsulation pattern LIL3 (refer to FIG. 9A).

Referring to FIG. 15A, the display panel manufacturing method according to this embodiment may include an operation of providing a preliminary display panel DP-I. The preliminary display panel DP-I provided in this embodiment may include the base layer BL, the circuit element layer DP-CL, the first anode AE1, the first sacrificial pattern SP1, a preliminary pixel defining layer PDL-I, and a preliminary barrier wall PW-I.

The circuit element layer DP-CL may be formed through a conventional circuit element manufacturing process of forming an insulating layer, a semiconductor layer, and a conductive layer by coating, deposition, or the like and forming a semiconductor pattern, a conductive pattern, and a signal line by selectively making the insulating layer, the semiconductor layer, and the conductive layer subject to patterning by photolithography and etching processes.

The first anode AE1 and the first sacrificial pattern SP1 may be formed by the same patterning process. The preliminary pixel defining layer PDL-I may cover both the first anode AE1 and the first sacrificial pattern SP1.

The preliminary barrier wall PW-I may include the first barrier wall layer L1 disposed on the preliminary pixel defining layer PDL-I and the second barrier wall layer L2 disposed on the first barrier wall layer L1. Each of the first and second barrier wall layers L1 and L2 may be formed through a deposition process.

Referring to FIG. 15B, the display panel manufacturing method according to this embodiment may include an operation of forming a preliminary mask pattern MP-I on the preliminary display panel DP-I and an operation of forming a first photoresist pattern PR1 on the preliminary mask pattern MP-I.

The preliminary mask pattern MP-I may be formed through a deposition process. In an embodiment, the preliminary mask pattern MP-I may be formed through a sputtering process, e.g., but is not limited thereto. The preliminary mask pattern MP-I may include a conductive material. The preliminary mask pattern MP-I may include transparent conductive oxide. In an embodiment, the preliminary mask pattern MP-I may include the same material as that of the first sacrificial pattern SP1.

The first photoresist pattern PR1 may be formed by forming a photoresist layer on the preliminary mask pattern MP-I and thereafter making the photoresist layer subject to patterning using a photo mask. Through the patterning process, a first photo opening OP1-PR overlapping the first anode AE1 and a second photo opening OP2-PR surrounding the first photo opening OP1-PR may be defined in the first photoresist pattern PR1. The first barrier wall opening OP1-P (refer to FIG. 15E) of the barrier wall PW (refer to FIG. 15E) may be defined to correspond to the first photo opening OP1-PR, and the first groove GR1 (refer to FIG. 15E) of the barrier wall PW (refer to FIG. 15E) may be defined to correspond to the second photo opening OP2-PR.

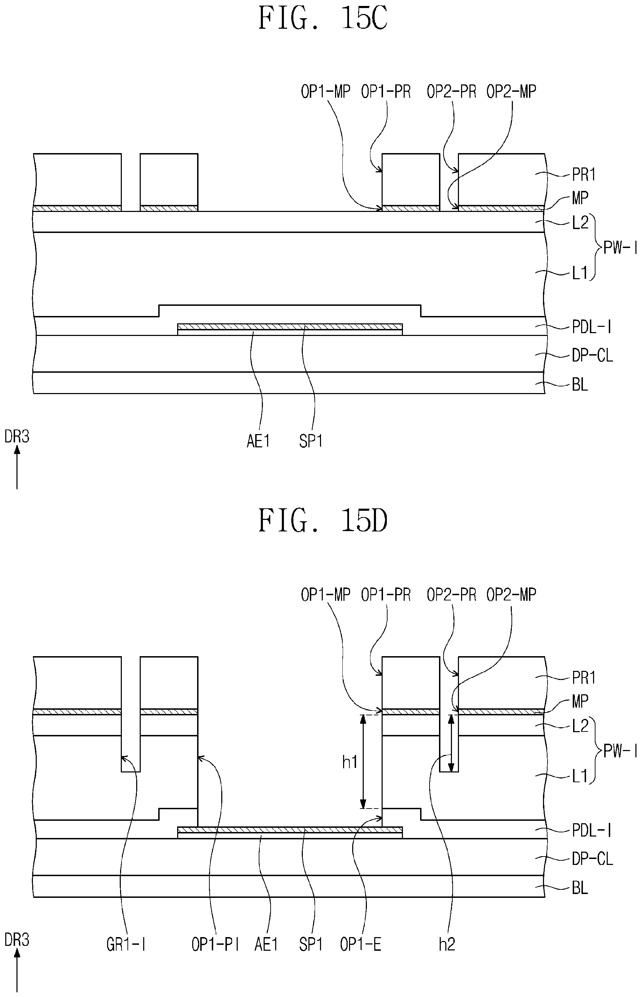

Referring to FIGS. 15B and 15C, the display panel manufacturing method according to this embodiment may include an operation of making the preliminary mask pattern MP-I subject to patterning to form a mask pattern MP.

The operation of making the preliminary mask pattern MP-I subj ect to patterning may be performed through a process of etching the preliminary mask pattern MP-I. In the process of etching the preliminary mask pattern MP-I, portions of the preliminary mask pattern MP-I exposed from the first photoresist pattern PR1 may be removed by wet etching the preliminary mask pattern MP-I using the first photoresist pattern PR1 as a mask. The mask pattern MP in which a first pattern opening OP1-MP corresponding to the first photo opening OP1-PR and a second pattern opening OP2-MP corresponding to the second photo opening OP2-PR are defined may be formed. In an embodiment, the width w-P2 of the second photo opening OP2-PR may be narrower than the width w-P1 of the first photo opening OP1-PR.

Referring to FIGS. 15D and 15E, the display panel manufacturing method according to this embodiment may include an operation of forming the barrier wall PW from the preliminary barrier wall PW-I. The operation of forming the barrier wall PW may include an operation of etching the first barrier wall layer L1 and the second barrier wall layer L2 of the preliminary barrier wall PW-I. In this embodiment, the operation of etching the first barrier wall layer L1 and the second barrier wall layer L2 of the preliminary barrier wall PW-I may be performed by two etching processes. The operation of etching the first and second barrier wall layers L1 and L2 of the preliminary barrier wall PW-I may include a first etching operation and a second etching operation.

First, as illustrated in FIG. 15D, in the first etching operation, a first preliminary barrier wall opening OP1-PI and a first initial groove GR1-I may be defined in the preliminary barrier wall PW-I using the first photoresist pattern PR1 and the mask pattern MP as a mask. The first preliminary barrier wall opening OP1-PI may be defined to correspond to the first photo opening OP1-PR, and the first initial groove GR1-I may be defined to correspond to the second photo opening OP2-PR. The first etching operation may be performed by a dry etch process.

The first etching operation in this embodiment may be performed in an etching environment in which the etch selectivity between the first and second barrier wall layers L1 and L2 is substantially the same. Accordingly, inner surfaces of the first and second barrier wall layers L1 and L2 that define the first preliminary barrier wall opening OP1-PI may be substantially aligned with each other. In addition, inner surfaces of the first and second barrier wall layers L1 and L2 that define the first initial groove GR1-I may be substantially aligned with each other.

In an etching process, an etch rate may be decreased as the width of a pattern to be etched is decreased. In an embodiment, since the width w-P2 (refer to FIG. 15B) of the second photo opening OP2-PR is smaller than the width w-P1 (refer to FIG. 15B) of the first photo opening OP1-PR, the height h1 (or the depth) of the first initial groove GR1-I may be smaller than the height h2 of the first preliminary barrier wall opening OP1-PI. Accordingly, the first preliminary barrier wall opening OP1-PI may be defined to penetrate the barrier wall PW in the thickness direction, and the first initial groove GR1-I may be defined of formed by removing only a portion of the barrier wall PW in the thickness direction. However, the disclosure is not limited thereto, and depending on etch time or the widths of the photo openings, the first initial groove GR1-I may also be defined in the form of an opening that penetrates the barrier wall PW in the thickness direction.

In an embodiment, as illustrated in FIG. 15D, the preliminary pixel defining layer PDL-I may also be subjected to patterning together in the first etching operation. Accordingly, the pixel defining layer PDL (e.g. refer to FIG. 8A) having the first light-emitting opening OP1-E formed therein may be formed from the preliminary pixel defining layer PDL-I.

As illustrated in FIG. 15E, in the second etching operation, the first barrier wall opening OP1-P and the first groove GR1 may be formed from the first preliminary barrier wall opening OP1-PI and the first initial groove GR1-I, respectively, using the first photoresist pattern PR1 and the mask pattern MP as a mask. The second etching operation may be performed by a wet etch process. Through the second etching operation, the barrier wall PW may be formed from the preliminary barrier wall PW-I. In this specification, the second etching operation may be also referred to as an "undercut etching process".

The second etching operation may include an operation of etching the first barrier wall layer L1 by providing the chemical EC to the preliminary barrier wall PW-I. In this specification, the chemical EC may refer to a processing liquid used for an etching process in the display panel manufacturing process.

The wet etch process in this embodiment may be performed in an environment in which the etch selectivity between the first barrier wall layer L1 and the second barrier wall layer L2 is high. In the undercut etching process, the etch rate of the first barrier wall layer L1 may be higher than the etch rate of the second barrier wall layer L2. The degree to which the first barrier wall layer L1 is etched may be higher than the degree to which the second barrier wall layer L2 is etched. Accordingly, in the operation of secondly etching the preliminary barrier wall PW-I, only the first barrier wall layer L1 may be etched, and the second barrier wall layer L2 may not be etched or may not be substantially etched.

Through the second etching operation, the inner surface of the barrier wall PW that defines the first barrier wall opening OP1-P may have an undercut shape, and the inner surface of the barrier wall PW that defines the first groove GR1 may have an undercut shape. The first to third tip portions TP1, TP2, and TP3 may be formed in the barrier wall PW.

An etching method of forming the barrier wall PW from the preliminary barrier wall PW-I is not limited to a particular embodiment, and various etching methods may be used depending on the materials of the first and second barrier wall layers L1 and L2.

Referring to FIGS. 15E and 15F, the display panel manufacturing method according to this embodiment may include an operation of removing the first photoresist pattern PR1.

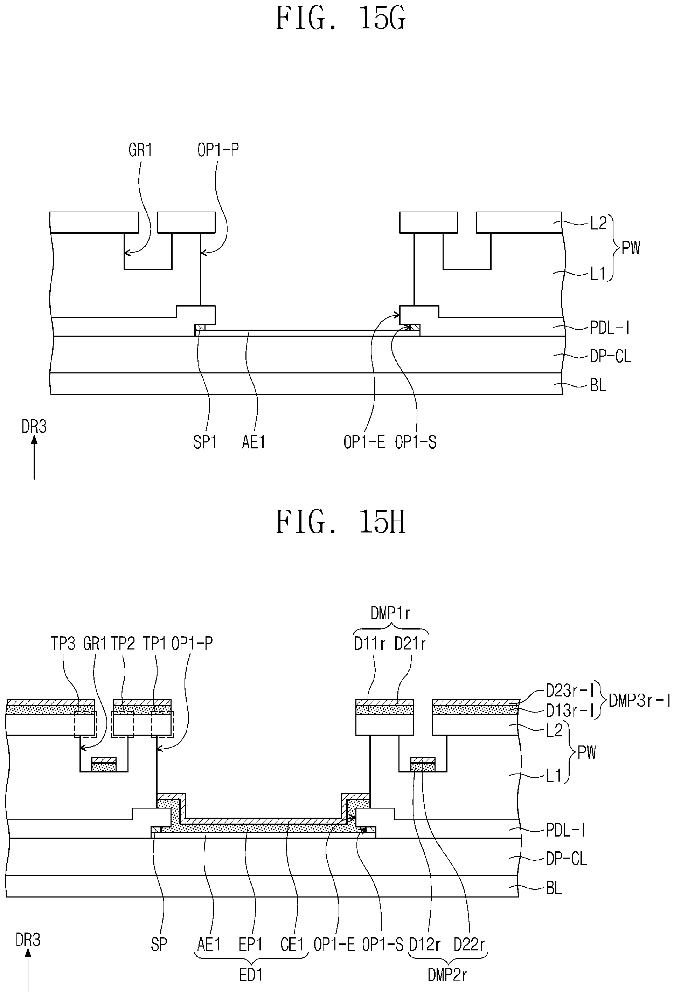

Referring to FIGS. 15F and 15G, the display panel manufacturing method according to this embodiment may include an operation of etching the first sacrificial pattern SP1. The operation of etching the first sacrificial pattern SP1 may be performed by a wet etch process. The first sacrificial opening OP1-S overlapping the first light-emitting opening OP1-E may be defined in the first sacrificial pattern SP1.

The etching process of the first sacrificial pattern SP1 may be performed in an environment in which the etch selectivity between the first sacrificial pattern SP1 and the first anode AE1 is large. Accordingly, the first anode AE1 may be prevented from being etched together. That is, the first sacrificial pattern SP1 having a higher etch rate than the first anode AE1 may be disposed between the pixel defining layer PDL and the first anode AE1, and thus the first anode AE1 may be prevented from being etched and damaged together during the etching process.

The mask pattern MP may be etched together in the etching process of the first sacrificial pattern SP1. That is, the display panel manufacturing method according to this embodiment may further include an operation of removing the mask pattern MP. The operation of removing the mask pattern MP may be simultaneously performed with the etching process of the first sacrificial pattern SP1.

Referring to FIG. 15H, the display panel manufacturing method according to this embodiment may include an operation of forming the first light-emitting element ED1. The operation of forming the first light-emitting element ED1 may include an operation of forming the first emission pattern EP1 and an operation of forming the first cathode CE1.

The operation of forming the first emission pattern EP1 and the operation of forming the first cathode CE1 may be performed by a deposition process. In an embodiment, the operation of forming the first emission pattern EP1 may be performed by a thermal evaporation process, and the operation of forming the first cathode CE1 may be performed by a chemical vapor deposition ("CVD") process. However, the disclosure is not limited thereto.

In the operation of forming the first emission pattern EP1, the first emission pattern EP1 may be separated by the first tip portion TP1 formed in the barrier wall PW and may be disposed in the first light-emitting opening OP1-E and the first barrier wall opening OP1-P.

In the operation of forming the first emission pattern EP1, the first-first layer dummy pattern D11r, the first-second layer dummy pattern D12r, and a first-third layer preliminary dummy pattern D13r-I that are spaced apart from the first emission pattern EP1 may be formed together. The first-first layer dummy pattern D11r may be disposed on the barrier wall PW and may be disposed between the first barrier wall opening OP1-P and the first groove GR1 when viewed from above the plane. The first-second layer dummy pattern D12r may be disposed in the first groove GR1. The first-third layer preliminary dummy pattern D13r-I may be disposed on the barrier wall PW outward of the first groove GR1. The first emission pattern EP 1 and the first-first layer dummy pattern D11r may be separated by the first tip portion TP1, the first-first layer dummy pattern D11r and the first-second layer dummy pattern D12r may be separated by the second tip portion TP2, and the first-second layer dummy pattern D12r and the first-third layer preliminary dummy pattern D13r-I may be separated by the third tip portion TP3.

In the operation of forming the first cathode CE1, the first cathode CE1 may be separated by the first tip portion TP1 formed in the barrier wall PW and may be disposed in the first light-emitting opening OP1-E and the first barrier wall opening OP1-P. The first cathode CE1 may be provided at a higher incident angle than the first emission pattern EP1. The first cathode CE1 may contact the first inner surface S-L1 (refer to FIG. 7) of the first barrier wall layer L1 that defines the first opening region A1 (refer to FIG. 15E) of the first barrier wall opening OP1-P and may be electrically connected with the barrier wall PW.

The first anode AE1, the first emission pattern EP1, and the first cathode CE1 may constitute the first light-emitting element ED1.

In the operation of forming the first cathode CE1, the second-first layer dummy pattern D21r, the second-second layer dummy pattern D22r, and a second-third layer preliminary dummy pattern D23r-I that are spaced apart from the first cathode CE1 may be formed together. The second-first layer dummy pattern D21r may be disposed on the barrier wall PW and may be disposed between the first barrier wall opening OP1-P and the first groove GR1 when viewed from above the plane. The second-second layer dummy pattern D22r may be disposed in the first groove GR1. The second-third layer preliminary dummy pattern D23r-I may be disposed on the barrier wall PW outward of the first groove GR1. The first cathode CE1 and the second-first layer dummy pattern D21r may be separated by the first tip portion TP1, the second-first layer dummy pattern D21r and the second-second layer dummy pattern D22r may be separated by the second tip portion TP2, and the second-second layer dummy pattern D22r and the second-third layer preliminary dummy pattern D23r-I may be separated by the third tip portion TP3.

The first-first layer dummy pattern D11r and the second-first layer dummy pattern D21r may form the first-first dummy patterns DMP1r. The first-second layer dummy pattern D12r and the second-second layer dummy pattern D22r may form the second-first dummy patterns DMP2r. The first-third layer preliminary dummy pattern D13r-I and the second-third layer preliminary dummy pattern D23r-I may form third-first preliminary dummy patterns DMP3r-I.

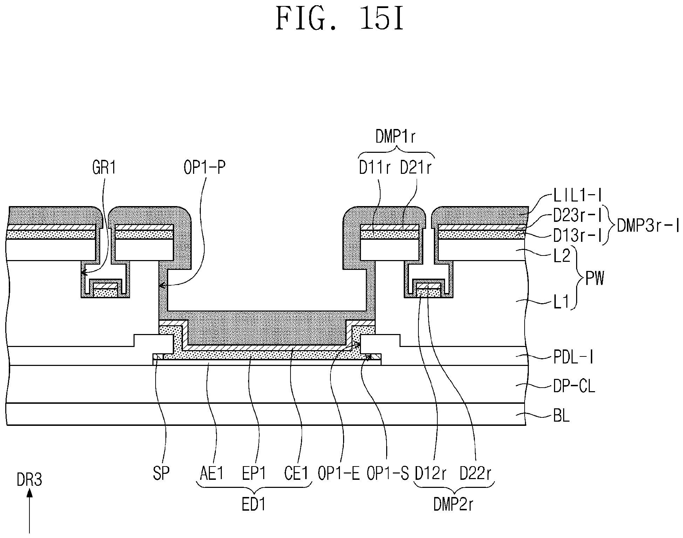

Referring to FIG. 15I, the display panel manufacturing method according to this embodiment may include an operation of forming a first preliminary lower encapsulation pattern LIL1-I.

The first preliminary lower encapsulation pattern LIL1-I may be formed through a deposition process. In an embodiment, the first preliminary lower encapsulation pattern LIL1-I may include an inorganic material, e.g., silicon nitride (SiNₓ). In an embodiment, the first preliminary lower encapsulation pattern LIL1-I may be formed through a CVD process, for example.

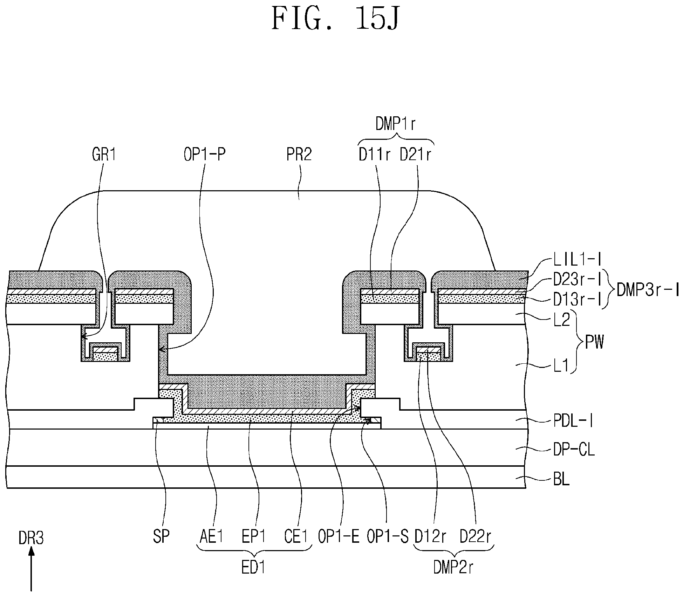

Referring to FIG. 15J, the display panel manufacturing method according to this embodiment may include an operation of forming a second photoresist pattern PR2. The second photoresist pattern PR2 may be formed on the first preliminary lower encapsulation pattern LIL1-I.

In the operation of forming the second photoresist pattern PR2, the second photoresist pattern PR2 may be formed by forming a preliminary photoresist layer and making the preliminary photoresist layer subject to patterning using a photo mask. Through the patterning process, the second photoresist pattern PR2 may be formed in the form of a pattern overlapping the first anode AE1 and the first light-emitting opening OP1-E. In addition, the second photoresist pattern PR2 may overlap the first barrier wall opening OP1-P and the first groove GR1. In this case, the second photoresist pattern PR2 may be formed so as not to overlap the second and third anodes AE2 and AE3 (refer to FIG. 9A). In addition, the second photoresist pattern PR2 may be formed to overlap the first-first dummy patterns DMP1r, the second-first dummy patterns DMP2r, and a portion of the third-first preliminary dummy patterns DMP3r-I.

Referring to FIGS. 15J and 15K, the display panel manufacturing method according to this embodiment may include an operation of making the first preliminary lower encapsulation pattern LIL1-I subject to patterning to form the first lower encapsulation pattern LIL1.

The operation of making the first preliminary lower encapsulation pattern LIL1-I subject to patterning may include an operation of etching the first preliminary lower encapsulation pattern LII,1-I. The operation of etching the first preliminary lower encapsulation pattern LIL1-I may be performed by a dry etch process using the second photoresist pattern PR2 as a mask.

Portions of the first preliminary lower encapsulation pattern LIL1-I that overlap the remaining anodes other than the corresponding anode may be removed. Specifically, when the first lower encapsulation pattern LIL1 covering the first light-emitting element ED1 is formed, the first preliminary lower encapsulation pattern LIL1-I may be considered to correspond to the first anode AE1 included in the first light-emitting element ED1 and may be subjected to patterning such that portions of the first preliminary lower encapsulation pattern LIL1-I that overlap the second and third anodes AE2 and AE3 (refer to FIG. 9A) are removed. The formed first lower encapsulation pattern LII,1 may include a portion disposed in the first barrier wall opening OP1-P and a portion disposed in the first groove GR1. A portion of the third-first preliminary dummy patterns DMP3r-I may be exposed from the first lower encapsulation pattern LII,1.

Referring to FIGS. 15K and 15I, the display panel manufacturing method according to this embodiment may include an operation of etching the third-first preliminary dummy patterns DMP3r-I.

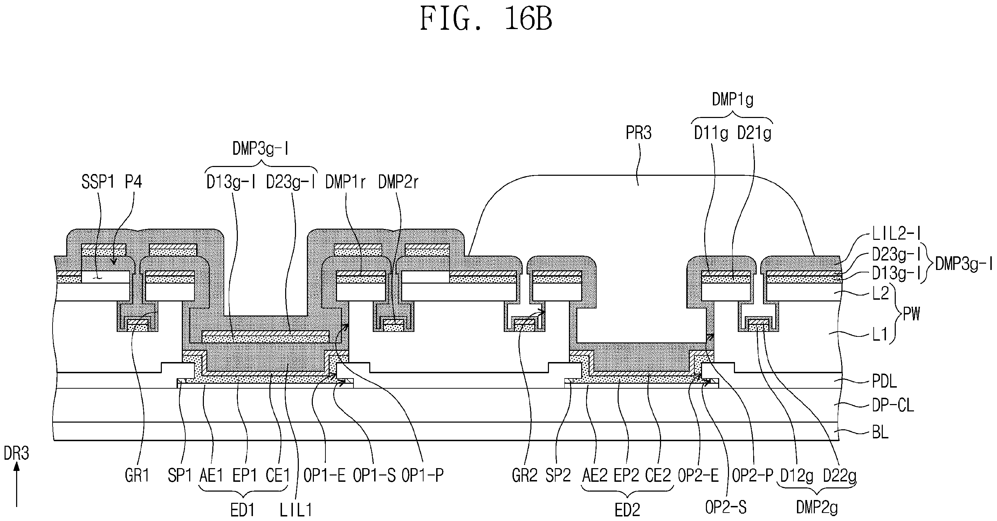

The operation of etching the third-first preliminary dummy patterns DMP3r-I may be performed by a wet etch process. The third-first preliminary dummy patterns DMP3r-I may be etched by providing a chemical EC-1 to the third-first preliminary dummy patterns DMP3r-I. In the operation of etching the third-first preliminary dummy patterns DMP3r-I, the second photoresist pattern PR2 may be used as a mask. In the operation of etching the third-first preliminary dummy patterns DMP3r-I, the third-first preliminary dummy patterns DMP3r-I may all be removed. That is, not only a portion of the third-first preliminary dummy patterns DMP3r-I exposed from the first lower encapsulation pattern LIL1 but also a portion covered by the first lower encapsulation pattern LIL1 may be removed together. That is, the chemical EC-1 may be introduced between the outer portion of the first lower encapsulation pattern LIL1 and the barrier wall PW, and the third-first preliminary dummy patterns DMP3r-I between the outer portion of the first lower encapsulation pattern LIL1 and the barrier wall PW may be etched. Accordingly, the outer portion of the first lower encapsulation pattern LIL1 may be spaced apart from the barrier wall PW to form the first spacing region SSP1. That is, the operation of etching the third-first preliminary dummy patterns DMP3r-I may be also referred to as an operation of defining the spacing region between the outer portion P4 (e.g. refer to FIG. 16B) of the first lower encapsulation pattern LIL1 and the barrier wall PW.

According to this embodiment, by performing the etching process of the third-first preliminary dummy patterns DMP3r-I through a wet etch process, contamination of a process chamber may be prevented or reduced. In contrast, when the etching process of the third-first preliminary dummy patterns DMP3r-I is performed through a dry etch process, the process chamber may be contaminated, and therefore a display panel damaged by contaminants may be manufactured in the display panel manufacturing process.

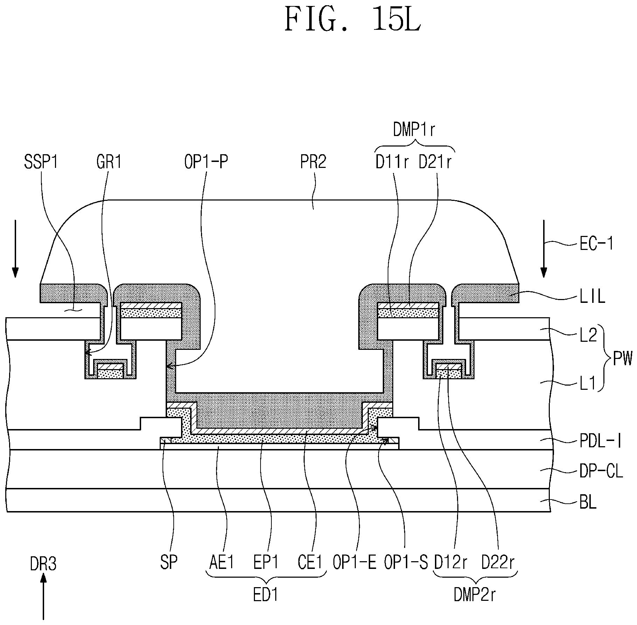

Referring to FIGS. 15L and 15M, the display panel manufacturing method according to this embodiment may include an operation of removing the second photoresist pattern PR2. Accordingly, the operation of manufacturing the first light-emitting element ED1 and the first lower encapsulation pattern LIL1 may be completed.

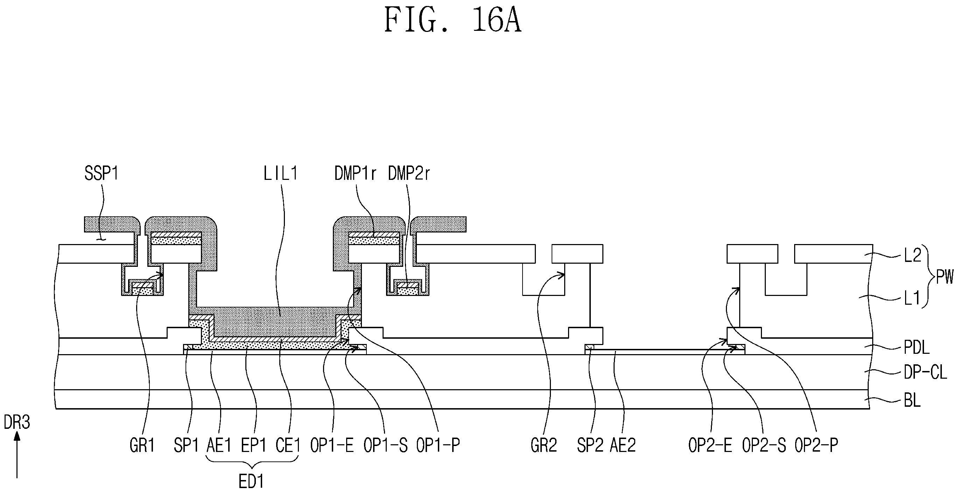

FIGS. 16A to 16E are cross-sectional views illustrating an embodiment of some of the operations of the display panel manufacturing method according to the disclosure. In describing FIGS. 16A to 16E, components identical/similar to the components described with reference to FIGS. 15A to 15M will be assigned with identical/similar reference numerals, and repetitive descriptions will be omitted.

In FIGS. 16A to 16E, two light-emitting elements among the first to third light-emitting elements ED1, ED2, and ED3 described above with reference to FIG. 9A are illustrated. In FIGS. 16A to 16E, operations of manufacturing the second light-emitting element ED2 and the second lower encapsulation pattern LIL2 after forming the first light-emitting element ED1 and the first lower encapsulation pattern LIL1 are illustrated. The first light-emitting element ED1 and the first lower encapsulation pattern LIL1 shown in FIGS. 16A to 16E may be formed through the operations described above with reference to FIGS. 15A to 15M.

FIGS. 16A to 16E are illustrated in an embodiment, and the order in which the first to third light-emitting elements ED1, ED2, and ED3 are formed is not limited to a particular embodiment.

Referring to FIG. 16A, the display panel manufacturing method in an embodiment of the disclosure may include an operation of defining the second barrier wall opening OP2-P and the second groove GR2 in the barrier wall PW and an operation of defining the second sacrificial opening OP2-S in the second sacrificial pattern SP2.

Although detailed operations are omitted in FIGS. 16A to 16E, the description made with reference to FIGS. 15B to 15F may be similarly applied to the operation of defining the second barrier wall opening OP2-P and the second groove GR2 in the barrier wall PW. In an embodiment, in the process of defining the second barrier wall opening OP2-P and the second groove GR2 in the barrier wall PW, the second light-emitting opening OP2-E may be formed together in the pixel defining layer PDL. The description made with reference to FIGS. 15F and 15G may be identically applied to the operation of defining the second sacrificial opening OP2-S in the second sacrificial pattern SP2.

Referring to FIG. 16B, the display panel manufacturing method according to this embodiment may include an operation of forming the second light-emitting element ED2, an operation of forming a second preliminary lower encapsulation pattern LIL2-I, and an operation of forming a third photoresist pattern PR3. The operation of forming the second light-emitting element ED2 may include an operation of forming the second emission pattern EP2 and an operation of forming the second cathode CE2.

The description of the deposition processes of the first emission pattern EP1 and the first cathode CE1 described above with reference to FIG. 15H may be similarly applied to the operations of forming the second emission pattern EP2 and the second cathode CE2. The second anode AE2, the second emission pattern EP2, and the second cathode CE2 may constitute the second light-emitting element ED2.

In the operation of forming the second emission pattern EP2, the first-first layer dummy pattern D11g, the first-second layer dummy pattern D12g, and a first-third layer preliminary dummy pattern D13g-I that are spaced apart from the second emission pattern EP2 may be formed together. The first-first layer dummy pattern D11g and the first-third layer preliminary dummy pattern D13g-I may be disposed on the barrier wall PW, and the first-second layer dummy pattern D12g may be disposed in the second groove GR2. One portion of the first-third layer preliminary dummy pattern D13g-I may be disposed on the barrier wall PW outward of the first-first layer dummy pattern D11g. Another portion of the first-third layer preliminary dummy pattern D13g-I may be disposed on the first lower encapsulation pattern LIL1, and part thereof may be disposed in the first barrier wall opening OP1-P.

In the operation of forming the second cathode CE2, the second-first layer dummy pattern D21g, the second-second layer dummy pattern D22g, and a second-third layer preliminary dummy pattern D23g-I that are spaced apart from the second cathode CE2 may be formed together. The second-first layer dummy pattern D21g and the second-third layer preliminary dummy pattern D23g-I may be disposed on the barrier wall PW, and the second-second layer dummy pattern D22g may be disposed in the second groove GR2. One portion of the second-third layer preliminary dummy pattern D23g-I may be disposed on the barrier wall PW outward of the second-first layer dummy pattern D21g. Another portion of the second-third layer preliminary dummy pattern D23g-I may be disposed on the first lower encapsulation pattern LIL1, and part thereof may be disposed in the first barrier wall opening OP1-P.

The first-first layer dummy pattern D11g and the second-first layer dummy pattern D21g may form the first-second dummy patterns DMP1g. The first-second layer dummy pattern D12g and the second-second layer dummy pattern D22g may form the second-second dummy patterns DMP2g. The first-third layer preliminary dummy pattern D13g-I and the second-third layer preliminary dummy pattern D23g-I may form third-second preliminary dummy patterns DMP3g-I.

The description of the deposition process of the first preliminary lower encapsulation pattern LII,1-I described with reference to FIG. 15I may be similarly applied to the operation of forming the second preliminary lower encapsulation pattern LIL2-I.

The third photoresist pattern PR3 may be formed on the second preliminary lower encapsulation pattern LIL2-I. The third photoresist pattern PR3 may be formed in the form of a pattern overlapping the second anode AE2 and the second light-emitting opening OP2-E and may be formed so as not to overlap the first anode AE1 and the third anode AE3 (refer to FIG. 9A). In addition, the third photoresist pattern PR3 may be formed to overlap the first-second dummy patterns DMP1g, the second-second dummy patterns DMP2g, and a portion of the third-second preliminary dummy patterns DMP3g-I.

Referring to FIGS. 16B and 16C, the display panel manufacturing method according to this embodiment may include an operation of making the second preliminary lower encapsulation pattern LIL2-I subject to patterning to form the second lower encapsulation pattern LIL2. The description of the etching operation of the first preliminary lower encapsulation pattern LIL1-I described with reference to FIGS. 15J and 15K may be similarly applied to the operation of making the second preliminary lower encapsulation pattern LIL2-I subject to patterning. In the operation of making the second preliminary lower encapsulation pattern LIL2-I subject to patterning, the third photoresist pattern PR3 may be used as a mask. The formed second lower encapsulation pattern LIL2 may include a portion disposed in the second barrier wall opening OP2-P and a portion disposed in the second groove GR2. A portion of the third-second preliminary dummy patterns DMP3g-I may be exposed from the second lower encapsulation pattern LIL2.

The third-second preliminary dummy patterns DMP3g-I may be separated by the outer portion P4 of the first lower encapsulation pattern LII,1, and the outer portion P4 of the first lower encapsulation pattern LIL1 may include a portion exposed from the third-second preliminary dummy patterns DMP3g-I. Accordingly, the second preliminary lower encapsulation pattern LIL2-I may be formed in a state of being brought into contact with the outer portion P4 of the first lower encapsulation pattern LIL1. In this case, in the operation of making the second preliminary lower encapsulation pattern LIL2-I subject to patterning, the outer portion P4 of the first lower encapsulation pattern LIL1 may be partially etched under the influence of an etching gas. That is, the outer portion P4 of the first lower encapsulation pattern LII,1 may be damaged. In an embodiment, a portion of the first lower encapsulation pattern LIL1 that is adjacent to the third tip portion TP3 (refer to FIG. 15H) may be spaced apart from the barrier wall PW, and a moisture permeation path along which moisture is capable of infiltrating may be formed through the spaced portion, for example.

However, according to this embodiment, the first groove GR1 may be provided to surround the first barrier wall opening OP1-P, and the first lower encapsulation pattern LIL1 may not only be brought into contact with not only the third tip portion TP3 (refer to FIG. 15H) but also the first tip portion TP1 (refer to FIG. 15H) and the second tip portion TP2 (refer to FIG. 15H). Accordingly, a moisture permeation path of the first lower encapsulation pattern LIL1 may be lengthened. A portion of the first lower encapsulation pattern LIL1 that is adjacent to the first and second tip portions TP1 and TP2 (refer to FIG. 15H) may be less affected by damage caused by an etching gas when compared to a portion of the first lower encapsulation pattern LIL1 that is adjacent to the third tip portion TP3 (refer to FIG. 15H) disposed outward of the first and second tip portions TP1 and TP2. Accordingly, at the portion of the first lower encapsulation pattern LIL1 that is adjacent to the first and second tip portions TP1 and TP2 (refer to FIG. 15H), more stable contact may be maintained, and infiltration of moisture may also be stably blocked. Thus, infiltration of moisture into the light-emitting element ED1 may be prevented, and the light-emitting element ED1 with improved process reliability and reduced defects may be provided.

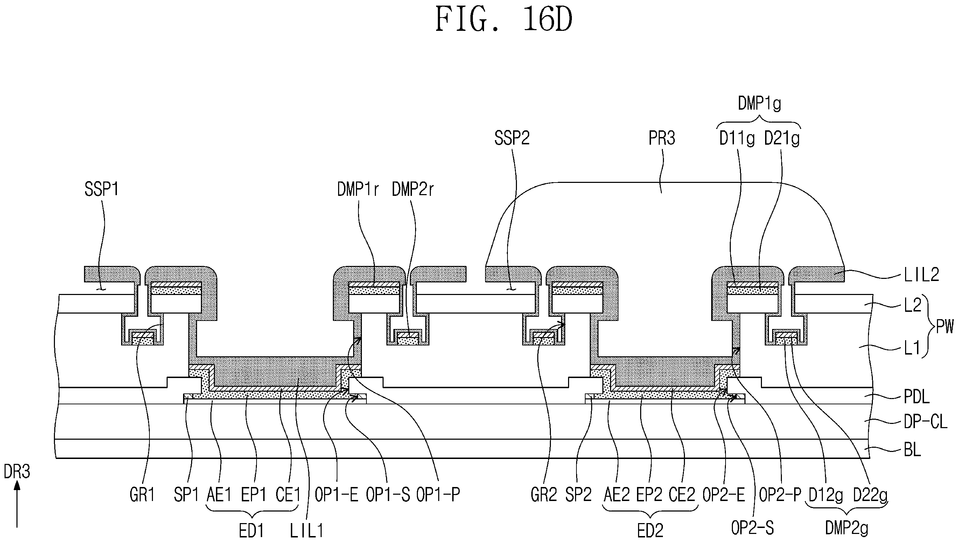

Referring to FIGS. 16C and 16D, the display panel manufacturing method according to this embodiment may include an operation of etching the third-second preliminary dummy patterns DMP3g-I and an operation of removing the third photoresist pattern PR3.

The description of the etching operation of the third-first preliminary dummy patterns DMP3r-I described with reference to FIGS. 15K and 15L may be similarly applied to the operation of etching the third-second preliminary dummy patterns DMP3g-I. In the operation of etching the third-second preliminary dummy patterns DMP3g-I, the third-second preliminary dummy patterns DMP3g-I may all be removed. Accordingly, the outer portion of the second lower encapsulation pattern LIL2 may be spaced apart from the barrier wall PW to form the second spacing region SSP2.

The second light-emitting element ED2 and the second lower encapsulation pattern LIL2 may be formed through the operations of FIGS. 16A to 16D. Thereafter, although not illustrated, the third light-emitting element ED3 (refer to FIG. 9A) and the third lower encapsulation pattern LIL3 (refer to FIG. 9A) may be formed in a manner similar to the operations described with reference to FIGS. 16A to 16D.

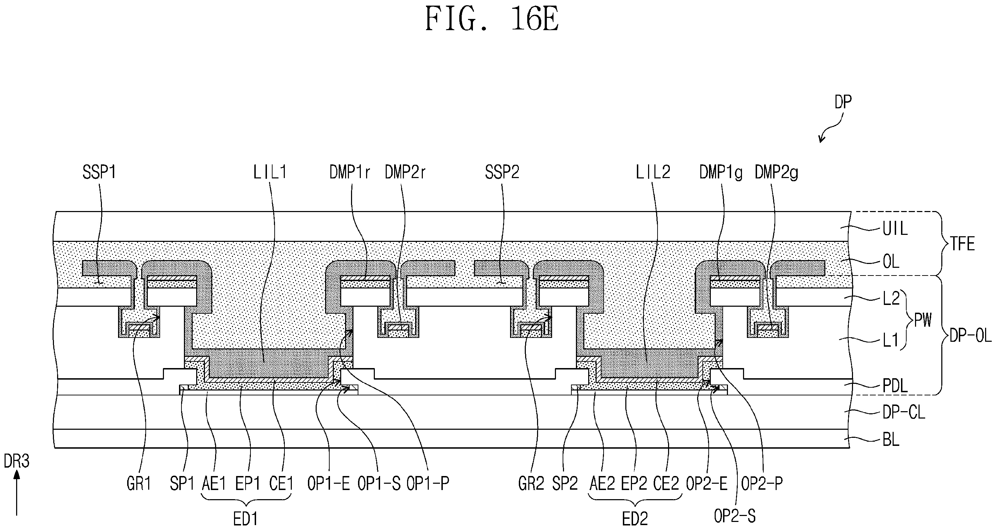

Referring to FIG. 16E, the display panel manufacturing method according to this embodiment may include an operation of forming the organic encapsulation film OL and the upper inorganic encapsulation film UIL to complete the display panel DP. The organic encapsulation film OL may be formed by applying an organic material using an inkjet method, but is not limited thereto. The organic encapsulation film OL provides a flat upper surface.

In an embodiment, the first spacing region SPP1 and the second spacing region SPP2 may be completely filled with the organic encapsulation film OL. However, the disclosure is not limited thereto, and depending on the heights of the first and second spacing regions SPP1 and SPP2 and the material of the organic encapsulation film OL, the organic encapsulation film OL may not fill the first and second spacing regions SPP1 and SPP2.

The upper inorganic encapsulation film UIL may be formed by depositing an inorganic material. Accordingly, the display panel DP including the base layer BL, the circuit element layer DP-CL, the display element layer DP-OL, and the thin film encapsulation layer TFE may be formed.

According to the disclosure, the emission patterns subjected to patterning without a metal mask may be provided. Accordingly, the display panel capable of improving process reliability and easily implementing relatively high resolution and the display device including the display panel may be provided.

According to the disclosure, the moisture permeation paths along which moisture is introduced into the light-emitting elements may be lengthened. Accordingly, moisture may be prevented from infiltrating into the light-emitting elements due to damage to the lower encapsulation pattern in a process. Thus, the display panel including the light-emitting elements with improved process reliability and reduced defects and the display device including the display panel may be provided.

According to the disclosure, the display device may further include the input sensor directly disposed on the display panel. The encapsulation layer may have the space therein. Accordingly, the permittivity of the encapsulation layer may be decreased, and the SNR may be reduced. Thus, the display device including the input sensor having improved sensitivity may be provided.

In addition, according to the disclosure, the manufacturing method for the display panel may be provided.

While the disclosure has been described with reference to embodiments thereof, it will be apparent to those of ordinary skill in the art that various changes and modifications may be made thereto without departing from the scope of the invention as set forth in the following claims.

## Claims

1. A display device comprising a display panel, the display panel including:
a base layer;
a pixel defining layer disposed on the base layer;
a barrier wall which is disposed on the pixel defining layer and in which a first barrier wall opening and a first groove spaced apart from the first barrier wall opening are defined;
a first light-emitting element including:
a first anode;
a first emission pattern; and
a first cathode which is disposed in the first barrier wall opening and contacts the barrier wall; and
a first lower encapsulation pattern disposed on the first light-emitting element and the barrier wall,
wherein the first groove surrounds the first barrier wall opening in a plan view, and
wherein an inner portion of the first lower encapsulation pattern is disposed in the first barrier wall opening and the first groove, and an outer portion of the first lower encapsulation pattern defines a first spacing region between the barrier wall and the outer portion of the first lower encapsulation pattern.

2. The display device of claim 1, wherein the first groove is defined by penetrating at least a portion of the barrier wall from an upper surface of the barrier wall in a thickness direction.

3. The display device of claim 1 or 2, wherein the barrier wall includes a first barrier wall layer disposed on the pixel defining layer and a second barrier wall layer disposed on the first barrier wall layer, and
wherein the first groove includes a first groove region defined by penetrating at least a portion of the first barrier wall layer and a second groove region which penetrates the second barrier wall layer, optionally wherein the first barrier wall opening includes a first opening region which penetrates the first barrier wall layer and a second opening region which penetrates the second barrier wall layer,
wherein the second opening region has a width smaller than a width of the first opening region, and
wherein a first tip portion adjacent to the first barrier wall opening is defined in the barrier wall.

4. The display device of claim 3, wherein the second groove region has a width smaller than a width of the first groove region, and
wherein a second tip portion and a third tip portion which are adjacent to the first groove and face each other are defined in the barrier wall, and the second tip portion is closer to the first barrier wall opening than the third tip portion is to the first barrier wall opening, optionally wherein the display panel further includes:
first dummy patterns disposed on the barrier wall and disposed between the first barrier wall opening and the first groove in the plan view; and
second dummy patterns disposed in the first groove, and
wherein each of the first dummy patterns and the second dummy patterns includes:
a first layer dummy pattern spaced apart from the first emission pattern, the first layer dummy pattern including a same material as a material of the first emission pattern; and
a second layer dummy pattern spaced apart from the first cathode, the second layer dummy pattern including a same material as a material of the first cathode, further optionally wherein the inner portion of the first lower encapsulation pattern includes:
a first portion disposed in the first barrier wall opening and covering the first cathode;
a second portion which extends from the first portion and is disposed on the barrier wall, the second portion covering the first dummy patterns; and
a third portion which extends from the second portion and is disposed in the first groove, the third portion covering the second dummy patterns.

5. The display device of claim 4, wherein an additional groove which surrounds the first barrier wall opening and the first groove in the plan view is defined in the barrier wall, and
wherein a fourth tip portion and a fifth tip portion which are adjacent to the additional groove and face each other are additionally defined in the barrier wall, optionally wherein the display panel further includes:
first additional dummy patterns disposed on the barrier wall and disposed between the first groove and the additional groove in the plan view; and
second additional dummy patterns disposed in the additional groove,
wherein each of the first additional dummy patterns and the second additional dummy patterns includes:
a first layer additional dummy pattern spaced apart from the first emission pattern, the first layer additional dummy pattern including a same material as a material of the first emission pattern; and
a second layer additional dummy pattern spaced apart from the first cathode, the second layer additional dummy pattern including a same material as a material of the first cathode, and
wherein one portion of the inner portion of the first lower encapsulation pattern covers the first additional dummy patterns, and another portion of the inner portion of the first lower encapsulation pattern is disposed in the additional groove and covers the second additional dummy patterns.

6. The display device of claim 3, 4 or 5, wherein the barrier wall further includes a third barrier wall layer disposed on the second barrier wall layer and a fourth barrier wall layer disposed on the third barrier wall layer,
wherein the first barrier wall opening further includes a third opening region which penetrates the third barrier wall layer and a fourth opening region which penetrates the fourth barrier wall layer, and
wherein the third opening region has a width greater than the width of the second opening region, and the fourth opening region has a width smaller than the width of the third opening region, optionally wherein the first groove further includes a third groove region which penetrates the third barrier wall layer and a fourth groove region which penetrates the fourth barrier wall layer, and
wherein the third groove region has a width greater than a width of the second groove region, and the fourth groove region has a width smaller than the width of the third groove region.

7. The display device of any one of claims 3 to 6, wherein a portion of the inner portion of the first lower encapsulation pattern fills the second groove region, and
wherein a space sealed by the first lower encapsulation pattern is defined in the first groove region.

8. The display device of any one of claims 1 to 7, wherein the first groove penetrates from an upper surface to a lower surface of the barrier wall.

9. The display device of any one of claims 1 to 8, wherein the display panel further includes an organic encapsulation film disposed on the barrier wall and the first lower encapsulation pattern, optionally wherein the first spacing region is filled with the organic encapsulation film.

10. The display device of any one of claims 1 to 9, further comprising an input sensor directly disposed on the display panel.

11. The display device of any one of claims 1 to 10, wherein the first groove has a closed-line shape in the plan view.

12. The display device of any one of claims 1 to 11, wherein the first groove has a width smaller than a width of the first barrier wall opening.

13. The display device of any one of claims 1 to 12, wherein the display panel further includes:
a second light-emitting element including a second anode, a second emission pattern, and a second cathode; and
a second lower encapsulation pattern spaced apart from the first lower encapsulation pattern and disposed on the second light-emitting element and the barrier wall,
wherein a second barrier wall opening spaced apart from the first barrier wall opening and a second groove which surrounds the second barrier wall opening in the plan view are additionally defined in the barrier wall,
wherein the second cathode is disposed in the second barrier wall opening and contacts the barrier wall, and
wherein an inner portion of the second lower encapsulation pattern is disposed in the second barrier wall opening and the second groove, and an outer portion of the second lower encapsulation pattern defines a second spacing region between the barrier wall and the outer portion of the second lower encapsulation pattern.

14. A method for manufacturing a display panel, the method comprising:
forming a barrier wall by etching a preliminary barrier wall, the barrier wall defining a barrier wall opening and a groove spaced apart from the barrier wall opening;
forming a light-emitting element in the barrier wall opening;
forming a lower encapsulation pattern including an inner portion disposed in the barrier wall opening and the groove and an outer portion disposed at an outsideof the inner portion; and
forming a spacing region between the outer portion of the lower encapsulation pattern and the barrier wall.

15. The method of claim 14, wherein the forming the barrier wall includes:
a first etching operation performed by a dry etch process; and
a second etching operation performed by a wet etch process,
wherein the barrier wall includes a first barrier wall layer and a second barrier wall layer disposed on the first barrier wall layer, and the barrier wall opening includes a first opening region formed through the first barrier wall layer and a second opening region formed through the second barrier wall layer, and
wherein the second opening region has a width smaller than a width of the first opening region, optionally further comprising:
forming a first photoresist pattern on the preliminary barrier wall before the forming of the barrier wall, the first photoresist pattern defining first photo opening and a second photo opening; and
removing the first photoresist pattern after the forming the barrier wall and before the forming the light-emitting element,
wherein in the forming the barrier wall, the barrier wall opening corresponds to the first photo opening, and the groove corresponds to the second photo opening,
wherein the second photo opening has a width smaller than a width of the first photo opening, and
wherein the groove has a height smaller than or equal to a height of the barrier wall opening, and optionally further comprising:
forming a preliminary mask pattern on the preliminary barrier wall before the forming the first photoresist pattern;
making the preliminary mask pattern subject to patterning after the forming the first photoresist pattern and before the forming the barrier wall to form a mask pattern in which a first pattern opening which overlaps the first photo opening and a second pattern opening which overlaps the second photo opening are defined; and
removing the mask pattern after the removing the first photoresist pattern and before the forming the light-emitting element, optionally further comprising:
providing a preliminary display panel before the forming the preliminary mask pattern, wherein the preliminary display panel includes a base layer, an anode disposed on the base layer, a sacrificial pattern disposed on the anode, a preliminary pixel defining layer disposed on the sacrificial pattern, and the preliminary barrier wall disposed on the preliminary pixel defining layer,
wherein in the forming the barrier wall, a pixel defining layer is formed from the preliminary pixel defining layer,
wherein a light-emitting opening corresponding to the first pattern opening is defined in the pixel defining layer, and
wherein in the removing the mask pattern, a sacrificial opening corresponding to the light-emitting opening is defined in the sacrificial pattern.

16. The method of claim 14 or 15, further comprising:
depositing a preliminary lower encapsulation pattern after the forming the light-emitting element and before the forming the lower encapsulation pattern; and
forming a second photoresist pattern on the preliminary lower encapsulation pattern,
wherein in the forming the light-emitting element, a first dummy pattern disposed on the barrier wall between the barrier wall opening and the groove, a second dummy pattern disposed in the groove, and a third preliminary dummy pattern disposed on the barrier wall outward of the groove are formed together,
wherein the second photoresist pattern overlaps a portion of the third preliminary dummy pattern, the first dummy pattern, the second dummy pattern, and the light-emitting element, and
wherein in the forming the spacing region, a wet etch process is performed using the second photoresist pattern as a mask, and the third preliminary dummy pattern is removed.

17. The method of claim 14, 15 or 16, wherein the groove is defined by removing a portion of the barrier wall from an upper surface of the barrier wall in a thickness direction.

18. The method of any one of claims 14 to 17, wherein the groove penetrates from an upper surface to a lower surface of the barrier wall.
